# EUROPEAN PATENT APPLICATION

(11) **EP 4 832 352 A1**
(43) Date of publication of application: **28.10.2026**
(21) Application number: 25745467.8
(22) Date of filing: 17.01.2025
(51) Int. Cl.: H03M 13/11, H03M 13/27, H03M 13/00, H04L 1/00

(54) **METHOD AND APPARATUS FOR ENCODING AND DECODING DATA IN COMMUNICATION OR BROADCASTING SYSTEM**

(30) Priority: 22.01.2024 KR 20240009767; 07.03.2024 KR 20240032729
(71) Applicant: Samsung Electronics Co., Ltd., Suwon-si, Gyeonggi-do 16677 (KR)
(72) Inventor: MYUNG, Seho, Suwon-si, Gyeonggi-do 16677 (KR); LEE, Donghun, Suwon-si, Gyeonggi-do 16677 (KR); JANG, Min, Suwon-si, Gyeonggi-do 16677 (KR); HAN, Donghwa, Suwon-si, Gyeonggi-do 16677 (KR)
(74) Representative: Gulde & Partner
(86) International application number: PCT/KR2025/000986
(87) International publication number: WO 2025/159450

(57) **Abstract**

The present disclosure relates to a 5G or 6G communication system for supporting a higher data transmission rate than 4G communication systems such as LTE.

## Description

### [Technical Field]

The disclosure relates to a method and an apparatus for encoding and decoding data in a communication or broadcasting system.

### [Background Art]

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100µsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collison avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable superhigh-performance communication and computing resources (such as mobile edge computing (MEC), clouds, and the like) over the network. In addition, through designing new protocols to be used in 6G communication systems, developing mecahnisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

### [Disclosure]

### [Technical Problem]

The disclosure provides algebraic characteristics to be satisfied by a parity-check matrix of a low-density parity-check (LDPC) code in order to reduce decoding latency and encoding complexity. The disclosure also provides an efficient encoding and decoding method and apparatus using an LDPC code having the algebraic characteristics.

The disclosure provides algebraic characteristics to be satisfied by a parity-check matrix of an LDPC code in order to reduce a block error rate (BLER) or block error probability. The disclosure also provides an efficient encoding and decoding method and apparatus using an LDPC code having the algebraic characteristics.

The disclosure provides algebraic characteristics to be satisfied by a parity-check matrix of an LDPC code, the algebraic characteristics being obtained by appropriately combining the above algebraic characteristics in order to simultaneously reduce decoding latency, encoding complexity, and BLER. The disclosure also provides an efficient encoding and decoding method and apparatus using an LDPC code having the combined algebraic characteristics.

### [Technical Solution]

According to an embodiment of the disclosure, a data transmission method performed by a base station or a terminal in a communication system may include performing LDPC encoding on data, based on a base matrix and/or a parity-check matrix, applying rate matching to the encoded data, modulating the rate-matched encoded data, and transmitting the modulated signal through a transmitter, wherein the base matrix, the parity-check matrix, or a weight matrix corresponding thereto satisfies a specific algebraic condition.

According to an embodiment of the disclosure, a data reception method performed by a base station or a terminal in a communication system may include receiving a modulated signal through a receiver, performing demodulation based on the received signal to determine values for decoding, performing LDPC decoding based on the determined values, a base matrix, and/or a parity-check matrix, applying appropriate rate dematching to the result of the LDPC decoding, and determining data from the result of the rate dematching, wherein the base matrix, the parity-check matrix, or a weight matrix corresponding thereto satisfies a specific algebraic condition.

Further, a method performed by a transmitting apparatus in a communication system according to an embodiment of the disclosure may include determining a number of input bits, determining a base matrix based on the number of the input bits, determining a lifting size (Z) based on at least one of the number of the input bits or the base matrix, determining a parity-check matrix, based on at least one of the base matrix or the lifting size (Z), performing encoding based on the parity-check matrix and the input bits, and performing rate matching, based on the encoded bits, wherein the parity-check matrix includes $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits, wherein puncturing starts from parity bits corresponding to a 4th column block among 0th, 1st, 2nd, 3rd, and 4th column blocks of the sub-matrix, and wherein, in the parity-check matrix, *I* is an identity matrix having a size of *Z*× *Z, O* is a zero matrix having a size of *Z* × *Z*, and *P^{a}, P^{b},* and *P^{c}* are each an identity matrix or a circulant permutation matrix having a size of *Z* × *Z.*

Furthermore, a method performed by a receiving apparatus in a communication system according to an embodiment of the disclosure may include receiving a signal corresponding to input bits, demodulating the signal to determine values for decoding, identifying a number of the input bits based on the signal, determining a base matrix based on the number of the input bits, determining a lifting size (Z) based on at least one of the number of the input bits or the base matrix, determining a parity-check matrix, based on at least one of the base matrix or the lifting size (Z), and performing decoding, based on the parity-check matrix and the values, wherein the parity-check matrix includes $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits, wherein the signal includes parity bits punctured starting from parity bits corresponding to a 4th column block among 0th, 1st, 2nd, 3rd, and 4th column blocks of the sub-matrix, and wherein, in the parity-check matrix, *I* is an identity matrix having a size of *Z* × *Z, O* is a zero matrix having a size of *Z* × *Z,* and *P^{a} , P^{b},* and *P^{c}* are each an identity matrix or a circulant permutation matrix having a size of *Z* × *Z.*

In addition, a transmitting apparatus in a communication system according to an embodiment of the disclosure may include a transceiver, and a controller coupled with the transceiver and configured to determine a number of input bits, determine a base matrix based on the number of the input bits, determine a lifting size (Z) based on at least one of the number of the input bits or the base matrix, determine a parity-check matrix based on at least one of the base matrix or the lifting size (Z), perform encoding based on the parity-check matrix and the input bits, and perform rate matching based on the encoded bits, wherein the parity-check matrix includes $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits, wherein puncturing starts from parity bits corresponding to a 4th column block among 0th, 1st, 2nd, 3rd, and 4th column blocks of the sub-matrix, and wherein, in the parity-check matrix, *I* is an identity matrix having a size of *Z* × *Z, O* is a zero matrix having a size of *Z* × Z, and *P^{a} , P^{b},* and *P^{c}* are each an identity matrix or a circulant permutation matrix having a size of *Z* × *Z.*

In addition, a receiving apparatus in a communication system according to an embodiment of the disclosure may include a transceiver, and a controller coupled with the transceiver and configured to receive a signal corresponding to input bits, demodulate the signal to determine values for decoding, identify a number of the input bits, based on the signal, determine a base matrix based on the number of the input bits, determine a lifting size (Z) based on at least one of the number of the input bits or the base matrix, determine a parity-check matrix, based on at least one of the base matrix or the lifting size (Z), and perform decoding, based on the parity-check matrix and the values, wherein the parity-check matrix includes $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits, wherein the signal includes parity bits punctured starting from parity bits corresponding to a 4th column block among 0th, 1st, 2nd, 3rd, and 4th column blocks of the sub-matrix, and wherein, in the parity-check matrix, *I* is an identity matrix having a size of *Z* × *Z, O* is a zero matrix having a size of *Z* × *Z,* and *P^{a} , P^{b},* and *P^{c}* are each an identity matrix or a circulant permutation matrix having a size of *Z* × *Z.*

### [Advantageous Effects]

According to the disclosure, by providing algebraic characteristics of a parity-check matrix for reducing latency and BLER, LDPC codes can be effectively supported for variable lengths and variable rates.

### [Description of Drawings]

FIG. 1 illustrates a systematic LDPC codeword structure.
FIG. 2 illustrates a graph representation method for an LDPC code.
FIG. 3A illustrates an example for describing a cycle characteristic of a QC-LDPC code.
FIG. 3B illustrates an example for describing a cycle characteristic of a QC-LDPC code.
FIG. 4 illustrates a transmission block structure according to an embodiment of the disclosure.
FIG. 5 illustrates an example of an LDPC encoding process according to an embodiment of the disclosure.
FIG. 6 illustrates an example of an LDPC decoding process according to an embodiment of the disclosure.
FIG. 7 is a block configuration diagram illustrating a transmitting device according to an embodiment of the disclosure.
FIG. 8 is a block configuration diagram illustrating a receiving device according to an embodiment of the disclosure.
FIG. 9 illustrates a structure of an LDPC decoder according to an embodiment of the disclosure.
FIG. 10 illustrates an example of a structure of a parity-check matrix of an LDPC code.
FIG. 11A illustrates an example of a parity-check matrix for an LDPC code satisfying the characteristics proposed in the disclosure.
FIG. 11B illustrates an example of a parity-check matrix for an LDPC code satisfying the characteristics proposed in the disclosure.
FIG. 12A illustrates an example for describing a cycle characteristic in a sub-matrix of a parity-check matrix for an LDPC code satisfying the characteristics proposed in the disclosure.
FIG. 12B illustrates an example for describing a cycle characteristic in a sub-matrix of a parity-check matrix for an LDPC code satisfying the characteristics proposed in the disclosure.
FIG. 12C illustrates an example for describing a cycle characteristic in a sub-matrix of a parity-check matrix for an LDPC code satisfying the characteristics proposed in the disclosure.
FIG. 13 illustrates an example of a parity-check matrix of an LDPC code according to an embodiment of the disclosure.
FIG. 14A illustrates an example of applying a permutation rule to a parity-check matrix according to an embodiment of the disclosure.
FIG. 14B illustrates an example of applying a permutation rule to a parity-check matrix according to an embodiment of the disclosure.

### [Mode for Invention]

Hereinafter, exemplary embodiments of the disclosure will be described in detail with reference to the accompanying drawings. Also, in describing the disclosure, a detailed description of relevant known functions or configurations will be omitted when it is determined that the description may make the subject matter of the disclosure unnecessarily unclear. In addition, the terms which will be described below are terms defined in consideration of the functions in the disclosure, and may be different according to users, intentions of the users, or customs. Accordingly, the definitions thereof should be made based on the contents throughout the specification.

Based on determinations by those skilled in the art, the main idea of the disclosure may also be applied to other communication systems having similar technical backgrounds through some modifications without significantly departing from the scope of the disclosure. For reference, the term "communication system" generally covers the meaning of a broadcast system, but in the disclosure, a communication system that provides a broadcast service as the main service may be more clearly referred to as a broadcast system.

The advantages and features of the disclosure and ways to achieve them will be apparent by making reference to embodiments as described below in detail in conjunction with the accompanying drawings. However, the disclosure is not limited to the embodiments set forth below, but may be implemented in various different forms. The following embodiments are provided only to completely disclose the disclosure and inform those skilled in the art of the scope of the disclosure, and the disclosure is defined only by the scope of the appended claims. Throughout the specification, the same or like reference numerals designate the same or like elements.

A low-density parity-check (hereinafter, LDPC) code, first introduced by Gallager in the 1960s, was long forgotten due to the implementation complexity given the state of technology at that time. However, after the turbo code proposed by Berrou, Glavieux, and Thitimajshima in 1993 was shown to achieve performance approaching the Shannon channel capacity, extensive analyses of the performance and characteristics of the turbo code led to significant research on channel coding based on iterative decoding and graphs. As LDPC codes were reinvestigated in the late 1990s, it was found that, by performing decoding using iterative decoding based on the sum-product algorithm on a Tanner graph corresponding to an LDPC code, the LDPC code also achieves performance approaching the Shannon channel capacity.

An LDPC code is generally defined by a parity-check matrix and may be represented using a bipartite graph generally referred to as a Tanner graph. In general, an LDPC code is a type of parity-check code and is referred to as a "low-density" parity-check code because the ratio (i.e., density) of the number of 1s in a parity-check matrix is very low when the code length is sufficiently long. Accordingly, for convenience of description, the techniques proposed based on LDPC codes in the disclosure may be readily extended to general parity-check matrix codes.

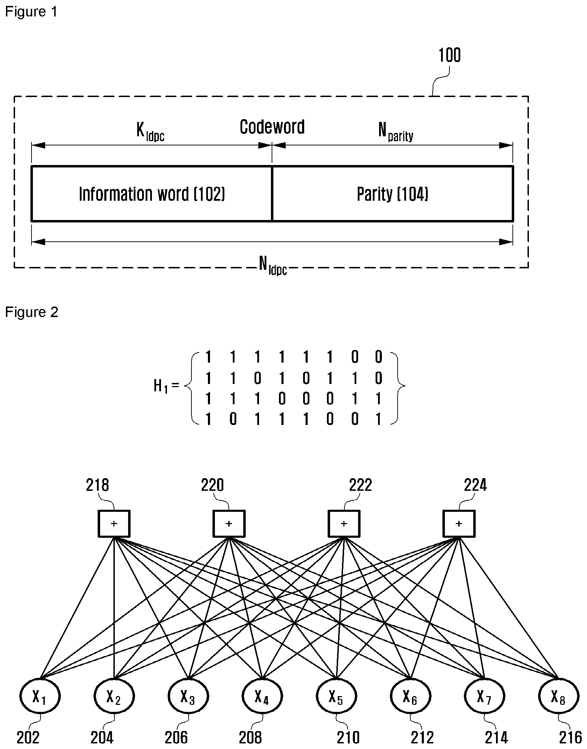

FIG. 1 illustrates a systematic LDPC codeword structure.

According to FIG. 1, an apparatus performing LDPC encoding receives an information word 102 including K_{ldpc} bits or symbols, performs encoding on the information word 102, and generates a codeword 100 including N_{ldpc} bits or symbols. For convenience of description, it is assumed that an information word 102 including K_{ldpc} bits is received as an input and a codeword 100 including N_{ldpc} bits is generated. That is, by encoding the information word ***i*** = (*i*₀*, i*₁*, i*₂*,* ... , *i*_{*Kldpc-*1}) 102 including the K_{ldpc} input bits, the codeword ***c*** = (*c*₀*, c*₁*, c*₂*, ... , c*_{*Nldpc*-1}) 100 is generated. That is, the information word and the codeword are bit strings each including a plurality of bits, and an information word bit and a codeword bit respectively refer to each bit constituting the information word and the codeword. The LDPC-coded bits are generally referred to as a systematic code when they include the information word as shown in ***c*** = (*c*₀*, c*₁*, c*₂*, ... , c*_{*Nldpc*-1}) = (***i***, ***w***) = (*i*₀*, i*₁, *i₂,* ... , *i*_{*Kldpc*-1}, *w₀, w*₁*, w*₂, *..., w*_{*Nldpc-Kldpc-*1}). Here, ***w*** = [*w*₀ *w*₁ *w*₂ ... *w*_{*Nldpc-Kldpc-*1}] denotes parity bits 104, and the number of parity bits, N_{parity}, may be expressed as N_{parity} = N_{ldpc} - K_{ldpc}.

An LDPC code is a type of linear block code and includes determining a codeword satisfying the condition represented by Equation 1 below. [Equation 1] $H ⋅ {{c}_{_}}^{T} = \left[{h}_{0} {h}_{1} {h}_{2} … {h}_{{N}_{ldpc} - 1}\right] ⋅ {{c}_{_}}^{T} = {\sum }_{i = 0}^{{N}_{ldpc} - 1} {c}_{i} ⋅ {h}_{i} = {0}_{_}$

Here, ***c*** = [*c*₀ *c*₁ *c*₂ ... *c*_{*Nldpc -*1}]*.*

In Equation 1, H denotes a parity-check matrix, c denotes a codeword, cᵢ denotes an i-th bit of the codeword, N_{ldpc} denotes the LDPC codeword length, and **h***ᵢ* denotes an i-th column of the parity-check matrix H.

The parity-check matrix H is composed of N_{ldpc} columns, where N_{ldpc} is equal to the number of bits in the LDPC codeword. Equation 1 indicates that the sum of the products of the i-th column (**h***ᵢ*) of the parity-check matrix and the i-th codeword bit cᵢ is equal to 0, and thus indicates that the i-th column (**h***ᵢ*) is associated with the i-th codeword bit cᵢ.

FIG. 2 illustrates a graph representation method for an LDPC code.

A graph representation method for an LDPC code will now be described with reference to FIG. 2.

FIG. 2 illustrates an example of a parity-check matrix H₁ of an LDPC code including four rows and eight columns, and a Tanner graph corresponding thereto. Referring to FIG. 2, since the parity-check matrix H₁ has eight columns, a codeword having a length of eight is generated. The code generated using H₁ is an LDPC code, and the columns correspond to the eight encoded bits.

Referring to FIG. 2, a Tanner graph of an LDPC code encoded and decoded based on the parity-check matrix H₁ includes eight variable nodes, i.e., x₁ 202, x₂ 204, x₃ 206, x₄ 208, x₅ 210, x₆ 212, x₇ 214, and x₈ 216, and four check nodes 218, 220, 222, and 224. Here, the i-th column and the j-th row of the parity-check matrix H₁ of the LDPC code correspond to the variable node xᵢ and the j-th check node, respectively. Further, a value of 1, i.e., a non-zero value, at an intersection of the i-th column and the j-th row of the parity-check matrix H₁ of the LDPC code indicates that an edge connecting the variable node xᵢ and the j-th check node exists in the Tanner graph, as shown in FIG. 2.

In the Tanner graph of an LDPC code, the degree of a variable node or a check node indicates the number of edges connected to the corresponding node, which is equal to the number of non-zero entries in the column or row corresponding to the node in the parity-check matrix of the LDPC code. For example, in FIG. 2, the degrees of the variable nodes x₁ 202, x₂ 204, x₃ 206, x₄ 208, x₅ 210, x₆ 212, x₇ 214, and x₈ 216 are 4, 3, 3, 3, 2, 2, 2, and 2, respectively, and the degrees of the check nodes (218, 220, 222, and 224) are 6, 5, 5, and 5, respectively. Further, the numbers of non-zero entries in the respective columns of the parity-check matrix H₁ of FIG. 2 corresponding to the variable nodes of FIG. 2 are 4, 3, 3, 3, 2, 2, 2, and 2, respectively, which correspond to the above-described degrees of the variable nodes, and the numbers of non-zero entries in the respective rows of the parity-check matrix H₁ of FIG. 2 corresponding to the check nodes of FIG. 2 are 6, 5, 5, and 5, respectively, which correspond to the above-described degrees of the check nodes. Accordingly, the degree of each variable node is also referred to as a column degree or column weight, and the degree of each check node is also referred to as a row degree or row weight.

The LDPC-encoded codeword bits may be decoded based on an iterative decoding algorithm based on a sum-product algorithm on the bipartite graph shown in FIG. 2. Here, the sum-product algorithm is a type of message-passing algorithm, and the message-passing algorithm refers to an algorithm in which messages are exchanged through edges on a bipartite graph and output messages are calculated and updated from messages input to a variable node or a check node.

Here, the value of the i-th encoded bit may be determined based on the message of the i-th variable node. The value of the i-th encoded bit may be determined using either hard decision or soft decision. Accordingly, the performance of the i-th bit cᵢ of the LDPC codeword corresponds to the performance of the i-th variable node in the Tanner graph, and may be determined according to the positions and the number of 1s in the i-th column of the parity-check matrix. In other words, the performance of the N_{ldpc} codeword bits of the codeword may depend on the positions and the number of 1s in the parity-check matrix, which means that the performance of the LDPC code is significantly affected by the parity-check matrix. Accordingly, in order to design an LDPC code having excellent performance, a method for designing an appropriate parity-check matrix is required.

In communication and broadcasting systems, a quasi-cyclic LDPC code (or a QC-LDPC code, hereinafter referred to as a QC-LDPC code) using a quasi-cyclic parity-check matrix is generally used for ease of implementation. Depending on the communication or broadcasting system, a parity-check matrix having a structure that is not a completely quasi-cyclic structure but is substantially similar to a quasi-cyclic structure may also be used. Although such an LDPC code may not be classified as a QC-LDPC code in a strict algebraic sense, it may, for convenience, also be classified as a QC-LDPC code.

A conventional QC-LDPC code is characterized by having a parity-check matrix composed of zero matrices or circulant permutation matrices (or circular permutation matrices), each having a small square-matrix form. Here, a permutation matrix refers to a matrix in which each row or each column includes only one 1 and all remaining entries are 0. Further, a circulant permutation matrix refers to a matrix obtained by circularly shifting the entries of an identity matrix to the right or to the left. In general, an identity matrix itself is also included in circulant permutation matrices because it is regarded as being obtained by circularly shifting the entries of the identity matrix by zero shifts. Accordingly, although a circulant permutation matrix basically includes an identity matrix, an identity matrix and a circulant permutation matrix other than the identity matrix may be distinguished from each other for convenience of description.

Hereinafter, QC-LDPC codes will be described in detail.

First, a circulant permutation matrix *P* = (*P_{i,j}*) having a size of *Z* × *Z* is defined as shown in Equation 2 below. Here, *P_{i,j}* denotes an entry located at the i-th row and the j-th column of the matrix P (0 ≤ *i, j* < *Z*). [Equation 2-1] ${P}_{i , j} = \left\{\begin{matrix}1 & if i + 1 ≡ j \left(mod Z\right) \\ 0 & otherwise .\end{matrix}\right.$

For the permutation matrix P defined above, *Pⁱ* (0 ≤ i < Z) denotes a circulant permutation matrix obtained by circularly shifting the entries of an identity matrix having a size of *Z* × *Z* to the right by i shifts. A circulant permutation matrix may also be defined as shown in Equation 2-2 below. In this case, *Pⁱ* denotes a circulant permutation matrix obtained by circularly shifting the entries of an identity matrix having a size of *Z* × *Z* to the left by i shifts. [Equation 2-2] ${P}_{i , j} = \left\{\begin{matrix}1 & if i ≡ j + 1 \left(mod Z\right) \\ 0 & otherwise .\end{matrix}\right.$

In the disclosure, for convenience, various embodiments will be described using circulant permutation matrices defined based on Equation 2-1. However, since the circulant permutation matrices defined in Equations 2-1 and 2-2 differ only in notation and have the same fundamental algebraic properties, circulant permutation matrices defined based on Equation 2-2 may also be used in the embodiments of the disclosure. Alternatively, various types of circulant permutation matrices having the same algebraic properties may be used.

The parity-check matrix H of the simplest QC-LDPC code may be represented in the form of Equation 3 below. [Equation 3] $H = \left[\begin{matrix}{P}^{{V}_{1 , 1}} & {P}^{{V}_{1 , 2}} & ⋯ & {P}^{{V}_{1 , {n}_{b}}} \\ {P}^{{V}_{2 , 1}} & {P}^{{V}_{2 , 2}} & ⋯ & {P}^{{V}_{2 , {n}_{b}}} \\ ⋮ & ⋮ & ⋱ & ⋮ \\ {P}^{{V}_{{m}_{b} , 1}} & {P}^{{V}_{{m}_{b} , 2}} & ⋯ & {P}^{{V}_{{m}_{b} , {n}_{b}}}\end{matrix}\right]$

For convenience, when *P*⁻¹ is defined as a zero matrix having a size of *Z* × *Z*, the index *V_{i,j}* of each circulant permutation matrix or zero matrix in Equation 3 has one of the values {-1, 0, 1, 2, ..., Z-1}. An identity matrix may be represented by *P*⁰ or *I*, and a zero matrix may be represented by *P*⁻¹ or *O*. Further, since the parity-check matrix H of Equation 3 includes *n_{b}* column blocks and *m_{b}* row blocks, the size of the parity-check matrix H is *n_{b}Z* × *m_{b}Z.*

If the parity-check matrix of Equation 3 has full rank (or full coefficient), the length of the information word bit of the QC-LDPC code corresponding to the parity-check matrix is (*n_{b} - m_{b}*)*Z*. For convenience, the *k_{b}* = (*n_{b} - m_{b}*) column blocks corresponding to the information word bit may be referred to as information column blocks, the number of information word bits may be *k_{b}Z,* and the *m_{b}* column blocks corresponding to the remaining parity bits may be referred to as parity column blocks. In this case, the number of parity bits is *m_{b}Z.* For reference, when the parity-check matrix of Equation 3 does not have full rank, the length of the information word bit is greater than (*n_{b}* - *m_{b}*)*Z,* the number of information word bits has a value greater than *k_{b}Z*, and the number of parity bits has a value smaller than *m_{b}Z*.

Conventionally, a binary matrix having a size of *m_{b}* × *n_{b}*, obtained by replacing each circulant permutation matrix and each zero matrix in the parity-check matrix of Equation 3 with 1 and 0, respectively, is referred to as a mother matrix, a base matrix, or a base graph of the parity-check matrix H, and is denoted by M(H) or **H**_{BG}. Further, by selecting the exponent of each circulant permutation matrix or zero matrix, an integer matrix having a size of *m_{b}* × *n_{b}* obtained as shown in Equation 4 is referred to as an exponent matrix (*V*(**H**)) of the parity-check matrix H. [Equation 4] $V \left(H\right) = \left[\begin{matrix}{V}_{1 , 1} & {V}_{1 , 2} & … & {V}_{1 , {n}_{b}} \\ {V}_{2 , 1} & {V}_{2 , 2} & … & {V}_{2 , {n}_{b}} \\ ⋮ & ⋮ & ⋱ & ⋮ \\ {V}_{{m}_{b} , 1} & {V}_{{m}_{b} , 2} & ⋯ & {V}_{{m}_{b} , {n}_{b}}\end{matrix}\right]$

Of course, this name is merely an example, and the exponent matrix *V*(**H**) may be referred to by another name. For example, since the exponent of each circulant permutation matrix corresponds to a value by which an identity matrix is circularly shifted, as shown in Equation 2-1 or Equation 2-2, each exponent may be referred to as a shift value or a circular shift value, and *V*(**H**) may be referred to as a circular shift value matrix or a shift value matrix. In general, when an exponent matrix or a shift value matrix and the value of *Z* corresponding to the size of the circulant permutation matrix or zero matrix are given, the parity-check matrix may be determined or identified. For this reason, although the parity-check matrix mathematically refers to the binary matrix H satisfying the condition of Equation 1, an exponent matrix or a shift value matrix may, in some cases, be referred to as a parity-check matrix for convenience.

Since each integer included in the exponent matrix or shift value matrix corresponds to a circulant permutation matrix in the parity-check matrix, the exponent matrix may, for convenience, be represented as a sequence of integers. In general, the parity-check matrix may be represented not only by an exponent matrix but also by various sequences capable of representing the same algebraic characteristics. In the disclosure, for convenience, the parity-check matrix is represented by an exponent matrix, a sequence indicating the positions of 1s in the parity-check matrix, or the like. However, since there are various sequence notations capable of distinguishing the positions of 1s or 0s included in the parity-check matrix, the disclosure is not limited to the representations described herein, and may be represented in various forms of sequences or matrices having algebraically equivalent effects. The sequence may be referred to by various names, such as an LDPC sequence, an LDPC code sequence, a parity-check matrix sequence, or a (circular) shift value sequence, in order to distinguish them from other sequences.

In addition, a transmitting/receiving device may directly generate a parity-check matrix and perform LDPC encoding and decoding, LDPC encoding and decoding may alternatively be performed, depending on implementation characteristics, based on an exponent matrix, a shift value matrix, or a sequence having the same algebraic effect as the parity-check matrix. Accordingly, although encoding and decoding using a parity-check matrix are described in the disclosure for convenience, in an actual transmitting/receiving apparatus, encoding and decoding may be implemented using various methods capable of achieving the same effect as the parity-check matrix.

For reference, the term "the same algebraic effect" means that, with respect to two or more different representations, the representations may be explained to be logically or mathematically completely identical to each other, or may be transformed into each other. In particular, in the case of a code that may be defined by a matrix, such as an LDPC code, the term may mean that algebraic values that may be defined by the matrix, such as a minimum distance, a rank, and cycle characteristics on a Tanner graph, are identical, or may mean that the basic structure or operation in the encoding/decoding process is identical. For example, if the same matrix is obtained through an appropriate column permutation, row permutation, or the like, the two matrices may be regarded as algebraically identical from the viewpoint of coding. Further, various transposes that do not change the essential characteristics of the code may also provide the same algebraic effect.

As a specific example, when a matrix A is given as follows, examples of various transformations providing the same algebraic effect are illustrated as A1 to A8. $A = \left[\begin{matrix}{P}^{{a}_{1 , 1}} & {P}^{{a}_{1 , 2}} & {P}^{{a}_{1 , 3}} & {P}^{{a}_{1 , 4}} \\ {P}^{{a}_{2 , 1}} & {P}^{{a}_{2 , 2}} & {P}^{{a}_{2 , 3}} & {P}^{{a}_{2 , 4}} \\ {P}^{{a}_{3 , 1}} & {P}^{{a}_{3 , 2}} & {P}^{{a}_{3 , 3}} & {P}^{{a}_{3 , 4}} \\ {P}^{{a}_{4 , 1}} & {P}^{{a}_{4 , 2}} & {P}^{{a}_{4 , 3}} & {P}^{{a}_{4 , 4}}\end{matrix}\right]$ ${A}_{1} = \left[\begin{matrix}{P}^{{a}_{1 , 1}} & {P}^{{a}_{1 , 3}} & {P}^{{a}_{1 , 2}} & {P}^{{a}_{1 , 4}} \\ {P}^{{a}_{2 , 1}} & {P}^{{a}_{2 , 3}} & {P}^{{a}_{2 , 2}} & {P}^{{a}_{2 , 4}} \\ {P}^{{a}_{3 , 1}} & {P}^{{a}_{3 , 3}} & {P}^{{a}_{3 , 2}} & {P}^{{a}_{3 , 4}} \\ {P}^{{a}_{4 , 1}} & {P}^{{a}_{4 , 3}} & {P}^{{a}_{4 , 2}} & {P}^{{a}_{4 , 4}}\end{matrix}\right] , {A}_{2} = \left[\begin{matrix}{P}^{{a}_{3 , 1}} & {P}^{{a}_{3 , 3}} & {P}^{{a}_{3 , 2}} & {P}^{{a}_{3 , 4}} \\ {P}^{{a}_{2 , 1}} & {P}^{{a}_{2 , 3}} & {P}^{{a}_{2 , 2}} & {P}^{{a}_{2 , 4}} \\ {P}^{{a}_{1 , 1}} & {P}^{{a}_{1 , 3}} & {P}^{{a}_{1 , 2}} & {P}^{{a}_{1 , 4}} \\ {P}^{{a}_{4 , 1}} & {P}^{{a}_{4 , 3}} & {P}^{{a}_{4 , 2}} & {P}^{{a}_{4 , 4}}\end{matrix}\right] ,$ ${A}_{3} = \left[\begin{matrix}{P}^{{a}_{1 , 1} + x} & {P}^{{a}_{1 , 2}} & {P}^{{a}_{1 , 3} + y} & {P}^{{a}_{1 , 4}} \\ {P}^{{a}_{2 , 1} + x} & {P}^{{a}_{2 , 2}} & {P}^{{a}_{2 , 3} + y} & {P}^{{a}_{2 , 4}} \\ {P}^{{a}_{3 , 1} + x} & {P}^{{a}_{3 , 2}} & {P}^{{a}_{3 , 3} + y} & {P}^{{a}_{3 , 4}} \\ {P}^{{a}_{4 , 1} + x} & {P}^{{a}_{4 , 2}} & {P}^{{a}_{4 , 3} + y} & {P}^{{a}_{4 , 4}}\end{matrix}\right] ,$ ${A}_{4} = \left[\begin{matrix}{P}^{{a}_{1 , 1} + x} & {P}^{{a}_{1 , 2}} & {P}^{{a}_{1 , 3} + y} & {P}^{{a}_{1 , 4}} \\ {P}^{{a}_{2 , 1} + x + z} & {P}^{{a}_{2 , 2} + z} & {P}^{{a}_{2 , 3} + y + z} & {P}^{{a}_{2 , 4} + z} \\ {P}^{{a}_{3 , 1} + x} & {P}^{{a}_{3 , 2}} & {P}^{{a}_{3 , 3} + y} & {P}^{{a}_{3 , 4}} \\ {P}^{{a}_{4 , 1} + x + w} & {P}^{{a}_{4 , 2} + w} & {P}^{{a}_{4 , 3} + y + w} & {P}^{{a}_{4 , 4} + w}\end{matrix}\right] ,$ ${A}_{5} = \left[\begin{matrix}{P}^{- {a}_{1 , 1}} & {P}^{- {a}_{2 , 1}} & {P}^{- {a}_{3 , 1}} & {P}^{- {a}_{4 , 1}} \\ {P}^{- {a}_{1 , 2}} & {P}^{- {a}_{2 , 2}} & {P}^{- {a}_{3 , 2}} & {P}^{- {a}_{4 , 2}} \\ {P}^{- {a}_{1 , 3}} & {P}^{- {a}_{2 , 3}} & {P}^{- {a}_{3 , 3}} & {P}^{- {a}_{4 , 3}} \\ {P}^{- {a}_{1 , 4}} & {P}^{- {a}_{2 , 4}} & {P}^{- {a}_{3 , 4}} & {P}^{- {a}_{4 , 4}}\end{matrix}\right] ,$ ${A}_{6} = \left[\begin{matrix}{P}^{{a}_{1 , 1}} & {P}^{{a}_{2 , 1}} & {P}^{{a}_{3 , 1}} & {P}^{{a}_{4 , 1}} \\ {P}^{{a}_{1 , 2}} & {P}^{{a}_{2 , 2}} & {P}^{{a}_{3 , 2}} & {P}^{{a}_{4 , 2}} \\ {P}^{{a}_{1 , 3}} & {P}^{{a}_{2 , 3}} & {P}^{{a}_{3 , 3}} & {P}^{{a}_{4 , 3}} \\ {P}^{{a}_{1 , 4}} & {P}^{{a}_{2 , 4}} & {P}^{{a}_{3 , 4}} & {P}^{{a}_{4 , 4}}\end{matrix}\right] ,$ ${A}_{7} = \left[\begin{matrix}{P}^{- {a}_{1 , 1}} & {P}^{- {a}_{1 , 2}} & {P}^{- {a}_{1 , 3}} & {P}^{- {a}_{1 , 4}} \\ {P}^{- {a}_{2 , 1}} & {P}^{- {a}_{2 , 2}} & {P}^{- {a}_{2 , 3}} & {P}^{- {a}_{2 , 4}} \\ {P}^{- {a}_{3 , 1}} & {P}^{- {a}_{3 , 2}} & {P}^{- {a}_{3 , 3}} & {P}^{- {a}_{3 , 4}} \\ {P}^{- {a}_{4 , 1}} & {P}^{- {a}_{4 , 2}} & {P}^{- {a}_{4 , 3}} & {P}^{- {a}_{4 , 4}}\end{matrix}\right] ,$ ${A}_{8} = \left[\begin{matrix}{P}^{{ka}_{1 , 1}} & {P}^{{ka}_{1 , 2}} & {P}^{{ka}_{1 , 3}} & {P}^{{ka}_{1 , 4}} \\ {P}^{{ka}_{2 , 1}} & {P}^{{ka}_{2 , 2}} & {P}^{{ka}_{2 , 3}} & {P}^{{ka}_{2 , 4}} \\ {P}^{{ka}_{3 , 1}} & {P}^{{ka}_{3 , 2}} & {P}^{{ka}_{3 , 3}} & {P}^{{ka}_{3 , 4}} \\ {P}^{{ka}_{4 , 1}} & {P}^{{ka}_{4 , 2}} & {P}^{{ka}_{4 , 3}} & {P}^{{ka}_{4 , 4}}\end{matrix}\right] ,$ (where k is an integer that is relatively prime to Z)

*A*₁ is an example of a block-wise permutation in which the second column block and the third column block of *A* are exchanged. *A*₂ is an example of a block-wise permutation in which the first row block and the third row block of *A*₁ are additionally exchanged. *A*₃ is an example in which circulant permutations are respectively applied only to the first column block and the third column block of *A. A*₄ is an example in which circulant permutations are additionally respectively applied only to the second row block and the fourth row block of *A*₃*. A*₅ is an example in which a transpose is applied to *A. A*₆ is an example in which a block-wise transpose is applied to *A. A*₇ is an example in which the signs of the respective exponents (or circular shift values) of *A* are reversed (however, for convenience, when a zero matrix having a size of *Z* × *Z* is represented by *P*⁻¹, the use of negative exponents (or shift values) may cause confusion, and thus (-a*ᵢ*,*ⱼ*) may be represented by a positive value, such as (*Z-a_{i,j}*))*. A*₈ is an example in which an affine transformation having a constant term of 0 is applied to *A* (in general, an affine transformation having a constant term other than 0 may also be applied). For reference, the above examples have been described, for convenience, for a case in which there is no entry for which *P^{ai,j}* is a zero matrix having a size of *Z* × *Z*. However, when a zero matrix is included, a portion corresponding to the zero matrix is always a zero matrix regardless of the transformation. For example, if *P^{a2,3}* in *A* is a zero matrix, then *P*^{*a*2,3} is also a zero matrix in *A*₁*, A*₂*,* and *A*₆, *P*^{*a*2,3+*y*} and *P^{a2,3+y+z}* are respectively zero matrices in *A*₃ and *A*₄*, P*^{*-a*2,3} is a zero matrix in *A*₅ and *A*₇, and *P*^{*ka*2,3} is a zero matrix in *A*₈.

Each of the above transformations is merely an example, and various other transformations may exist. In addition, each transformation may be applied independently, or may be applied in an appropriately overlapping and combined manner. Here, each transformation or a combination of transformations is characterized in that it is transformable into the original matrix through an appropriate invertible transform.

The various transformations or combinations of transformations described above are, in substance, reversible transformations in which only the arrangement of bits (or variable nodes) or check nodes on a Tanner graph is changed, or in which a symmetric transformation or a particular structure is maintained. Therefore, although instantaneous performance may vary depending on a given channel condition from the viewpoint of code performance, the transformations may provide the same performance on average. Accordingly, in the disclosure, all parity-check matrices obtained through transformations capable of providing the same algebraic effect are regarded as the same parity-check matrix.

For convenience, the foregoing description has been given only for a case in which one circulant permutation matrix corresponds to one square block of size *Z* × *Z*. However, the foregoing description may also be applied to a case in which a plurality of circulant permutation matrices are included in one block. For example, as shown in Equation 5 below, when two circulant permutation matrices, ${P}^{{V}_{ij}^{\left(1\right)}}$ and ${P}^{{V}_{ij}^{\left(2\right)}}$, correspond to the position of the i-th row block and the j-th column block, they may simply be represented in the form of a sum, such as ${P}^{{V}_{ij}^{\left(1\right)}} + {P}^{{V}_{ij}^{\left(2\right)}}$*,* and the corresponding exponent matrix (or circular shift value matrix) may be represented as shown in Equation 6 below. Referring to Equation 6, it may be seen that the exponent matrix is a matrix in which two integers correspond to the i-th row and the j-th column corresponding to the row block and the column block including the sum of the plurality of circulant permutation matrices. [Equation 5] $H = \left[{P}^{{V}_{i , j}^{\left(1\right)}}+{P}^{{V}_{i , j}^{\left(2\right)}}\right]$ [Equation 6] $V \left(H\right) = \left[\left({V}_{i , j}^{\left(1\right)}, {V}_{i , j}^{\left(2\right)}\right)\right]$

As described in the above embodiment, in general, in a QC-LDPC code, one or a plurality of circulant permutation matrices may correspond to one row block and one column block in a parity-check matrix. For reference, a matrix having a size of *Z* × *Z* in which a plurality of circulant permutation matrices are superimposed in one row block and one column block is referred to as a circulant (or circulant matrix or circular matrix). In general, the entries of a circulant matrix are not limited to binary numbers and may be any numbers. However, since the disclosure describes a binary code for convenience, the circulant matrix refers to a binary circulant matrix. Of course, the algebraic structures and characteristics proposed in the disclosure may also be extended in a similar manner to the case of a non-binary code. However, a detailed description thereof will be omitted in the disclosure.

Meanwhile, a base matrix (or a mother matrix or a base graph) corresponding to the parity-check matrix and the exponent matrix (or circular shift value matrix) of Equations 5 and 6 refers to a binary matrix obtained by replacing each circulant permutation matrix and each zero matrix with 1 and 0, respectively, similarly to the definition used in Equation 3. Here, a circulant matrix included in one block (that is, a sum of a plurality of circulant permutation matrices) may also be replaced with 1.

A simple example of the relationship among a parity-check matrix, an exponent matrix (or a circular shift value matrix), and a base matrix is shown in Equation 7 below. [Equation 7] $\begin{matrix}{H}_{1} = \left[\begin{matrix}{P}^{159} & O & {P}^{0} & {P}^{0} & O & O \\ {P}^{117} & {P}^{109} & O & {P}^{0} & {P}^{0} & O \\ O & {P}^{225} & {P}^{1} & O & {P}^{0} & {P}^{0} \\ {P}^{84} & {P}^{211} & {P}^{0} & O & O & {P}^{0}\end{matrix}\right] \left(=\left[\begin{matrix}{P}^{159} & O & I & I & O & O \\ {P}^{117} & {P}^{109} & O & I & I & O \\ O & {P}^{225} & {P}^{1} & O & I & I \\ {P}^{84} & {P}^{211} & I & O & O & I\end{matrix}\right]\right) , \\ M \left({H}_{1}\right) = \left[\begin{matrix}1 & 0 & 1 & 1 & 0 & 0 \\ 1 & 1 & 0 & 1 & 1 & 0 \\ 0 & 1 & 1 & 0 & 1 & 1 \\ 1 & 1 & 1 & 0 & 0 & 1\end{matrix}\right] , \\ V \left({H}_{1}\right) = \left[\begin{matrix}159 & - 1 & 0 & 0 & - 1 & - 1 \\ 117 & 109 & - 1 & 0 & 0 & - 1 \\ - 1 & 225 & 1 & - 1 & 0 & 0 \\ 84 & 211 & 0 & - 1 & - 1 & 0\end{matrix}\right] .\end{matrix}$

In Equation 7 above, representing the exponent (or shift value) of a zero matrix having a size of *Z* × *Z* by -1 is merely an example, and various other representations may be used. In addition, the matrix representation of Equation 7 may be expressed in various other ways. As a specific example, a representation method of a parity-check matrix of an LDPC code defined in the 3GPP 5G standard specification, 3GPP TS 38.212, may be used. In 3GPP TS 38.212, since the parity-check matrices of the LDPC codes corresponding to base graph 1 (BG1) and base graph 2 (BG2) are excessively large, they are represented using tables. When the representation method is applied to the matrices of Equation 7, the result is as shown in Table 1 below.

**H_{BG1}** is a matrix having a size of 4×8, and **H₁** is a matrix having a size of 4Z×8Z. For the entries of the base matrix (or base graph) and the parity-check matrix that are not shown in Table 1 below, 0 or a zero matrix having a size of *Z* ×*Z* corresponds thereto.

**[Table 1]**

| **H_{BG1}** | | ***V*_{*i*,*j*}** |
|---|---|---|
| Row index *i* | Column index *j* | |
| 0 | 0 | 159 |
| | 2 | 0 |
| | 3 | 0 |
| 1 | 0 | 117 |
| | 1 | 109 |
| | 3 | 0 |
| | 4 | 0 |
| 2 | 1 | 225 |
| | 2 | 1 |
| | 4 | 0 |
| | 5 | 0 |
| 3 | 0 | 84 |
| | 1 | 211 |
| | 2 | 0 |
| | 5 | 0 |

If the base matrix and the exponent matrix in Equation 7 are represented using sequences, they may be represented in the following manner.
*M*(**H₁**):
   0 2 3
   0 1 3 4
   1245
   0125
*V*(**H**₁):
   159 0 0
   117 109 0 0
   225 1 0 0
   84 211 00

When the exponent matrix V(**H₁**) is represented as sequences as described above, the sequences may, for convenience, be referred to in various ways, such as a shift sequence, a shift value sequence, or an LDPC sequence. In the above sequence representation, *M*(**H₁**) represents the positions of columns having non-zero entries, arranged for each row, and *V*(**H₁**) represents the exponents or shift values of the respective circulant permutation matrices other than zero matrices, arranged for each row. From the above sequences, the exponent matrix (or shift value matrix) may be accurately determined, and if information regarding the value of Z is obtained, the parity-check matrix may also be accurately determined.

Another simple example of the relationship among a parity-check matrix, an exponent matrix (or a circular shift value matrix), and a base matrix is shown in Equation 8 below. The example of Equation 8 illustrates a case in which the parity-check matrix includes a circulant matrix in which two or more circulant permutation matrices correspond to at least one block of size *Z* × *Z* in the parity-check matrix. [Equation 8] $\begin{matrix}{H}_{2} = \left[\begin{matrix}{P}^{117} + {P}^{159} & {P}^{109} & {P}^{0} & {P}^{0} \\ {P}^{84} & {P}^{211} + {P}^{225} & {P}^{1} + {P}^{3} & {P}^{0}\end{matrix}\right] , \\ M \left({H}_{2}\right) = \left[\begin{matrix}1 & 1 & 1 & 1 \\ 1 & 1 & 1 & 1\end{matrix}\right] , \\ V \left({H}_{2}\right) = \left[\begin{matrix}117 , 159 & 109 & 0 & 0 \\ 84 & 211 , 225 & 1 , 3 & 0\end{matrix}\right] , \\ W \left({H}_{2}\right) = \left[\begin{matrix}2 & 1 & 1 & 1 \\ 1 & 2 & 2 & 1\end{matrix}\right] .\end{matrix}$

For reference, in Equation 8 above, *W*(**H₂**) denotes a weight matrix for the base matrix, the exponent matrix, or the parity-check matrix. The weight matrix represents the number of circulant permutation matrices corresponding to the i-th row and the j-th column in the base matrix or the exponent matrix, or to the i-th row block and the j-th column block in the parity-check matrix. For example, *W*(**H₂**) denotes a matrix in which the number of circulant permutation matrices constituting a circulant matrix having a size of *Z* × *Z* corresponding to the i-th row block and the j-th column block in the parity-check matrix is represented as the entry at the i-th row and the j-th column. That is, *W*(**H₂**) is a matrix in which 0 is represented as an entry when a zero matrix corresponds thereto, and *w* is represented as an entry when *w* circulant permutation matrices correspond thereto, respectively. (For reference, although a zero matrix may be regarded as a circulant matrix in a broad sense, it is not a circulant permutation matrix.)

When the base matrix, the parity-check matrix, or the circular shift value matrix (or exponent matrix) defined in Equation 8 is represented by applying the representation method used in 3GPP TS 38.212 for representing parity-check matrices of LDPC codes, as in Table 1, the result may be expressed as shown in Table 2 below.

**H_{BG2}** is a matrix having a size of 2 × 4, and **H₂** is a matrix having a size of 2Z × 4Z. For the entries of the base matrix (or base graph) and the parity-check matrix that are not shown in Table 2 below, 0 or a zero matrix having a size of *Z* × *Z* corresponds thereto.

**[Table 2]**

| **H_{BG2}** | | ***V_{i,j}*** |
|---|---|---|
| Row index *i* | Column index *j* | |
| 0 | 0 | 117,159 |
| | 1 | 109 |
| | 2 | 0 |
| | 3 | 0 |
| 1 | 0 | 84 |
| | 1 | 211, 225 |
| | 2 | 1, 3 |
| | 3 | 0 |

If the base matrix and the exponent matrix of Equation 8 are represented using sequences, they may be represented in the following manner.
*M*(**H₂**):
   0 1 2 3
   0 1 2 3
*V*(**H₂**):
   (117, 159) 109 0 0
   84 (211, 225) (1, 3) 0

Alternatively, the matrices may be represented in the form of sequences only by using a weight matrix, as follows.
*M*(**H₂**):
   0 1 2 3
   0 1 2 3
*W*(**H₂**):
   2 1 1 1
   1 2 2 1
*V*(**H₂**):
   117 159 109 0 0
   84 211 225 1 3 0

In the above representation, *M*(**H₂**) represents the positions of columns having non-zero entries, arranged for each row, *W*(**H₂**) is a matrix defined based on the number of circulant permutation matrices constituting circulant matrices corresponding to the base matrix, the exponent matrix, or the parity-check matrix, and *V*(**H₂**) represents the exponents or shift values of the respective circulant matrices other than zero matrices, arranged for each row. From the above sequences, the exponent matrix may be accurately determined, and if information regarding the value of Z is obtained, the parity-check matrix may also be accurately determined.

Since the performance of an LDPC code is determined by its parity-check matrix, it is necessary to design a parity-check matrix for an LDPC code having excellent performance. In addition, an LDPC encoding or decoding method capable of supporting various input lengths and code rates is required.

Lifting may refer not only to a method used for efficient design of a QC-LDPC code, but also to a method used for generating parity-check matrices having various lengths or generating LDPC codewords using a given base matrix and exponent matrix. That is, the lifting may refer to a method of efficiently designing a very large parity-check matrix by configuring a value of Z, which determines the size of a circulant permutation matrix or a zero matrix from a given small mother matrix, according to a predetermined rule, or to a method of generating parity-check matrices having various lengths or generating LDPC codewords by applying an appropriate value of Z to a given exponent matrix or a sequence corresponding thereto.

The characteristics of the conventional lifting method and the QC-LDPC code designed through the lifting method will now be briefly described with reference to the following reference [Myung2006].

### Reference [Myung2006]

S. Myung, K. Yang, and Y. Kim, "Lifting Methods for Quasi-Cyclic LDPC Codes," IEEE Communications Letters, vol. 10, pp. 489-491, June 2006.

First, when an LDPC code C₀ is given, let C₁ ...., C_{S} denote S QC-LDPC codes to be designed through a lifting method, and let Lₖ denote a value corresponding to the size of the row blocks and the column blocks of a parity-check matrix of each QC-LDPC code. Here, C₀ corresponds to the smallest LDPC code having, as a parity-check matrix, a mother matrix of the codes C₁ ...., C_{S}, and the value of Z₀, corresponding to the size of the row blocks and the column blocks, is 1. Further, for convenience, the parity-check matrix **H*ₖ*** of each code Cₖ has an exponent matrix $V \left({H}_{k}\right) = \left({V}_{ij}^{\left(k\right)}\right)$ of size *m* × *n*, and each exponent ${V}_{ij}^{\left(k\right)}$ is selected from one of the values {-1, 0, 1, 2, ..., *Zₖ* - 1}.

The conventional lifting method is performed in the order of C₀ → C₁ → ··· → C_{S}, and is characterized by satisfying the condition Zₖ₊₁ = qₖ₊₁Zₖ (qₖ₊₁ is a positive integer, k = 0,1, ..., S - 1). Further, due to the characteristics of the lifting process, when only the parity-check matrix **H*_{S}*** of C_{S} is stored, all of the QC-LDPC codes C₀, C₁ ...., C_{S} may be represented according to the lifting method by using Equation 9 or Equation 10 below. [Equation 9] $V \left({H}_{k}\right) ≡ \left⌊\frac{{Z}_{k}}{{Z}_{S}}V\left({H}_{S}\right)\right⌋$ or
[Equation 10] $V \left({H}_{k}\right) ≡ V \left({H}_{S}\right) \left(mod {Z}_{k}\right)$

As described above, not only a method of designing larger QC-LDPC codes C₁ ...., C_{S} from C₀, but also a method of generating smaller codes Cᵢ (i=k-1, k-2 ... 1, 0) from a larger code Cₖ by using an appropriate method, such as that of Equation 9 or Equation 10, may be referred to as lifting. For reference, in 3GPP TS 38.212, LDPC codes having various lengths may be generated by using the lifting method of Equation 10.

In the lifting method of Equation 9 or Equation 10, the values Zₖ, corresponding to the sizes of the row blocks or the column blocks in the parity-check matrices of the respective QC-LDPC codes Cₖ, have a multiple relationship with one another, and the exponent matrices are also selected according to a particular method. Such a conventional lifting method facilitates the design of QC-LDPC codes having improved error-floor characteristics by improving the algebraic or graph characteristics of each parity-check matrix designed through lifting.

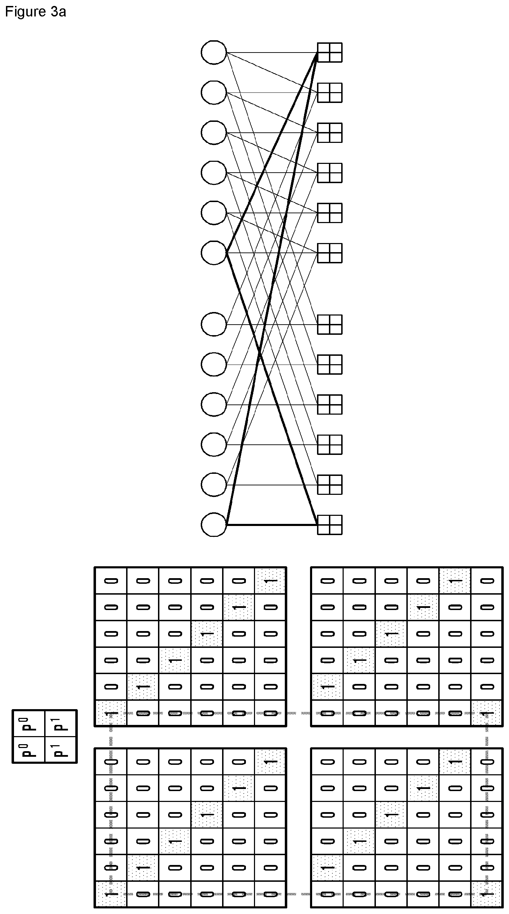

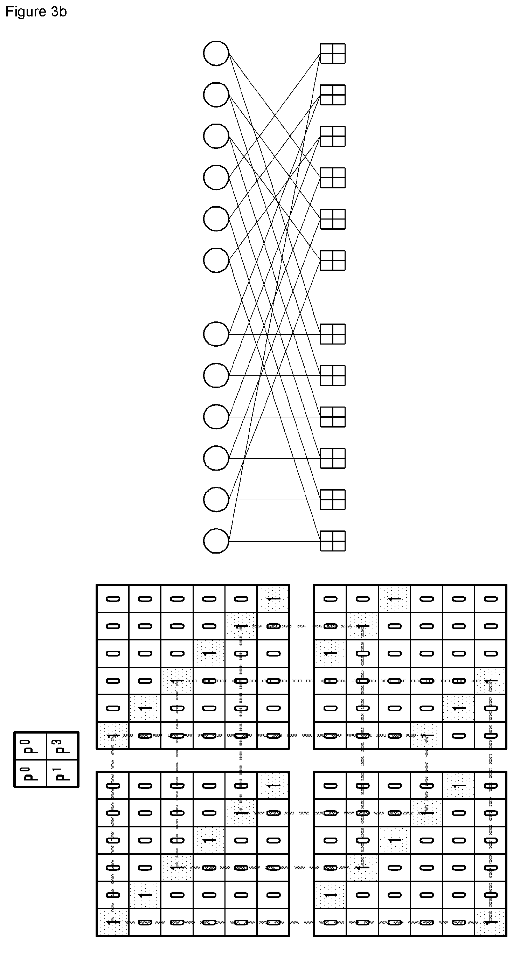

FIGS. 3A and 3B are exemplary diagrams for briefly describing that the cycle characteristics of a QC-LDPC code may vary significantly depending on the exponent matrix of the QC-LDPC code.

FIG. 3A is a diagram for describing the cycle characteristics of a QC-LDPC code.

The exponent matrix of FIG. 3A is ${\left[\begin{matrix}{P}^{0} & {P}^{0} \\ {P}^{1} & {P}^{1}\end{matrix}\right]}_{\left(Z=6\right)}$*,* and in this case, many 4-cycles may exist in the Tanner graph. A code having many such short cycles may suffer significant degradation in decoding performance.

FIG. 3B is a diagram for describing the cycle characteristics of a QC-LDPC code.

The exponent matrix of FIG. 3B is ${\left[\begin{matrix}{P}^{0} & {P}^{0} \\ {P}^{1} & {P}^{3}\end{matrix}\right]}_{\left(Z=6\right)}$, and in this case, the length of the shortest cycle in the Tanner graph is 12. As described above, since the cycle characteristics of the Tanner graph may vary significantly even when only one exponent of a circulant permutation matrix is changed, selection of the exponent matrix plays an important role in improving the performance of an LDPC code. The lifting method may also be regarded as one of the design methods that take such cycle characteristics into consideration.

In general, lifting may be regarded as using the exponent matrix of Equation 4 for LDPC encoding and decoding by changing the values of the entries thereof for various values of Z. For example, when the exponent matrix of Equation 4 is denoted by *V*(**H**) = (*V_{i,j}*)*,* and an exponent matrix transformed according to a value of Z is denoted by *V*(**H**(**Z**)) = (*V_{i,j}* (*Z*)), in general, a transformation equation such as Equation 11 below may be applied. [Equation 11] ${V}_{i , j} \left(Z\right) = \left\{\begin{matrix}{V}_{i , j} & {V}_{i , j} < 0 \\ f \left({V}_{i , j}, Z\right) & {V}_{i , j} \geq 0\end{matrix}\right. or {V}_{i , j} \left(Z\right) = \left\{\begin{matrix}{V}_{i , j} & {V}_{i , j} \leq 0 \\ f \left({V}_{i , j}, Z\right) & {V}_{i , j} > 0\end{matrix}\right.$

In Equation 11, *f*(*x, Z*) may be defined in various forms. For example, Equation 9 corresponds to $f \left(x, Z\right) = \left⌊\left(Z/{Z}_{max}\right)x\right⌋$ (where *Z*ₘₐₓ = *Z_{S}*), and Equation 10 may correspond to *f*(*x, Z*) = *mod*(*x, Z*) (where mod(a, b) denotes a modulo-b operation on *a*). In addition, *f*(*x, Z*) may also be defined in various other manners, as shown in Equation 12 below. [Equation 12] $\begin{matrix}f \left(x, Z\right) = mod \left(x{, 2}^{\left⌊{log}_{2} Z\right⌋}\right) \\ or \\ f \left(x, Z\right) = \left⌊\frac{x}{{2}^{D - \left⌊{log}_{2} Z\right⌋}}\right⌋ \\ or \\ f \left(x, Z\right) = \left⌊\frac{Z}{D}x\right⌋\end{matrix}$

In Equation 12, D denotes a positive integer constant predefined in advance.

For reference, in the transformation equation of Equation 11, the reference value for applying the transformation equation (or transformation function) *f* (or the reference value of *V_{i,j}* for distinguishing between application of *V_{i,j}* and *f*(*V_{i,j}, Z*)) is, for convenience, represented as 0. However, the reference value may be configured differently according to a value of the lifting size Z to be supported or a method of representing a zero matrix having a size of ***Z*** × ***Z*.** For example, when a zero matrix having a size of ***Z*** × ***Z*** is represented by another predefined value or symbol instead of the negative integer -1, the reference value for applying the transformation equation *f* may be defined differently. Further, when the exponent matrix or the LDPC sequence is represented based on a scheme in which exponents corresponding to zero matrices are omitted from the representation, the rule for exponents having values less than 0 in Equation 11 may be omitted. Since the transformation equation *f* is applied to circulant permutation matrices or circulant matrices other than zero matrices, methods of omitting the transformation for zero matrices of size ***Z*** × ***Z*** may, in general, be expressed in various ways.

According to an embodiment of the disclosure, a case in which LDPC encoding and decoding are performed based on a plurality of exponent matrices or LDPC sequences based on one predetermined base matrix will be described. That is, one base matrix is fixed, and an exponent matrix, a (circular) shift value matrix, an LDPC sequence, or the like of an LDPC code defined based on the base matrix may be determined. By applying lifting to the matrix or sequence according to a lifting size included in each lifting size group, variable-length LDPC encoding and decoding are performed. In this approach, although the entries or values constituting the exponent matrix or the LDPC sequence of the LDPC code may differ from one another, the positions of the corresponding entries or values exactly coincide in the base matrix.

An LDPC code defined in TS 38.212, which is a 3GPP 5G standard specification, is also a code designed in the above-described manner. In the specification, two base matrices **H_{BG}** are defined, and eight exponent matrices (or circular shift value matrices) $V \left({H}_{{i}_{LS}}\right) = \left({V}_{i , j}^{\left({i}_{LS}\right)}\right) \left({i}_{LS}=0,1,2,…,7\right)$ are defined for each base matrix and may be used for LDPC encoding. That is, according to the standard specification, parity-check matrices of various LDPC codes may be determined based on a total of two base matrices, sixteen exponent matrices, and an appropriate lifting size *Z*. However, in the TS 38.212 specification, the matrix corresponding to *V*(**H***_{iLS}*) is referred to as a parity-check matrix, whereas a matrix corresponding to a conventional parity-check matrix is referred to as Matrix **H.** Although *V*(**H***_{iLS}*) is a matrix composed of integers and, in a strict sense, can constitute a parity-check matrix only when a lifting size *Z* is given, *V*(**H***_{iLS}*) may also be referred to as a parity-check matrix for convenience, as described above.

Hereinafter, for convenience of description, the LDPC code defined in TS 38.212, which is a 3GPP 5G standard specification, and the representation method thereof will be used to the greatest extent possible. However, in some cases, conventional mathematical notation or other representation methods may also be used. First, the lifting sizes Zto be supported for determining a parity-check matrix or Matrix **H** of the LDPC code are shown in Table 3 below. (Hereinafter, the set index *i_{LS}* for each lifting size set is merely an example and may be arranged in a different order.)

**[Table 3]**

| ***Set index (i_{LS})*** | ***Set of lifting sizes (Z)*** |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In the disclosure, lifting sizes or block sizes are basically represented in the manner shown in Table 3 above. However, they may also be represented in the manner shown in Table 4 below, and various other representation methods may also be used.

**[Table 4]**

| ***Set index (i_{LS})*** | ***Set of lifting sizes (Z)*** |
|---|---|
| 0 | 2 × 2*^{k}, k* = 0,1,2,...,7 |
| 1 | 3 × 2*^{k}, k* = 0, 1, 2, ... , 7 |
| 2 | 5 × 2*^{k}, k* = 0, 1, 2, ... , 6 |
| 3 | 7 × 2*^{k}, k* = 0, 1, 2, ... , 5 |
| 4 | 9 × 2*^{k}, k* = 0, 1, 2, ... , 5 |
| 5 | 11 × 2*^{k}, k* = 0, 1, 2, ... , 5 |
| 6 | 13 × 2*^{k}, k* = 0*,* 1*,* 2*, ... ,* 4 |
| 7 | 15 × 2*^{k}, k* = 0, 1, 2, ... , 4 |

In 3GPP 5G, lifting sizes or block sizes *Z* may be divided into and used as a plurality of sets (or groups), as shown in Table 3 above or Table 4 below. (Hereinafter, for convenience, such sets (or groups) are referred to as lifting size sets (or groups) or block size sets (or groups).)

In the 3GPP 5G standard, a parity-check matrix or Matrix **H** is determined based on an exponent matrix *V*(**H***_{iLS}*(*Z*)) ≡ *V*(**H***_{iLS}*) (mod *Z*) obtained by using the lifting method of Equation 10. That is, when $V \left({H}_{{i}_{LS}}\right) = \left({V}_{i , j}^{\left({i}_{LS}\right)}\right)$ and $V \left({H}_{{i}_{LS}}\left(Z\right)\right) = \left({V}_{i , j}^{\left({i}_{LS}\right)}\left(Z\right)\right)$*,* it means that ${V}_{i , j}^{\left({i}_{LS}\right)} \left(Z\right) = mod \left({V}_{i , j}^{\left({i}_{LS}\right)}, Z\right)$ for each *i* and *j.* (For reference, in the 3GPP 5G standard specification TS 38.212, ${V}_{i , j}^{\left({i}_{LS}\right)} \left(Z\right)$ is simply denoted by *P_{i,j}.*)

As described above with reference to Equation 11, it should be noted that, in the disclosure, no special transformation is applied to portions corresponding to zero matrices of size *Z* × *Z* in the base matrix and the exponent matrix. That is, even in *V* (**H***_{iLS}*(*Z*)) *= V*(**H***_{iLS}*) (mod *Z*) , unless otherwise specified, no special transformation is performed on portions corresponding to zero matrices, and only the sizes of the zero matrices may vary according to the value of *Z*. As a specific example, in the representation method used in the 3GPP 5G standard specification, as shown in Tables 1 and 2, portions corresponding to zero matrices of size *Z* × *Z* are not represented from the start. Therefore, when only the *V_{i,j}* values included in Table 1 or Table 2 are subjected to a predetermined transformation, such as a modulo operation, the portions corresponding to the zero matrices naturally undergo no transformation, thereby producing the same result as defining zero matrices that differ only in size. The above representation method is merely an example for convenience of description, and various other representation methods may also be used.

Since a parity-check matrix or Matrix **H** may be transformed in various ways according to the lifting sizes defined in Table 3 above for a given exponent matrix (or circular shift value matrix), the lifting size sets required for a particular system may be defined differently. That is, Tables 3 and 4 are merely examples. All lifting size (Z) values included in the lifting size (or block size) groups (or sets) of Tables 3 and 4 may be used, only some of the appropriate lifting sizes may be selected and used according to system requirements, or additional lifting size values may be added as needed.

For example, when the minimum transport block size (TBS) has a value of 24, the lifting sizes Z= 2, 3, 4, 5, 6, 9, and 13 are, in practice, not used in the system. In this case, the lifting size sets may be defined by excluding some Z values, as shown in Table 5 below.

**[Table 5]**

| ***Set index (i_{LS})*** | ***Set of lifting sizes (Z)*** |
|---|---|
| 0 | {8, 16, 32, 64, 128, 256} |
| 1 | {12, 24, 48, 96, 192, 384} |
| 2 | {10, 20, 40, 80, 160, 320} |
| 3 | {7, 14, 28, 56, 112, 224} |
| 4 | {18, 36, 72, 144, 288} |
| 5 | {11, 22, 44, 88, 176, 352} |
| 6 | {26, 52, 104, 208} |
| 7 | {15, 30, 60, 120, 240} |

In a communication system based on an LDPC code in which the lifting sizes of Table 5 are applied, since the minimum lifting size is 7, each column block constituting the parity-check matrix of the LDPC code used for LDPC encoding and decoding may include at least seven columns.

If, in consideration of future extensibility, the minimum transport block size (TBS) is 8 or greater and additional values, such as 8 and 16, are used, the lifting size sets (or block size groups) may be modified as shown in Table 6 below.

**[Table 6]**

| ***Set index (i_{LS})*** | ***Set of lifting sizes (Z)*** |
|---|---|
| 0 | {4, 8, 16, 32, 64, 128, 256} |
| 1 | {6, 12, 24, 48, 96, 192, 384} |
| 2 | {(5,) 10, 20, 40, 80, 160, 320} |
| 3 | {7, 14, 28, 56, 112, 224} |
| 4 | {(9,) 18, 36, 72, 144, 288} |
| 5 | {11, 22, 44, 88, 176, 352} |
| 6 | {(13,) 26, 52, 104, 208} |
| 7 | {15, 30, 60, 120, 240} |

Since the minimum value of *Z* that may be determined when the TBS is 8 or greater is 4, Table 6 is obtained by excluding only the cases where Z = 2, 3 from Table 3 or Table 4.

As another example of configuring lifting size sets, when lifting size sets are classified into *A* sets, Z₁, *Z*₂*, Z*₃*,* ... , *Z_{A},* they may basically be classified in the following manner. (*k* = 1, 2, ...) ${Z}_{1} = \left\{A,2A,…{, 2}^{k}A\right\}$ ${Z}_{2} = \left\{\left(A+1\right),2\left(A+1\right),…{, 2}^{k}\left(A+1\right)\right\}$ ... ${Z}_{i} = \left\{\left(A+i-1\right),2\left(A+i-1\right),…{, 2}^{k}\left(A+i-1\right)\right\}$ ... ${Z}_{A} = \left\{2A-1,2\left(2A-1\right),…{, 2}^{k}\left(2A-1\right)\right\}$

For example, examples in which A=4 and A=8 may be shown in Tables 7-1 and 7-2 below, respectively. (k=0,1,2,...).

**[Table 7-1]**

| ***Set of lifting sizes (Z)*** |
|---|
| 4, 8, 16, 32, ... (= 4 × 2*^{k}*) |
| 5, 10, 20, 40, ... (= 5 × 2*^{k}*) |
| 6, 12, 24, 48, ... (= 6 × 2*^{k}*) |
| 7, 14, 28, 56, ... (= 7 × 2*^{k}*) |

**[Table 7-2]**

| ***Set of lifting sizes (Z)*** |
|---|
| 8, 16, 32, 64, ... (= 8 × 2*^{k}*) |
| 9, 18, 36, 72, ... (= 9 × 2*^{k}*) |
| 10, 20, 40, 80, ... (= 10 × 2*^{k}*) |
| 11, 22, 44, 88, ... (= 11 × 2*^{k}*) |
| 12, 24, 48, 96, ... (= 12 × 2*^{k}*) |
| 13, 26, 52, 108, ... (= 13 × 2*^{k}*) |
| 14, 28, 56, 112, ... (= 14 × 2*^{k}*) |
| 15, 30, 60, 120, ... (= 15 × 2*^{k}*) |

When lifting size sets are defined in the manner shown in Tables 7-1 and 7-2, the distribution of the *Z* values may be configured to be relatively uniform. Although the lifting size sets defined in Tables 7-1 and 7-2 each include the same number of *Z* values, appropriate *Z* values may be added to or removed from each set as necessary. For example, the lifting size sets of Tables 3 to 6 may be defined based on the lifting size sets of Table 7-2.

Further, by appropriately configuring the range of the value of *k* in Tables 7-1 and 7-2, *Z* values suitable for the system may also be configured. For example, when the value of *k* is configured as *k* = 0,1, ...,6, lifting size sets each including seven different *Z* values are obtained. When the value of *k* is configured as *k* = 3,4, ... ,6 , lifting size sets each including four different *Z* values are obtained. However, the value of *k* is merely an embodiment, and the example of the value of *k* does not limit the scope of the disclosure. In addition, depending on the circumstances, appropriate *Z* values may be added to or some *Z* values may be excluded from the lifting size sets. For example, if the maximum value of *Z* configured in the system is *Z*ₘₐₓ, all values greater than *Z*ₘₐₓ may be removed (e.g., *Z*ₘₐₓ = 768). In addition, when all *Z* values supported by the existing 3GPP 5G standard are included, at least some of the values 2, 3, 4, 5, 6, and 7 may additionally be included. Of course, even when additional support is provided for values such as TBS = 8 and 16 in a 5G or 6G system, values such as *Z* = 2 and *Z* = 3 are not used. Accordingly, only values such as 4, 6, and 7 or 4, 5, 6, and 7 may additionally be included, and values that are not substantially used in 5G may be excluded. A specific example of lifting size sets is shown in Table 8 below. (In Table 8, the values in parentheses indicate values that may or may not be used as lifting sizes.)

**[Table 8]**

| ***Set index (i_{LS})*** | ***Set of lifting sizes (Z)*** |
|---|---|
| 0 | {(2, 4,) 8, 16, 32, 64, 128, 256, 512} |
| 1 | {(3, 6,) 12, 24, 48, 96, 192, 384, 768} |
| 2 | {(5,) 10, 20, 40, 80, 160, 320, 640} |
| 3 | {7, 14, 28, 56, 112, 224, 448(, 896)} |
| 4 | {(9,) 18, 36, 72, 144, 288, 576} |
| 5 | {11, 22, 44, 88, 176, 352, 704} |
| 6 | {(13,) 26, 52, 104, 208, 416(, 832)} |
| 7 | {15, 30, 60, 120, 240, 480(, 960)} |

Although the lifting size sets may be defined in various other ways in addition to those shown in Tables 3 to 8, a common characteristic is that each of the plurality of lifting size sets should not have any overlapping lifting sizes, and the lifting sizes included in each lifting size set should be in a multiple or divisor relationship with one another. Although Tables 3 to 8 are configured such that each lifting size set consists of consecutive multiples of 2*^{k}*(*k* = 0,1,2, ...) with respect to the smallest lifting size in the corresponding lifting size set, each lifting size set may generally consist of non-consecutive multiples, such as 2*^{k}*(*k* = 0,1,3,5, ...), and may also include multiples of integers other than 2.

In a new communication system, including a 6G system, the existing lifting size sets may be maintained (e.g., Tables 3 or 4) in order to support backward compatibility with an existing system (e.g., a 5G system), and new lifting size sets may be added (e.g., Tables 5 to 8). Alternatively, a single lifting size set may be defined, and if the range of TBS values to be used is predetermined differently according to system settings, such as an application scenario or a target BLER, the range of *Z* values to be used also varies. For example, if a first minimum TBS value and a first maximum TBS value are configured for a service to which a first target BLER is applied, and a second minimum TBS value and/or a second maximum TBS value are configured for a service to which a second target BLER is applied, the first minimum TBS value may differ from the second minimum TBS value, or the first maximum TBS value may differ from the second maximum TBS value (or both the minimum values and the maximum values may differ).

Further, an application service scenario or a target BLER may also be determined based on higher-layer signaling information. For example, a channel quality information (CQI) table or a modulation and coding scheme (MCS) table may generally be determined in consideration of a target service scenario or target BLERs. (For example, a first target service or target BLER corresponds to a first CQI table and/or a first MCS table, a second target service or target BLER corresponds to a second CQI table and/or a second MCS table, a third target service or target BLER corresponds to a third CQI table and/or a third MCS table, ...)

As a result, the range of lifting sizes to be used or the lifting size set to be used may be determined from the higher-layer signaling information, and intermediate operations therebetween may vary depending on the system. In addition, the lifting size set to be used may be indicated through physical-layer signaling or higher-layer signaling. A parity-check matrix may be determined based on the indicated lifting size set and the determined lifting size Z.

For reference, in the disclosure, a target BLER refers to a minimum BLER to be achieved by the system, and is generally configured such that the average BLER of a UE or a base station does not exceed the target BLER.

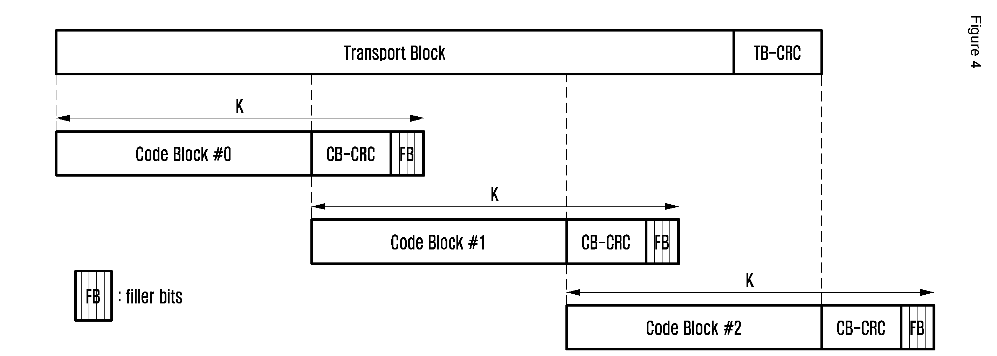

FIG. 4 illustrates a transport block structure according to an embodiment of the disclosure.

Referring to FIG. 4, L CRC bits (TB-CRC bits) are added to a transport block composed of A bits, and one transport block may constitute one code block. Further, when B=A+L is greater than a predetermined threshold value, the transport block may be divided into a plurality of code blocks through an appropriate segmentation process. In this case, the code blocks all have the same size K, and, to this end, specific bits, referred to as null bits or filler bits, may be added to each code block. The null bits or filler bits generally correspond to a value of 0. However, the disclosure is not necessarily limited thereto, and the null bits or filler bits may also consist of predetermined specific bits. The operation of adding predetermined bits, such as null bits or filler bits, as described above is generally referred to as shortening because the size of the actual information word bits is reduced. When the values thereof are 0, the operation may also be referred to as zero-padding.

After the transport block size (TBS) of a transport block to be transmitted is determined, one of two different LDPC base matrices used for LDPC encoding or decoding may be determined based on the TBS and the code rate indicated by the MCS through a method such as the following [Base Matrix Determination Method].

### [Base Matrix Determination Method]

The LDPC base matrix for LDPC encoding and decoding of a transport block having a TBS = A may be determined based on the TBS and the code rate indicated by the MCS, as follows:
- When A ≤ 292 (or 288), when A ≤ 3824 and R ≤ 0.67, or when R ≤ 0.25, LDPC encoding may be performed using LDPC base matrix 2.
- Otherwise, LDPC encoding may be performed using LDPC base matrix 1. For reference, base matrix 1 *M*(**H_{*BG*1}**) and base matrix 2 *M*(**H_{*BG*2}**) defined in the 3GPP 5G standard are as follows.

*M*(**H_{*BG*1}**):
   0 1 2 3 5 6 9 10 11 12 13 15 16 18 19 20 21 22 23
   0 2 3 4 5 7 8 9 11 12 14 15 16 17 19 21 22 23 24
   0 12 4 5 6 7 8 9 10 13 14 15 17 18 19 20 24 25
   0 1 3 4 6 7 8 10 11 12 13 14 16 17 18 20 21 22 25
   0126
   0 1 3 12 16 21 22 27
   0 6 10 11 13 17 18 20 28
   0 1 4 7 8 14 29
   0 13 12 16 19 21 22 24 30
   0 1 10 11 13 17 18 20 31
   1 2 4 7 8 14 32
   0 1 12 16 21 22 23 33
   0 1 10 11 13 18 34
   0 3 7 20 23 35
   0 12 15 16 17 21 36
   0 1 10 13 18 25 37
   1 3 11 20 22 38
   0 14 16 17 21 39
   1 12 13 18 19 40
   0 1 7 8 10 41
   0 3 9 11 22 42
   15 16 20 21 43
   0 12 13 17 44
   1 2 10 18 45
   0 3 4 11 22 46
   1 6 7 14 47
   0 2 4 15 48
   1 6 8 49
   0 4 19 21 50
   1 14 18 25 51
   0 10 13 24 52
   1 7 22 25 53
   0 12 14 24 54
   1 2 11 21 55
   0 7 15 17 56
   1 6 12 22 57
   0 14 15 18 58
   1 13 23 59
   0 9 10 12 60
   1 3 7 19 61
   0 8 17 62
   1 3 9 18 63
   0 4 24 64
   1 16 18 25 65
   0792266
   1 6 10 67
*M*(**H_{*BG*2}**):
   0 1 2 3 6 9 10 11
   0 3 4 5 6 7 8 9 11 12
   0 13 4 8 10 12 13
   1 2 4 5 6 7 8 9 10 13
   0 1 11 14
   0 1 5 7 11 15
   05791116
   157111317
   0 1 12 18
   18101119
   016720
   0 7 9 13 21
   1 3 11 22
   0 1 8 13 23
   1 6 11 13 24
   0 10 11 25
   1 9 11 12 26
   1 5 11 12 27
   06728
   0 1 10 29
   1 4 11 30
   08 13 31
   1232
   0 3 5 33
   12934
   0535
   2 7 12 13 36
   0637
   12538
   0439
   257940
   1 13 41
   05 12 42
   27 1043
   0 12 13 44
   1 5 11 45
   02746
   10 13 47
   1 5 11 48
   07 12 49
   2 10 13 50
   1 5 11 51

The sizes of base matrix 1 *M*(**H_{*BG*1}**) and base matrix 2 *M*(**H_{*BG*2}**) are 46 × 68 and 42 × 52, respectively, and the sizes of the parity-check matrices determined from the base matrices are 46*Z* × 68*Z* and 42*Z* × 52*Z*, respectively.

Further, according to the determined TBS, the number of CRC bits (L_{TB}) to be appended to the transport block may be determined as follows.

### [Transport Block CRC Bit Number Determination Method]

The value of the CRC bit size L_{TB} for a transport block having a TBS = A may be configured differently according to the TBS value, as follows.

When A > 3824, L_{TB} = 24; otherwise, L_{TB} = 16.

According to the TBS size (A) determined as described above or the total number of bits B = A + L obtained by appending a CRC to the transport block, appropriate code blocks may be determined from the transport block, and LDPC encoding and decoding may be performed for each code block. In this case, a process of determining a code block size (CBS) will be described in more detail as follows:

### [CBS Determination Method]

An input bit sequence for code block segmentation may be represented as b₀, b₁, ..., bB-₁.(B > 0) If B is greater than the maximum code block size K_{cb}, segmentation of the input bit sequence is performed, and a CRC of L = 24 bits is additionally appended to each code block. The maximum code block size is K_{cb} = 8448 for LDPC base matrix 1 and K_{cb} = 3840 for LDPC base matrix 2.

The detailed procedure is as follows.

Operation 1: The number of code blocks C may be determined.

If *B* ≤ *K_{cb}, L* = 0*,* C = 1, and *B'* = *B.*

Otherwise, *L* = 24, $C = \left⌈B/\left({K}_{cb}-L\right)\right⌉$*,* and *B'* = *B + C* × *L.*

Operation 2: Let the output bits from the code block segmentation be cᵣ₀, cᵣ₁, ..., cr_{(Kr - 1)}, where r denotes a code block number (0 ≤ r < C), and Kr (= K) denotes the number of bits of the code block corresponding to code block number r. Here, the number of bits K included in each code block may be calculated as follows:
$K ′ = B ′ / C ;$

For LDPC base matrix 1, K_{b} = 22.

For LDPC base matrix 2,
if *B* > 640, *K_{b}* = 10;
if 560 *< B* ≤ 640, *K_{b}* = 9;
if 192 *< B* ≤ 560, *K_{b}* = 8;
if *B* ≤ 192, *K_{b}* = 6.

Operation 3: The minimum value *Zc* satisfying *K_{b} · Z_{c}* ≥ *K'* among the Z values of Table 3 may be determined. K is configured as *K* = *22Z_{c}* for LDPC base matrix 1 and as *K* = 10*Z_{c}* for LDPC base matrix 2.

In operation 2 of the [CBS Determination Method], the value *K_{b}* corresponds to the columns or column blocks corresponding to LDPC information word bits (information bits) in the base matrix (or base graph) or the parity-check matrix of the LDPC code, and may correspond to the maximum number of LDPC information word bits without shortening or zero-padding (= *K_{b}Z_{c}*). For example, even when the number of columns (or column blocks) corresponding to the information word bits in LDPC base matrix 2 or the parity-check matrix corresponding to base matrix 2 is 10, if *K_{b}* is configured as 6, LDPC encoding/decoding is substantially performed for the maximum of 6*Z_{c}* information word bits, which means that the information word bits corresponding to at least (10 *- K_{b}*)*Z_{c}* = 4*Z_{c}* columns in the parity-check matrix are shortened or zero-padded. Here, shortening or zero-padding may mean assigning predetermined bit values, such as 0, by agreement between the transmitter and the receiver, or may mean that the corresponding portion of the parity-check matrix is not used.

The value of the lifting size Z for LDPC encoding and decoding may be determined based on the lifting size sets shown in Tables 3 to 8 or lifting size sets obtained by adding and removing particular lifting size values. Each Z value belongs to a particular set predetermined according to the index i_{LS}. When the Z value is determined in Operation 3 of the [CBS Determination Method], the set corresponding to the Z value or the index value i_{LS} of the set is determined, and the parity-check matrix of the LDPC code corresponding to each index or a sequence corresponding thereto may also be determined. A modulo operation based on the lifting size Z is applied to the parity-check matrix of the LDPC code determined as described above or a sequence corresponding thereto to transform the parity-check matrix or the sequence, thereby supporting encoding and decoding of LDPC codes having various lengths. In the 3GPP 5G standard as well, each number included in the parity-check matrix or sequence of the LDPC code represents a value corresponding to a circulant permutation matrix.

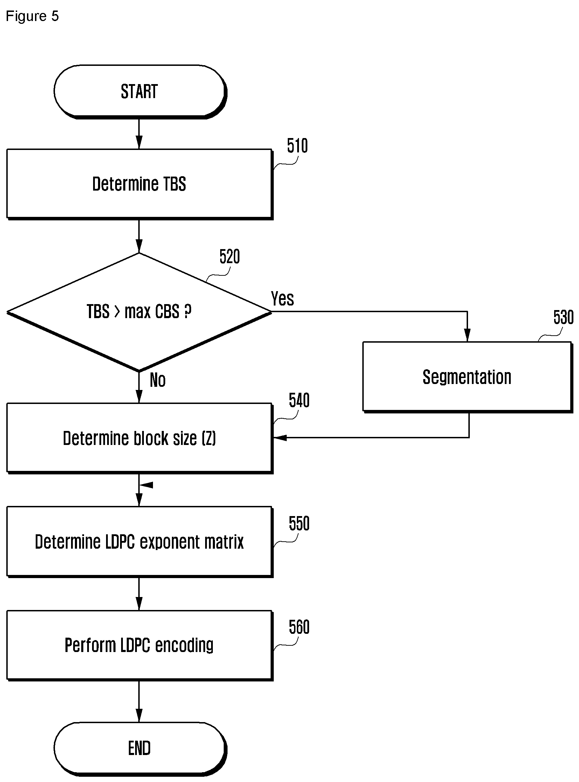

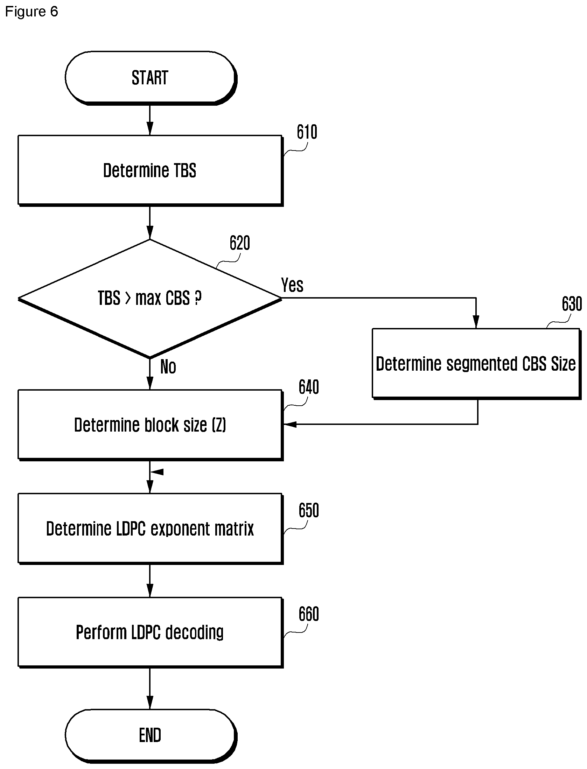

FIGS. 5 and 6 illustrate flowcharts of embodiments of the LDPC encoding and decoding process based on the designed base matrix or exponent matrix.

FIG. 5 is a diagram illustrating an embodiment of an LDPC encoding process.

First, in operation 510 of FIG. 5, a transmitter determines a transport block size (TBS) to be transmitted. In operation 520, the transmitter determines whether the TBS is greater than the maximum CBS or less than or equal to the maximum CBS.

If the TBS is greater than the maximum CBS, the transmitter may segment the transport block to determine a CBS in operation 530. If the TBS is less than or equal to the maximum CBS, the transmitter omits the segmentation operation and determines the TBS as the CBS.

In operation 540, the transmitter determines a lifting size (Z) value to be applied to LDPC encoding based on the CBS.

In operation 550, the transmitter determines a parity-check matrix or a sequence according to the TBS, the CBS, or the lifting size (Z) value. Alternatively, the transmitter may determine an LDPC exponent matrix or a sequence having the same algebraic effect as the parity-check matrix.

In operation 560, the transmitter performs LDPC encoding based on the parity-check matrix or the sequence. Alternatively, in operation 560, the transmitter may perform LDPC encoding based on the exponent matrix or the sequence. Further, in operation 560, the transmitter may perform LDPC encoding based on the lifting size and the exponent matrix or the sequence.

For reference, operation 550 may, in some cases, include a process of transforming the determined LDPC exponent matrix or sequence based on the determined lifting size. It is apparent that the LDPC exponent matrix, sequence, or parity-check matrix for LDPC encoding may be determined in various ways based on the TBS or the CBS depending on the system. For example, the transmitter may first determine a base matrix, based on the TBS and then determine an LDPC exponent matrix, a sequence, or a parity-check matrix, based on the determined base matrix and the CBS. Various other methods may also be applied. For reference, an additional operation may be included between operation 520 and operation 540 or between operation 530 and operation 540 depending on the system. For example, in the 3GPP 5G system, when base matrix 2 (M(**H_{*BG*2}**)) is used, a process of determining the value K_{b}, which indicates the number of columns to be substantially used in the base matrix or the number of column blocks to be used in the parity-check matrix according to the TBS, may be included. (For reference, shortening is applied to the column blocks of the parity-check matrix corresponding to the (10 - *K_{b}*) columns of the base matrix.)

The LDPC decoding process may also be illustrated similarly, as shown in FIG. 6.

FIG. 6 illustrates an embodiment of an LDPC decoding process.

When the TBS has been determined in operation 610, a receiver determines whether the TBS is greater than the maximum CBS or less than or equal to the maximum CBS in operation 620. If the TBS is greater than the maximum CBS, the receiver determines the size of the CBS to which segmentation has been applied in operation 630. If it is determined that the TBS is less than or equal to the maximum CBS, the TBS is determined to be the same as the CBS.

In operation 640, the receiver determines a lifting size (Z) value to be applied to LDPC decoding.

In operation 650, the receiver determines a parity-check matrix or a sequence according to the TBS, the CBS, or the lifting size (Z) value. Alternatively, the receiver may determine an exponent matrix or a sequence having the same algebraic effect as the parity-check matrix.

In operation 660, the receiver may perform LDPC decoding based on the parity-check matrix or the sequence. Alternatively, the receiver may perform LDPC decoding using the exponent matrix or the sequence in operation 660. For reference, operation 650 may, in some cases, include a process of transforming the determined LDPC exponent matrix or sequence, based on the determined lifting size. It is apparent that, depending on the system, the LDPC exponent matrix, sequence, or parity-check matrix for LDPC decoding may be determined in various ways based on the TBS or the CBS. For example, the receiver may first determine a base matrix, based on the TBS and then determine an LDPC exponent matrix, a sequence, or a parity-check matrix, based on the determined base matrix and the CBS. Various other methods may also be applied.

According to the above embodiment, the process of determining an LDPC exponent matrix or a sequence in operations 550 and 650 of FIGS. 5 and 6 has been described for the case in which the exponent matrix or the sequence is determined based on one of the TBS, the CBS, and the lifting size (Z). However, various other methods may also exist. Further, an additional operation may be included between operations 620 and 640 or between operations 630 and 640 of FIG. 6 depending on the system. For example, in a 3GPP 5G system, when base matrix 2 (*M*(**H_{*BG*2}**)) is used, a process of determining the value K_{b}, which indicates the number of columns to be substantially used in the base matrix or the number of column blocks to be used in the parity-check matrix according to the TBS, may be included. For reference, since the receiver may recognize that shortening has been applied at the transmitter to the bits corresponding to the column blocks of the parity-check matrix corresponding to the (10 - *K_{b}*) columns of the base matrix, the receiver may additionally perform an appropriate operation on the shortened bits before performing LDPC decoding.

In the embodiment of the LDPC encoding and decoding process based on the base matrix and the exponent matrix (or LDPC sequence) of the LDPC code shown in FIGS. 5 and 6, various code rates and various lengths of LDPC encoding and decoding may be supported by appropriately applying shortening or puncturing to some of the information word bits of the LDPC code and applying puncturing and repetition to some of the codeword bits. For example, as in the 3GPP 5G standard, shortening may be applied to some of the information word bits in the LDPC encoding process of FIG. 5, the information word bits corresponding to the first two columns of the base matrix, that is, the information word bits corresponding to the first 2*Z_{c}* columns of the parity-check matrix, may be punctured, and some of the parity bits may be punctured or some of the LDPC codeword bits may be repeated, thereby supporting various information bit lengths (or code block lengths) and various code rates.

When given input bits or code block bits are denoted by *i*₀*, i*₁*, i*₂, ..., *i*_{*K*-1}, and encoded bits are denoted by *d*₀*, d*₁*, d*₂, ..., *d*_{*N-*1} (where *N* = 66*Z_{c}* for base matrix 1 and *N* = 50*Z_{c}* for base matrix 2), a part of the encoding process may be defined as shown in Table 9 below.

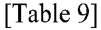

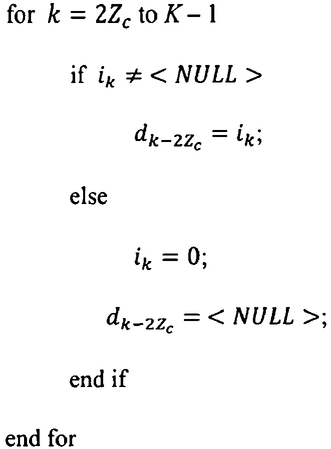

According to the above encoding process, the first 2*Zc* bits *i*₀*, i*₁*, i*_{2,}... , i_{2*Zc*-1} among the input bits or code block bits are not included in the encoded bits. That is, the 2*Z_{c}* bits are punctured at the transmitter and are not transmitted to the receiver. For reference, when some of the information word bits are punctured, it means that the transmitter does not transmit a part of the information word 102 of FIG. 1. Accordingly, at the receiver, the information word bits that have not been transmitted may be regarded as erased and decoded accordingly. In other words, since the punctured bits are regarded as erased and thus have equal probabilities of being 0 and 1, the receiver may insert corresponding values and perform decoding.

The information word bits punctured in the above encoding process may always remain untransmitted even in the case of retransmission. When a circular buffer is used for rate matching, if rate matching and retransmission are performed without storing the punctured information word bits in the circular buffer, the punctured information word bits may always remain untransmitted.

On the other hand, in the case of an initial transmission, some of the information word bits are punctured, whereas, in the case of retransmission, all or part of the punctured information word bits may be transmitted. All of the information word bits may be stored in the circular buffer, and, in the case of an initial transmission, a redundancy value (RV) may be appropriately configured such that some of the information word bits are punctured (e.g., by configuring RV0 to exclude the information word bits to be punctured). Even when some of the information word bits are punctured during the initial transmission, since the bit values are stored in the circular buffer, some or all of the punctured information word bits may be transmitted during retransmission according to the circular buffer rate matching operation and the selection of an appropriate RV value.

In Table 9, *d*₀*, d*₁*, d*₂*, ..., d*_{*N*-1} are referred to as encoded bits for convenience. However, the definition of the encoded bits may vary depending on the convenience of description. For example, the bit sequence after puncturing some of the information word bits, such as *d*₀*, d*₁*, d*₂, *..., d*_{*N-*1} in Table 9, may be defined as the encoded bits. However, since the input bits or code block bits *i*₀*, i*₁*, i*₂*, ..., i*_{*K-*1} are used to generate the parity bit vector ***w*** during the actual encoding process, the following bit sequence (***i***, ***w***) = (*i*₀*, i*₁*, i*₂, ..., *i*_{*Kldpc-*1}*, w*₀*, w*₁*, w*₂, *... , w*_{*Nldpc-Kldpc-*1}) before puncturing the information word bits may be defined as the encoded bits. Further, the bit sequence *e*₀*, e*₁*, e*₂, ..., *e*_{*E-*1}*,* to which rate matching based on the allocated amount of resources has been applied, may be defined as the encoded bits, or the bit sequence *f*₀, *f*₁*, f*₂, *..., f*_{*E*-1}, obtained by applying interleaving to the rate-matched bit sequence, may be defined as the encoded bits. In addition, the encoded bit sequence may be defined in various other ways depending on the convenience of description. However, in general, the bit sequence *d*₀*, d*₁*, d*₂, *..., d*_{*N-*1}*,* which is actually related to transmission in the system, or (***i***, ***w***), which is related to the encoding process, may be defined as the encoded bits.

In the LDPC decoding process of FIG. 6, decoding may be performed by adding appropriate operations for the shortened information word bits and the punctured bits or the repeated bits in accordance with the operation of the transmitter. In general, since the shortened information word bits are 0, the receiver may perform decoding by excluding the columns corresponding to the shortened bits from the parity-check matrix, or by configuring the shortened bits to predetermined values in the system and performing decoding. (Since the shortened bits are certainly 0, the shortened bits are generally configured with the highest value corresponding to 0 predetermined in the system.) Since the punctured parity bits are regarded as erasures and thus have equal probabilities of being 0 and 1, the receiver may perform decoding by inserting corresponding values. Alternatively, depending on the structure of the parity-check matrix, decoding may be performed without using at least some of the rows corresponding to the punctured parity bits. In general, when parity bits corresponding to columns having a degree of 1 are punctured, decoding may be performed without using part or all of the corresponding portion of the parity-check matrix in the LDPC decoder, thereby providing the advantage of reducing decoding complexity.

In addition, when supporting a variable-length information word or a variable code rate by using shortening, zero-padding, or the like of the LDPC code, the code performance may be improved depending on the shortening order or the shortening method. When a shortening order is configured, encoding performance may be improved by appropriately rearranging part or all of a given base matrix. Further, the performance may also be improved by appropriately determining the lifting size or the number of column blocks to which shortening is to be applied for a particular information word length (or code block length (CBS)). Similarly, there is a method of improving the performance of the LDPC code by controlling the puncturing order of the parity bits or the transmission order of the generated LDPC codeword. For example, compared with simply puncturing parity bits to support variable code rates, better performance may be achieved by appropriately puncturing some of the information word bits together with the parity bits. Further, when part of the LDPC codeword is repeated to support a lower code rate, the LDPC encoding performance may also be improved by appropriately determining the order of repetition in advance.

In general, in the LDPC encoding process, the transmitter first determines the size of input bits (or a code block) to which LDPC encoding is to be applied, then determines a lifting size (Z) to which the LDPC encoding is to be applied according to the determined size, determines an appropriate LDPC exponent matrix or sequence according to the lifting size, and then performs LDPC encoding based on the lifting size (Z) and the determined exponent matrix or LDPC sequence. In this case, the LDPC exponent matrix or sequence may be applied to LDPC encoding without transformation, or, in some cases, LDPC encoding may be performed by appropriately transforming the LDPC exponent matrix or sequence according to the lifting size (Z).

Similarly, in the LDPC decoding process, the receiver first determines the size of input bits (or a code block) corresponding to the transmitted LDPC codeword, then determines a lifting size (Z) to which LDPC decoding is to be applied according to the determined size, determines an appropriate LDPC exponent matrix or sequence according to the lifting size, and then performs LDPC decoding based on the lifting size (Z) and the determined exponent matrix or LDPC sequence. In this case, the LDPC exponent matrix or sequence may be applied to LDPC decoding without transformation, or, in some cases, LDPC decoding may be performed by appropriately transforming the LDPC exponent matrix or sequence according to the lifting size (Z).

In many cases, a submatrix corresponding to parity bits in a parity-check matrix has a special structure for efficient encoding. In this case, lifting may cause a change in the encoding method or the encoding complexity. Accordingly, in order to maintain the same encoding method or encoding complexity, lifting may not be applied to a part of the exponent matrix for the submatrix corresponding to the parity bits in the parity-check matrix, or a lifting scheme different from that applied to the exponent matrix for the submatrix corresponding to the information word bits may be applied. In other words, the lifting scheme applied to a sequence corresponding to the information word bits in the exponent matrix and the lifting scheme applied to a sequence corresponding to the parity bits may be configured differently. In some cases, lifting may not be applied to part or all of the sequence corresponding to the parity bits, such that fixed values are used without sequence transformation.

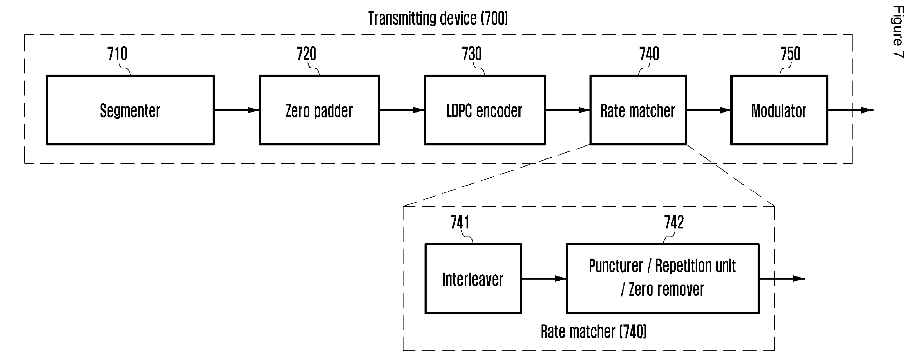

FIG. 7 is a block configuration diagram illustrating a transmitting device according to an embodiment of the disclosure.

Specifically, as shown in FIG. 7, a transmitting device 700 may include a segmenter 710, a zero-padder 720, an LDPC encoder 730, a rate matcher 740, and a modulator 750 to process variable-length input bits. The rate matcher 740 may include an interleaver 741 and a puncturer/repetition unit/zero-remover 742.

Here, the components illustrated in FIG. 7 are components for performing encoding and modulation on the variable-length input bits and are merely examples. Accordingly, some of the components illustrated in FIG. 7 may be omitted or modified depending on the implementation, and other components may be additionally included.

Meanwhile, the transmitting device 700 may determine required parameters (e.g., at least one of an input bit length, a modulation and code rate (ModCod), parameters for zero-padding (or shortening), a code rate/codeword length of an LDPC code, parameters for interleaving, parameters for repetition and puncturing, and a modulation scheme), and may encode the input bits, based on the determined parameters and transmit the encoded input bits to a receiving device 800.

Since the number of input bits is variable, when the number of input bits is greater than a predetermined value, the input bits may be segmented so as to have a length less than or equal to the predetermined value. Further, each segmented block may correspond to one LDPC-coded block. However, when the number of input bits is less than or equal to the predetermined value, the input bits are not segmented, and the input bits may correspond to one LDPC-coded block.

Meanwhile, the transmitting device 700 may store various parameters used for encoding, interleaving, and modulation. Here, the parameters used for encoding may include at least one of a code rate of an LDPC code, a codeword length, and information on a parity-check matrix. Further, the parameters used for interleaving may include information on an interleaving rule, and the parameters used for modulation may include information on a modulation scheme. In addition, the information on puncturing may include a puncturing length. Further, the information on repetition may include a repetition length. The information on the parity-check matrix may include exponent values of circulant matrices or values algebraically equivalent thereto when the parity-check matrix proposed in the disclosure is used.

In this case, each component of the transmitting device 700 may perform an operation using these parameters.

Meanwhile, although not shown, the transmitting device 700 may further include a controller (not shown) for controlling the operation of the transmitting device 700, depending on the case.

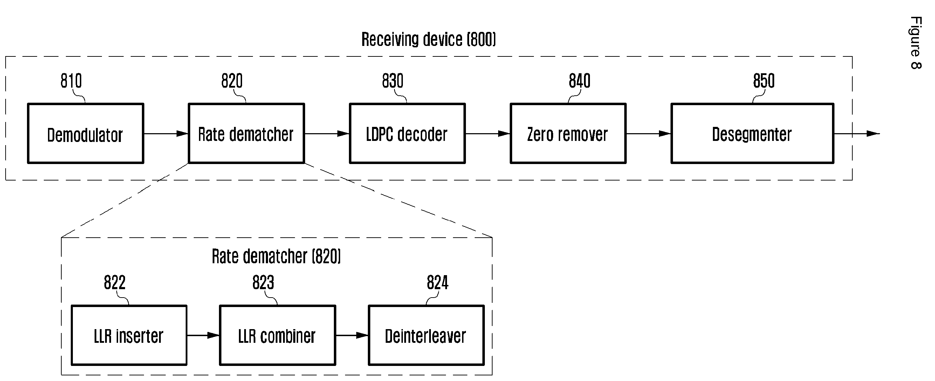

FIG. 8 is a block configuration diagram of a receiving device according to an embodiment of the disclosure.

Specifically, as shown in FIG. 8, a receiving device 800 may include a demodulator 810, a rate dematcher 820, an LDPC decoder 830, a zero-remover 840, and a desegmenter 850 to process variable-length information. The rate dematcher 820 may include a log-likelihood ratio (LLR) inserter 822, an LLR combiner 823, and a deinterleaver 824.

Here, the components illustrated in FIG. 8 perform functions corresponding to the respective components illustrated in FIG. 8, and are merely examples. Accordingly, some of the components may be omitted or modified depending on the implementation, and other components may be additionally included.

In the disclosure, the parity-check matrix may be read using a memory, may be provided in advance in the transmitting device or the receiving device, or may be directly generated by the transmitting device or the receiving device. Further, the transmitting device may store or generate a sequence corresponding to the parity-check matrix, an exponent matrix, or values algebraically equivalent thereto, and apply the same to encoding. Likewise, the receiving device may store or generate a sequence corresponding to the parity-check matrix, an exponent matrix, or values algebraically equivalent thereto, and apply the same to decoding.

Hereinafter, the operation of the receiver will be described in detail with reference to FIG. 8.

The demodulator 810 demodulates a signal received from the transmitting device 700.

Specifically, the demodulator 810 is a component corresponding to the modulator 750 of the transmitting device 700, and may demodulate the signal received from the transmitting device 700 to generate values corresponding to the bits transmitted by the transmitting device 700.

To this end, the receiving device 800 may determine parameters required for demodulation and decoding (e.g., at least one of an input bit length, a modulation and code rate (ModCod), parameters for zero-padding (or shortening), a code rate/codeword length of an LDPC code, parameters for interleaving, parameters for repetition and puncturing, and a modulation scheme), and, based on the determined parameters, the demodulator 810 may perform a decoding process of generating values corresponding to the LDPC codeword bits by demodulating the signal received from the transmitting device 700 according to a mode.

Meanwhile, the values corresponding to the bits transmitted by the transmitting device 700 may be likelihood ratio (LR) values or log-likelihood ratio (LLR) values.

Specifically, an LR value represents a ratio between a probability that a bit transmitted by the transmitting device 700 is 0 and a probability that the bit is 1, and an LLR value may be represented as a value obtained by taking the logarithm of the ratio between the probability that the bit transmitted by the transmitting device 700 is 0 and the probability that the bit is 1. Alternatively, the LR or LLR value may be hard-decided according to the probability, the ratio of the probabilities, or the logarithmic value of the ratio of the probabilities, and represented by the bit value itself, or may be represented by a representative value predefined according to an interval to which the probability, the ratio of the probabilities, or the logarithmic value of the ratio of the probabilities belongs. An example of a method for determining the representative value predefined according to the interval to which the probability, the ratio of the probabilities, or the logarithmic value of the ratio of the probabilities belongs includes a method that takes quantization into consideration. In addition, various other values corresponding to the probability, the ratio of the probabilities, or the logarithmic value of the ratio of the probabilities may also be used.

Although operations based on LLR values have been described in the disclosure for convenience of describing the operation of the receiving method and the receiving device, the disclosure is not limited thereto.

The demodulator 810 includes a function of performing multiplexing (not shown) on LLR values. Specifically, the multiplexer (not shown) is a component corresponding to a bit demultiplexer (not shown) of the transmitting device 700, and may perform an operation corresponding to that of the bit demultiplexer (not shown).

To this end, the receiving device 800 may store information on parameters used by the transmitting device 700 for demultiplexing and block interleaving. Accordingly, the multiplexer (not shown) may perform, on the LLR values corresponding to a cell word (information representing received symbols for an LDPC codeword as vector values), the reverse of the demultiplexing and block interleaving operations performed by the bit demultiplexer (not shown), thereby multiplexing the LLR values corresponding to the cell word in units of bits.

The rate dematcher 820 may insert additional LLR values into the LLR values output from the demodulator 810. In this case, the rate dematcher 820 may insert predetermined LLR values between the LLR values output from the demodulator 810.

Specifically, the rate dematcher 820 is a component corresponding to the rate matcher 740 of the transmitting device 700, and may perform operations corresponding to those of the interleaver 741 and the puncturer/repetition unit/zero-remover 742.

First, the rate dematcher 820 performs deinterleaving corresponding to the interleaver 741 of the transmitter. The LLR inserter 822 may insert, into the output of the deinterleaver 824, LLR values corresponding to zero bits at positions where zero bits were padded in the LDPC codeword. In this case, the LLR values corresponding to the padded zero bits, that is, the shortened zero bits, may be ∞ or -∞. However, ∞ or -∞ are theoretical values, and in practice may be the maximum or minimum LLR values used in the receiving device 800.

To this end, the receiving device 800 may store information on parameters used by the transmitting device 700 for padding zero bits. Accordingly, the rate dematcher 820 may determine positions at which zero bits were padded in the LDPC codeword, and may insert LLR values corresponding to the shortened zero bits at the determined positions.

Further, the LLR inserter 822 of the rate dematcher 820 may insert LLR values corresponding to punctured bits at positions of the punctured bits in the LDPC codeword. In this case, the LLR values corresponding to the punctured bits may be 0 or other predetermined values. In general, when parity bits having a degree of 1 are punctured, they may not be used in the LDPC decoding process without LLR insertion at some or all of the corresponding punctured positions because they have no effect on improving decoding performance during the LDPC decoding process. However, in order to improve the efficiency of the LDPC decoding process based on parallel processing, the LLR inserter 822 may insert predetermined LLR values at positions corresponding to some or all of the punctured bits having a degree of 1 regardless of whether decoding performance is improved.

To this end, the receiving device 800 may store information on parameters used by the transmitting device 700 for puncturing. Accordingly, the LLR inserter 822 may insert LLR values (e.g., LLR = 0) corresponding thereto at positions where LDPC information word bits or parity bits were punctured. However, this process may be omitted at positions of some punctured parity bits.

The LLR combiner 823 may combine, that is, add the LLR values output from the LLR inserter 822 and the demodulator 810. Specifically, the LLR combiner 823 is a component corresponding to the puncturer/repetition unit/zero-remover 742 of the transmitting device 700, and may perform an operation corresponding to that of the repetition unit. First, the LLR combiner 823 may combine the LLR values corresponding to repeated bits with other LLR values. Here, the other LLR values may be LLR values for the bits on which the repeated bits generated by the transmitting device 700 are based, that is, LLR values for LDPC information word bits or parity bits selected as targets for repetition.

That is, as described above, the transmitting device 700 selects LDPC encoded bits, repeats the selected LDPC encoded bits among LDPC information word bits and LDPC parity bits, and transmits them to the receiving device 800. Accordingly, the LLR values for the LDPC encoded bits may include LLR values for repeated LDPC encoded bits and LLR values for non-repeated LDPC encoded bits. The LLR combiner 823 may combine the LLR values corresponding to the same LDPC encoded bits.

To this end, the receiving device 800 may store information on parameters used by the transmitting device 700 for repetition. Accordingly, the LLR combiner 823 may determine the LLR values for the repeated LDPC encoded bits and combine the determined LLR values with the LLR values for the LDPC encoded bits on which the repetition is based.

Further, the LLR combiner 823 may combine LLR values corresponding to retransmitted bits or incremental redundancy (IR) bits with other LLR values. Here, the other LLR values may be LLR values for some or all of the LDPC codeword bits used to generate retransmitted bits or IR bits in the transmitting device 700.

As described above, when a NACK occurs for HARQ, the transmitting device 700 may transmit some or all of the codeword bits to the receiving device 800.

Accordingly, the LLR combiner 823 may combine the LLR values for the bits received through retransmission or IR with the LLR values for the LDPC codeword bits received through a previous frame.

To this end, the receiving device 800 may store information on parameters used by the transmitting device 700 to generate retransmitted bits or IR bits. Accordingly, the LLR combiner 823 may determine the LLR values corresponding to the retransmitted bits or IR bits and combine the determined LLR values with the LLR values for the LDPC encoded bits used to generate the retransmitted bits.

The deinterleaver 824 may deinterleave the LLR values output from the LLR combiner 823.

Specifically, the deinterleaver 824 is a component corresponding to the interleaver 741 of the transmitting device 700, and may perform an operation corresponding to that of the interleaver 741.

To this end, the receiving device 800 may store information on parameters used by the transmitting device 700 for interleaving. Accordingly, the deinterleaver 824 may perform, in reverse, the interleaving operation performed by the interleaver 741 on the LLR values corresponding to the transmitted LDPC encoded bits, thereby deinterleaving the LLR values corresponding to the transmitted LDPC encoded bits.

The LDPC decoder 830 may perform LDPC decoding, based on the LLR values output from the rate dematcher 820.

Specifically, the LDPC decoder 830 is a component corresponding to the LDPC encoder 730 of the transmitting device 700, and may perform an operation corresponding to that of the LDPC encoder 730.

To this end, the receiving device 800 may have previously stored information on parameters used by the transmitting device 700 for performing LDPC encoding according to a mode. Accordingly, the LDPC decoder 830 may perform LDPC decoding, based on the LLR values output from the rate dematcher 820 according to the mode.

For example, the LDPC decoder 830 may perform LDPC decoding, based on the LLR values output from the rate dematcher 820 based on an iterative decoding scheme using a sum-product algorithm, and may output bits having errors corrected through the LDPC decoding. The LDPC decoder 830 performs LDPC decoding on an LDPC codeword, based on a parity-check matrix or an exponent matrix or sequence corresponding thereto. Further, the LDPC decoder 830 may perform LDPC decoding by using parity-check matrices differently defined according to a code rate (i.e., a code rate of an LDPC code). The LDPC decoder 830 may perform LDPC decoding by passing LLR values corresponding to LDPC codeword bits through an iterative decoding algorithm to generate information word bits. Here, the LLR values are channel values corresponding to the LDPC codeword bits, and may be represented in various ways.

The zero-remover 840 may remove zero bits from the bits output from the LDPC decoder 830.

Specifically, the zero-remover 840 is a component corresponding to the zero-padder 720 of the transmitting device 700, and may perform an operation corresponding to that of the zero-padder 720.

To this end, the receiving device 800 may have previously stored information on parameters used by the transmitting device 700 for padding zero bits. Accordingly, the zero-remover 840 may remove the zero bits padded by the zero-padder 720 from the bits output from the LDPC decoder 830.

The desegmenter 850 is a component corresponding to the segmenter 710 of the transmitting device 700, and may perform an operation corresponding to that of the segmenter 710.

To this end, the receiving device 800 may have previously stored information on parameters used by the transmitting device 700 for segmentation. Accordingly, the desegmenter 850 may combine the bits output from the zero-remover 840, that is, the segments for the variable-length input bits, to recover the bits before segmentation.

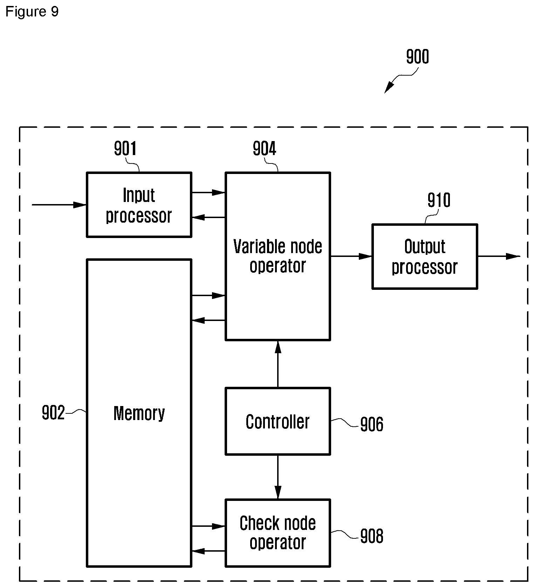

FIG. 9 illustrates a structure of an LDPC decoder according to an embodiment of the disclosure.

As described above, the LDPC decoder 830 may perform LDPC decoding using an iterative decoding algorithm. In this case, the LDPC decoder 830 may have a structure as shown in FIG. 9. However, the detailed configuration illustrated in FIG. 9 is also merely an example.

Referring to FIG. 9, the decoding device 900 includes an input processor 901, a memory 902, a variable node operator 904, a controller 906, a check node operator 908, and an output processor 910.

The input processor 901 stores input values. Specifically, the input processor 901 may store LLR values of a received signal received through a channel.

The controller 906 determines the number of values input to the variable node operator 904 and address values in the memory 902, the number of values input to the check node operator 908 and address values in the memory 902, and the like, based on a block size (i.e., a codeword length) of a received signal received through the channel and a parity-check matrix corresponding to a code rate.

The memory 902 stores input data and output data for the variable node operator 904 and the check node operator 908.

The variable node operator 904 receives data from the memory 902 according to address information of input data received from the controller 906 and information on the number of the input data, and performs a variable node operation. Thereafter, the variable node operator 904 stores results of the variable node operation in the memory 902, based on address information of output data received from the controller 906 and information on the number of the output data. Further, the variable node operator 904 inputs a result of the variable node operation to the output processor 910, based on data received from the input processor 901 and the memory 902. Here, the variable node operation has been described above with reference to FIG. 6.

The check node operator 908 receives data from the memory 902, based on address information of input data received from the controller 906 and information on the number of the input data, and performs a check node operation. Thereafter, the check node operator 908 stores results of the check node operation in the memory 902, based on address information of output data received from the controller 906 and information on the number of the output data. Here, the check node operation has been described above with reference to FIG. 6.

The output processor 910 performs hard decision on whether the information word bits of a codeword at the transmitting side are 0 or 1, based on data received from the variable node operator 904, and then outputs a result of the hard decision. The output value of the output processor 910 is the finally decoded value. In this case, the hard decision may be performed based on a value obtained by summing all message values input to one variable node in FIG. 6 (i.e., an initial message value and all message values input from check nodes).

Meanwhile, the memory 902 of the decoding device 900 may store information on a code rate of an LDPC code, a codeword length, and a parity-check matrix, and the LDPC decoder 830 may perform LDPC decoding using the information. However, this is merely an example, and the information may alternatively be provided from the transmitting side.

For reference, although the disclosure has been described with a focus on LDPC codes as a forward error correction (FEC) scheme of a communication system, FEC encoding and decoding in a communication system may generally be subdivided into a concatenated code including, for example, an outer code and an inner code. Depending on definitions of the outer code and the inner code, a transmitter performs inner encoding after outer encoding, and a receiver performs outer decoding after inner decoding.

For an outer code, algebraic codes capable of relatively simple error detection or error correction, such as a cyclic redundancy check (CRC) code, a Bose-Chaudhuri-Hocquenghem (BCH) code, and Reed-Solomon (RS) coding, are widely used. However, the disclosure is not necessarily limited thereto, and multiple codes may also be applied redundantly.

For an inner code, coding schemes having excellent error-correction capability, although relatively complex, such as an LDPC code, a Turbo code, and a Polar code, are widely used. However, the disclosure is not necessarily limited thereto. (For example, a tail-biting convolutional code or another algebraic code may also be used, and multiple codes may also be applied redundantly.) For reference, in a 3GPP 5G system, a CRC code is used as the outer code, an LDPC code is used as the inner code for a data channel, and a Polar code is used as the inner code for a control channel.

Various broadcasting systems and communication systems use LDPC codes optimized for their respective systems. Although the disclosure describes, by way of example, a system using an LDPC code defined based on a parity-check matrix having the same structure as that of the LDPC code used in the 3GPP 5G system, the disclosure is not necessarily limited thereto. In addition, in communication systems including 5G or 6G systems, rate matching may be applied at a transmitter and rate dematching may be applied at a receiver in order to support various code rates and various code lengths. However, in a system that performs encoding/decoding based on a fixed LDPC code, such as some broadcasting systems, not only rate matching or rate dematching but also all or part of other operations may be omitted.

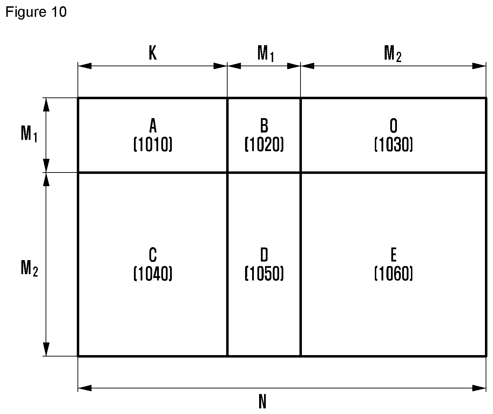

FIG. 10 illustrates a general structure of a parity-check matrix of an LDPC code, which is an inner code applied to an FEC encoder (not shown) and an FEC decoder (not shown) described in the disclosure.

The parity-check matrix illustrated in FIG. 10 has N columns and (M₁ + M₂) rows (where M₁, M₂ ≥ 0 and M₁ + M₂ > 0). In general, when the parity-check matrix has full rank, the number of columns corresponding to information word bits in the parity-check matrix is equal to the total number of columns minus the total number of rows. That is, when the parity-check matrix of FIG. 10 has full rank (M₁ + M₂), it means that the number K of information word bits is N - (M₁ + M₂). In the disclosure, for convenience of description, only the case where the parity-check matrix of FIG. 10 has full rank will be described, but the disclosure is not necessarily limited thereto.

First, the parity-check matrix of FIG. 10 may be divided into a first part of the parity-check matrix composed of submatrices A 1010 and B 1020, and a second part of the parity-check matrix composed of submatrices C 1040, D 1050, and E 1060 (provided that, when one of M₁ and M₂ is 0, the parity-check matrix may not be divided into the first part and the second part). The submatrix O 1030 denotes a zero matrix having a size of (M₁ × M₂). Since the submatrix O 1030 is a zero matrix having a size of (M₁ × M₂), it has no effect on matrix operations even when it is included in the first part of the parity-check matrix. For this reason, in the disclosure, for convenience of description, the first part of the parity-check matrix is defined as a matrix composed of the submatrices A 1010 and B 1020, excluding a zero matrix having a size of (M₁ × M2). However, if necessary, the first part of the parity-check matrix may include a zero matrix having a size of (M₁ × M₂).

When the parity-check matrix of FIG. 10 is defined as a QC-LDPC code having a lifting size or block size Z, the parity-check matrix of FIG. 10 may correspond to a base matrix or a weight matrix having a size of *m_{b}* × *n_{b}*, where *k_{b} = K*/*Z, n_{b}* = *N*/*Z,* and ${m}_{b} = \left({M}_{1}+{M}_{2}\right) / Z = {m}_{b 1} + {m}_{b 2} \left({m}_{b 1}=\frac{{M}_{1}}{Z},{m}_{b 2}={M}_{2}/Z\right)$ . Likewise, the first part of the parity-check matrix composed of the submatrices A 1010 and B 1020 corresponds to a submatrix of a base matrix or a weight matrix having a size of $\left(\frac{{M}_{1}}{Z}\right) \times \left(\frac{K + {M}_{1}}{Z}\right)$ or *m*_{*b*1} × (*k_{b}* + *m*_{*b*1}), and the second part of the parity-check matrix composed of the submatrices C 1040, D 1050, and E 1060 corresponds to a submatrix of a base matrix or a weight matrix having a size of $\left(\frac{{M}_{2}}{Z}\right) \times \left(\frac{K + {M}_{1} + {M}_{2}}{Z}\right)$ or *m*_{*b*2} × (*k_{b}* + *m*_{*b*1} + *m*_{*b*2}) = *m*_{*b*2} × *n_{b}*.

Assuming, for convenience of description, that the parity-check matrix of FIG. 10 is *H*, information word bits (or information word bit vector) corresponding to the submatrix A 1010 or C 1040 are referred to as ***i*** = (*i*₀, *i*₁, *i*₂, ... , *i*_{*K*-1}), the first parity bits (or first parity bit vector) corresponding to the submatrix B 1020 or D 1050 are ***w***₁ = (*w*_{1,0}*, w*_{1,1}*, w*_{1,2}, ... , *w*_{1,*M*1-1}), and the second parity bits (or second parity bit vector) corresponding to the submatrix E 1060 are ***w*₂** = (*w*_{2,0}, *w*_{2,1}, *w*_{2,2}, ... , *w*_{2,*M*2-1}), the following relational expression of Equation 13 may be obtained from Equation 1. [Equation 13] $\begin{matrix}H ⋅ {c}^{T} = H ⋅ \left[\begin{matrix}{{i}_{¯}}^{T} \\ {{w}_{¯}}_{1}^{T} \\ {{w}_{¯}}_{2}^{T}\end{matrix}\right] = \left[\begin{matrix}A & B & O \\ C & D & E\end{matrix}\right] ⋅ \left[\begin{matrix}{{i}_{¯}}^{T} \\ {{w}_{¯}}_{1}^{T} \\ {{w}_{¯}}_{2}^{T}\end{matrix}\right] \\ = \left\{\begin{matrix}A ⋅ {{i}_{¯}}^{T} + B ⋅ {{w}_{¯}}_{1}^{T} = 0 \\ C ⋅ {{i}_{¯}}^{T} + D ⋅ {{w}_{¯}}_{1}^{T} + E ⋅ {{w}_{¯}}_{2}^{T} = 0\end{matrix}\right.\end{matrix}$

Referring to Equation 13, the first parity vector ***w*₁** may be obtained (or calculated or determined) based on the information word bit vector ***i*** and the first part of the parity-check matrix. Further, after the parity vector ***w*₁** is obtained, the parity vector ***w*₂** may be obtained (or calculated or determined) based on the information word bit vector ***i***, the parity vector ***w*₁**, and the second part of the parity-check matrix.

In the disclosure, for convenience of description, the first part of the parity-check matrix composed of A 1010 and B 1020, which is required to generate the first parity vector ***w*₁** based on the information word bit vector ***i***, may be referred to as a core part or core matrix, a kernel part or kernel matrix, or a precoding part or precoding matrix. Further, the second part of the parity-check matrix composed of C 1040, D 1050, and E 1060, which is required to generate the second parity vector ***w*₂** based on the information word bit vector ***i*** and/or the first parity vector ***w*₁**, may be referred to as an extension part or a single parity-check extension part.

As a specific example, the core matrix portions of base matrix *M*(**H_{*BG*1}**) and base matrix 2 *M*(**H_{*BG*2}**) defined in the above-described 3GPP 5G standard are respectively shown below.
Core matrix of *M*(**H_{*BG*1}**):
   0 1 2 3 5 6 9 10 11 12 13 15 16 18 19 20 21 22 23
   0 2 3 4 5 7 8 9 11 12 14 15 16 17 19 21 22 23 24
   0 1 2 4 5 6 7 8 9 10 13 14 15 17 18 19 20 24 25
   0 1 3 4 6 7 8 10 11 12 13 14 16 17 18 20 21 22 25
Core matrix of *M*(**H_{*BG*2}**):
   0 1 2 3 6 9 10 11
   0 3 4 5 6 7 8 9 11 12
   0 1 3 4 8 10 12 13
   1 2 4 5 6 7 8 9 10 13

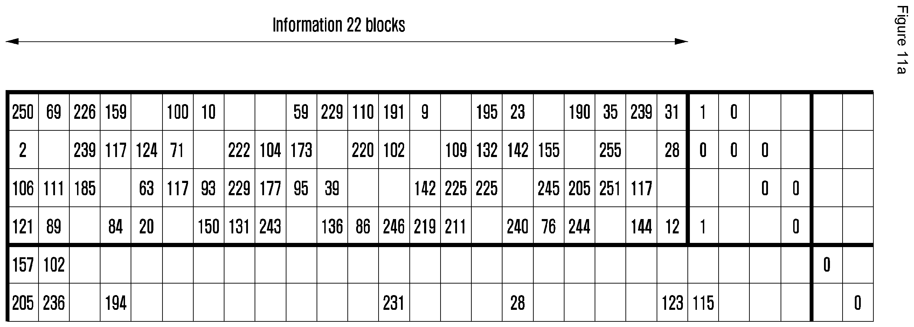

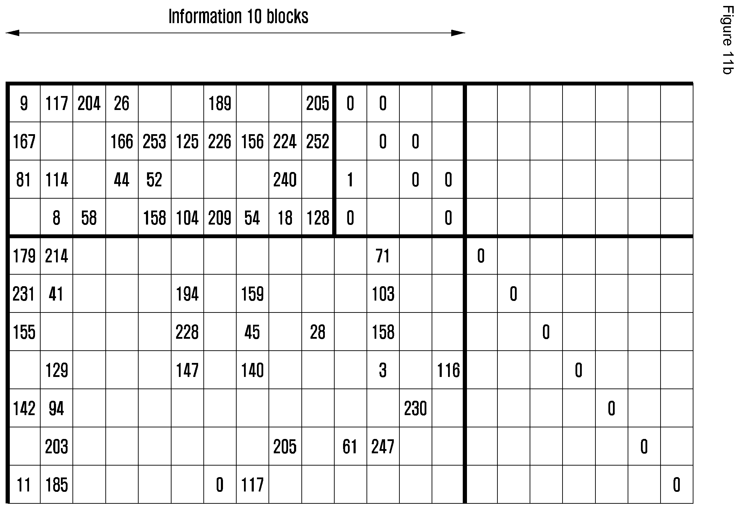

The core matrix of *M*(**H_{*BG*1}**) has a size of 4 × 26, and the core matrix of *M*(**H_{*BG*2}**) has a size of 4 × 14. Further, in terms of the parity-check matrix, the core matrices have sizes of 4Z×26Z and 4Z×14Z, respectively. As a specific example, FIGS. 11A and 11B illustrate portions of exponent matrices of LDPC codes defined in 3GPP 5G specification TS 38.212 for the case where the lifting size set index ***i_{LS}***= 0. In FIGS. 11A and 11B, the portions corresponding to the core matrices of the base matrices or the parity-check matrices are as follows.
Core matrix of *V*(**H₁**) for *i_{LS}* = 0:
   250 69 226 159 100 10 59 229 110 191 9 195 23 190 35 239 31 1 0
   2 239 117 124 71 222 104 173 220 102 109 132 142 155 255 28 0 0 0
   106 111 185 63 117 93 229 177 95 39 142 225 225 245 205 251 117 0 0
   121 89 84 20 150 131 243 136 86 246 219 211 240 76 244 144 12 1 0
Core matrix of *V*(**H₂**) for *i_{LS}* = 0:
   9 117 204 26 189 205 0 0
   167 166 253 125 226 156 224 252 0 0
   81 114 44 52 240 1 0 0
   8 58 158 104 209 54 18 128 0 0

Meanwhile, in the disclosure, a parity-check matrix corresponding to FIG. 10 satisfying the following conditions may be considered.

Hereinafter, the submatrix A 1010 and the submatrix B 1020 may be referred to as a first submatrix and a second submatrix, respectively. Further, hereinafter, a circulant permutation matrix may refer to a circulant permutation matrix having a size of *Z* × Z, which is determined based on a lifting size Z, and may be configured, for example, as shown in Equation 5 or Equation 6. In addition, in the disclosure, a circulant matrix may refer to a matrix in which circulant permutation matrices are superimposed.

**Condition 1(a):** In the parity-check matrix for the QC-LDPC code of FIG. 10, when the submatrix B 1020 does not include a circulant matrix in which circulant permutation matrices each having a size of *Z* × *Z* are superimposed, the weights of all column blocks of the submatrix B 1020 are 2 or greater, and at least one column block having a weight that is an odd number of 3 or greater may be included in the submatrix B 1020. Further, the weights of all columns of a base matrix *M*(**B**) corresponding to the submatrix B 1020 are 2 or greater, and the base matrix *M*(**B**) may include at least one column having a weight that is an odd number of 3 or greater.

**Condition 1(b):** In the parity-check matrix for the QC-LDPC code of FIG. 10, when the submatrix B 1020 includes at least one circulant matrix in which circulant permutation matrices each having a size of *Z* × *Z* are superimposed, the weights of all column blocks of the submatrix B 1020 are 2 or greater, and at least one column block having a weight that is an odd number of 3 or greater is included in the submatrix B (1020). Further, in a weight matrix *W*(**B**) corresponding to the submatrix B 1020, the sum of the entries of each column are 2 or greater, and the weight matrix *W*(**B**) includes at least one column whose sum of entries is an odd number of 3 or greater (The weight of a column block including the circulant matrix in which circulant permutation matrices each having a size of *Z* × *Z* are superimposed may be 2 or may be 3 or greater.)

**Condition 2:** The weight of each column and the weight of each row of a submatrix E 1060 of FIG. 10 are 1. Further, the weight of each column and the weight of each row of a submatrix of the base matrix and the weight matrix corresponding to the submatrix E 1060 are all 1. Accordingly, the submatrix E 1060 and the submatrix of the base matrix and the weight matrix corresponding to the submatrix E 1060 are an identity matrix or a matrix that is transformed into an identity matrix by applying an appropriate column permutation, row permutation, or the like. (That is, the submatrix E 1060 is an identity matrix or a matrix having algebraic characteristics equivalent thereto.) When the parity-check matrix of FIG. 10 is defined as a quasi-cyclic parity-check matrix, the submatrix E may be divided into a plurality of identity matrices each having a size of *Z* × *Z.*

FIGS. 11A and 11B illustrate examples of parity-check matrices satisfying at least one of Condition 1(a), Condition 1(b), and Condition 2. As briefly described above, FIG. 11A illustrates an example in which K = 22*Z, M₁ = 4*Z, and M₂ = 2*Z in FIG. 10, and FIG. 11B illustrates an example in which K = 10*Z, M₁ = 4*Z, and M2 = 7*Z in FIG. 10. Since the code rate of an LDPC code corresponding to the parity-check matrices of FIG. 10, FIG. 11A, and FIG. 11B is K/N, it should be noted that a lower-code-rate codeword may be generated as M₂ decreases. In other words, according to the disclosure, LDPC encoding and decoding may be performed based on a parity-check matrix that includes those of FIGS. 11A and 11B and is capable of supporting a lower code rate by further extending columns having a degree of 1.

When a lifting size set is used for LDPC encoding or decoding with respect to a parity-check matrix of a quasi-cyclic LDPC code, the number of columns constituting one column block of the parity-check matrix is greater than or equal to the minimum lifting size. For example, when the values in Table 6 are used as lifting sizes, the number of columns constituting one column block of the parity-check matrix may be at least 4. Accordingly, in a communication system in which the lifting sizes of Table 6 are substantially applied to a parity-check matrix of an LDPC code having the structure of FIG. 10, FIG. 11A, or FIG. 11B satisfying at least one of Condition 1(a), Condition 1(b), and Condition 2, the number of columns having a degree of 3 in the submatrix B 1020 is at least 4.

For reference, the core matrix in the parity-check matrix, the base matrix, or the weight matrix may be defined, as follows, by further adding one or two rows so as to satisfy at least one of Condition 1(a), Condition 1(b), and Condition 2.
Core matrix of *M*(**H_{BG1}**):
   0 1 2 3 5 6 9 10 11 12 13 15 16 18 19 20 21 22 23
   0 2 3 4 5 7 8 9 11 12 14 15 16 17 19 21 22 23 24
   0 1 2 4 5 6 7 8 9 10 13 14 15 17 18 19 20 24 25
   0 1 3 4 6 7 8 10 11 12 13 14 16 17 18 20 21 22 25
   0 1 26
Core matrix of *M*(**H_{BG2}**):
   0 1 2 3 6 9 10 11
   0 3 4 5 6 7 8 9 11 12
   0 1 3 4 8 10 12 13
   1 2 4 5 6 7 8 9 10 13
   0 1 11 14

However, in the disclosure, for convenience of description, a parity-check matrix [A 1010 B 1020] including the submatrix B satisfying only Condition 1(a) or Condition 1(b) is regarded as a core matrix (or kernel matrix or precoding matrix). That is, in the disclosure, the first part of the base matrix, the first part of the parity-check matrix, the core matrix/part, the kernel matrix/part, and the like refer to a submatrix excluding columns corresponding to parity bits having a degree of 1 and rows directly related to the parity bits having a degree of 1.

As an embodiment of the disclosure, a method of improving the performance of an LDPC code and a method of improving the decoding convergence speed according to a weight matrix will now be described.

First, the core matrix of base matrix 2 *M*(**H_{BG2}**) defined in [Base Matrix Determination Method] consists of four rows, and may also be represented by a weight matrix as shown in Equation 14. Since the LDPC code defined by base matrix 1 *M*(**H_{BG1}**)or base matrix 2 *M*(**H_{BG2}**) is defined such that one circulant permutation matrix corresponds to one block having a size of *Z* × *Z*, the base matrix and the weight matrix are basically identical. [Equation 14] $W \left({H}_{BG 2}\right) = \left[\begin{matrix}1 & 1 & 1 & 1 & 0 & 0 & 1 & 0 & 0 & 1 & 1 & 1 & 0 & 0 \\ 1 & 0 & 0 & 1 & 1 & 1 & 1 & 1 & 1 & 1 & 0 & 1 & 1 & 0 \\ 1 & 1 & 0 & 1 & 1 & 0 & 0 & 0 & 1 & 0 & 1 & 0 & 1 & 1 \\ 0 & 1 & 1 & 0 & 1 & 1 & 1 & 1 & 1 & 1 & 1 & 0 & 0 & 1\end{matrix}\right]$

As described above, an LDPC code designed such that at most one circulant permutation matrix corresponds to one block having a size of *Z* × *Z* has a structure suitable for performing layered decoding in units of one row block during decoding. That is, the structure of the LDPC code is suitable for performing decoding through a Z-unit parallel-processing processor. Layered decoding refers to an operation of sequentially performing decoding on a layer-by-layer basis. Accordingly, decoding may be sequentially performed in units of one row block, or a plurality of row blocks may constitute one layer such that decoding is performed on a layer-by-layer basis. Meanwhile, although layered decoding has been defined in the disclosure as an operation of sequentially performing decoding on a layer-by-layer basis, sequentially performing decoding means that decoding is performed on a layer-by-layer basis, and does not mean that decoding should be performed in the index order of the layers. Further, in the disclosure, sequentially performing decoding may mean sequentially performing decoding according to a layered decoding order or pattern (or sequence). Further, depending on the structure of one parity-check matrix, some layers may each consist of one row block, whereas other layers may each consist of a plurality of row blocks.

Since such a layered decoding scheme generally performs parallel processing using, as a basic unit, a layer composed of one row block or a plurality of row blocks, one iteration of decoding may be determined to be completed when decoding has been performed as many times as the total number of row blocks. This means that, if sufficient parallel-processing processors are available, the decoding throughput through layered decoding is inversely proportional to the number of row blocks. However, when the same code length is supported using a parity-check matrix having a smaller number of row blocks, this means that the lifting size Z increases accordingly. Therefore, the number of parallel-processing processors required to simultaneously perform decoding for one row block increases.

For example, the weight matrix *W*(**H_{BG2}**) consists of four rows and 14 columns, and the weights of the respective columns are 3, 3, 2, 3, 3, 2, 3, 2, 3, 3, 3, 2, 2, and 2. Likewise, a weight matrix $W \left({H}_{BG 2}^{′}\right)$ consisting of three rows and 13 columns and having a weight distribution similar to that of *W*(**H_{BG2}**), and a weight matrix $W \left({H}_{BG 2}^{"}\right)$ consisting of two rows and 12 columns and having a weight distribution similar to that of *W*(**H_{BG2}**), may be configured as follows. $W \left({H}_{BG 2}^{′}\right) = \left[\begin{matrix}1 & 1 & 1 & 1 & 1 & 1 & 1 & 0 & 1 & 1 & 1 & 1 & 0 \\ 1 & 1 & 0 & 1 & 1 & 1 & 1 & 1 & 1 & 1 & 1 & 1 & 1 \\ 1 & 1 & 1 & 1 & 1 & 0 & 1 & 1 & 1 & 1 & 1 & 0 & 1\end{matrix}\right] ,$ $W \left({H}_{BG 2}^{"}\right) = \left[\begin{matrix}2 & 1 & 1 & 2 & 1 & 1 & 2 & 1 & 1 & 2 & 1 & 1 \\ 1 & 2 & 1 & 1 & 2 & 1 & 1 & 1 & 2 & 1 & 2 & 1\end{matrix}\right] .$

If LDPC codes having the same code length may be generated using the respective weight matrices *W*(**H_{BG2}**), $W \left({H}_{BG 2}^{′}\right)$,and $W \left({H}_{BG 2}^{"}\right)$, and the lifting sizes corresponding to the respective parity-check matrices are *Z*₁, *Z*₂, and *Z*₃, respectively, then the following relationships hold: ${Z}_{3} = \frac{14}{12} {Z}_{1}$ and ${Z}_{2} = \frac{13}{12} {Z}_{1}$*.* In addition, if *Zᵢ* parallel-processing processors are allowed in the LDPC decoder, the approximate decoding information throughput of *W*(**H'_{BG2}**) may be 1.5 times that of *W*(**H_{BG2}**), and that of *W*(**H"_{BG2}**) may be 2 times that of *W*(**H_{BG2}**).

As described above, when a sufficient number of parallel processors is available, reducing the number of row blocks makes it possible to increase the decoding throughput in inverse proportion thereto. Therefore, in a system requiring a very high decoding throughput, if a greater number of parallel processors can be employed, it is advantageous to keep the number of rows of the base matrix or the weight matrix, that is, the number of row blocks of the parity-check matrix, small.

Although keeping the number of rows of the base matrix or the weight matrix, that is, the number of row blocks of the parity-check matrix, small may be advantageous from the viewpoint of decoding throughput, if the number of row blocks is configured too small, serious constraints may be imposed on algebraic characteristics of the LDPC code, such as cycle characteristics or minimum-distance characteristics, thereby causing performance degradation. Accordingly, the base matrix or the weight matrix should be determined by taking into consideration both the target throughput and the target error-correction capability of the system.

As an embodiment of the disclosure, a method for improving code performance while achieving high decoding throughput is proposed. In particular, the disclosure proposes algebraic characteristics that should be satisfied by the core matrix portion of the base matrix or the weight matrix, which is closely related to the maximum decoding throughput or the peak data rate of the system. Of course, when the parity-check matrix does not include the second part of the parity-check matrix composed of submatrices C 1040, D 1050, and E 1060 of FIG. 10, the core matrix may be identical to the base matrix or the weight matrix.

One of the conditions to be satisfied by the core matrix of the parity-check matrix is that, when two columns each having only one non-zero entry are selected from the weight matrix corresponding to the core matrix, the non-zero entries should not be included in a single row, as shown in $\left[\begin{matrix}0 & 0 \\ ⋮ & ⋮ \\ {w}_{1} & {w}_{2} \\ ⋮ & ⋮ \\ 0 & 0\end{matrix}\right] \left({w}_{1},{w}_{2}\geq 1\right)$. As simple examples, $\left[\begin{matrix}{w}_{1} & {w}_{2} \\ 0 & 0\end{matrix}\right] , \left[\begin{matrix}0 & 0 \\ {w}_{1} & {w}_{2}\end{matrix}\right] , \left[\begin{matrix}{w}_{1} & {w}_{2} \\ 0 & 0 \\ 0 & 0\end{matrix}\right] , \left[\begin{matrix}0 & 0 \\ {w}_{1} & {w}_{2} \\ 0 & 0\end{matrix}\right]$, ... and the like correspond to such a case. Since the minimum distance of a parity-check matrix corresponding to a weight matrix or a core matrix including such a structure is less than or equal to *w*₁ + *w*₂, an error-floor phenomenon is likely to occur. Accordingly, as shown in $\left[\begin{matrix}{w}_{1} & 0 \\ 0 & {w}_{2}\end{matrix}\right] , \left[\begin{matrix}{w}_{1} & 0 \\ 0 & {w}_{2} \\ 0 & 0\end{matrix}\right] , \left[\begin{matrix}{w}_{1} & 0 \\ 0 & 0 \\ 0 & {w}_{2}\end{matrix}\right]$, ..., the non-zero entries in any two columns each having only one non-zero entry should be located in different rows. This also means that, in the base matrix, non-zero entries located in columns having a weight of 1 are all located in different rows. The above description may be defined as the following Conditions 3(a) and 3(b).

**Condition 3(a)**: All columns of the base matrix or the weight matrix corresponding to the core matrix have a weight of 2 or greater, or the number of columns having a weight of 1 is at most one.

**Condition 3(b):** When the number of columns having a weight of 1 among the columns of the base matrix or the weight matrix corresponding to the core matrix is two or greater, the non-zero entries included in the columns having a weight of 1 are located in different rows.

Conditions 3(a) and 3(b) mean that the number of column blocks composed of only one circulant permutation matrix or circulant matrix included in the core matrix is at most one, or, when two or more column blocks each composed of only one circulant permutation matrix or circulant matrix are included in the core matrix, the circulant permutation matrices or circulant matrices having a size of *Z* × *Z* are included in different row blocks. Further, Conditions 3(a) and 3(b) define a structure for preventing a severe error-floor phenomenon. If better error-floor characteristics are desired, the following Condition 4 may further be added. As described above, each of the circulant permutation matrix and the circulant matrix may have a size of *Z* × *Z*.

**Condition 4:** In the parity-check matrix corresponding to the core matrix, the weights of columns corresponding to information bits (or input bits or code blocks) are 3 or greater.

Condition 4 may be applied when it is desired to improve the error-floor phenomenon, although the coding gain may be reduced, by preventing the case where the weights of columns corresponding to information bits are 2, as in the parity-check matrix corresponding to base matrix 2 *M*(**H_{BG2}**) of Equation 14.

Condition 4 means that, when the submatrix A 1010 does not include a circulant matrix in which circulant permutation matrices each having a size of *Z* × *Z* are superimposed in the parity-check matrix for the QC-LDPC code, the weights of all column blocks of the submatrix A 1010 are 3 or greater, and the weights of all columns of the base matrix *M*(**A**) corresponding to the submatrix A 1010 are 3 or greater. Further, Condition 4 means that, when the submatrix A 1010 includes at least one circulant matrix in which circulant permutation matrices each having a size of *Z* × *Z* are superimposed in the parity-check matrix for the QC-LDPC code, the weights of all column blocks of the submatrix A 1010 are 3 or greater, and the sums of entries of all columns of the weight matrix W(A) corresponding to the submatrix A 1010 are 3 or greater.

As another condition to be satisfied by the core matrix of the parity-check matrix, a condition may be considered in which the weight matrix corresponding to the core matrix does not include any entry having a value of 3 or greater. In general, when the core matrix of the weight matrix includes an integer entry of 3 or greater, this means that three or more circulant permutation matrices correspond to the corresponding position. When three or more circulant permutation matrices constituting a circulant matrix having a size of *Z* × *Z* overlap, the maximum cycle length is limited to 6 regardless of the value of Z. Since the performance improvement achieved by iterative decoding is reduced when the cycle length is short, a parity-check matrix corresponding to a weight matrix or a core matrix including an entry having a value of 3 or greater is suitable for use when the code length is short or the code rate is relatively high. Since the disclosure deals with a method for designing LDPC codes supporting various code rates and various code lengths, an entry having a value of 3 or greater is not included in the core matrix of the weight matrix. (Of course, such an entry may be included in a portion corresponding to the single parity-check extension part.) The above may be defined as the following Condition 5.

**Condition 5:** The weight matrix corresponding to the core matrix consists only of 0 and 1, or only of 0, 1, and 2.

As another condition to be satisfied by the core matrix, the submatrix B 1020 of FIG. 10 corresponding to the first parity vector ***w*₁** should have full rank to enable efficient encoding, and, in order to prevent severe degradation of cycle characteristics, the following restricted structure is desirable.

**Condition 6(a)**: When the weight matrix corresponding to the core matrix consists of four rows, the submatrix corresponding to B 1020 in the weight matrix and the base matrix is one of the following: $\left[\begin{matrix}1 & 1 & 0 & 0 \\ 1 & 1 & 1 & 0 \\ 0 & 0 & 1 & 1 \\ 1 & 0 & 0 & 1\end{matrix}\right] , \left[\begin{matrix}1 & 1 & 0 & 0 \\ 0 & 1 & 1 & 0 \\ 1 & 0 & 1 & 1 \\ 1 & 0 & 0 & 1\end{matrix}\right] , \left[\begin{matrix}1 & 1 & 0 & 0 \\ 1 & 1 & 1 & 0 \\ 0 & 0 & 1 & 1 \\ 1 & 0 & 1 & 1\end{matrix}\right] , \left[\begin{matrix}1 & 1 & 0 & 0 \\ 0 & 1 & 1 & 0 \\ 1 & 1 & 1 & 1 \\ 1 & 0 & 1 & 1\end{matrix}\right] ,$ $\left[\begin{matrix}1 & 1 & 0 & 0 \\ 0 & 1 & 1 & 0 \\ 1 & 1 & 1 & 1 \\ 1 & 0 & 1 & 1\end{matrix}\right] . \left[\begin{matrix}1 & 1 & 0 & 0 \\ 0 & 1 & 1 & 0 \\ 1 & 0 & 1 & 1 \\ 1 & 1 & 1 & 1\end{matrix}\right]$

**Condition 6(b)**: When the weight matrix corresponding to the core matrix consists of three rows, the submatrix of the base matrix corresponding to the submatrix B 1020 is $\left[\begin{matrix}1 & 1 & 0 \\ 1 & 1 & 1 \\ 1 & 0 & 1\end{matrix}\right]$, and the weight matrix is one of the following: $\left[\begin{matrix}1 & 1 & 0 \\ 1 & 1 & 1 \\ 1 & 0 & 1\end{matrix}\right] , \left[\begin{matrix}1 & 1 & 0 \\ 0 & 1 & 1 \\ 2 & 0 & 1\end{matrix}\right] , \left[\begin{matrix}2 & 1 & 0 \\ 0 & 1 & 1 \\ 1 & 0 & 1\end{matrix}\right] , \left[\begin{matrix}1 & 2 & 0 \\ 0 & 1 & 1 \\ 2 & 0 & 1\end{matrix}\right] , \left[\begin{matrix}1 & 2 & 0 \\ 0 & 1 & 2 \\ 2 & 0 & 1\end{matrix}\right] .$

**Condition 6(c)**: When the weight matrix corresponding to the core matrix consists of two rows, the submatrix of the base matrix corresponding to the submatrix B 1020 is $\left[\begin{matrix}1 & 1 \\ 1 & 1\end{matrix}\right]$, and the weight matrix is one of the following: $\left[\begin{matrix}1 & 1 \\ 2 & 1\end{matrix}\right] , \left[\begin{matrix}1 & 2 \\ 2 & 1\end{matrix}\right]$.

For reference, Condition 6(a) illustrates a case in which the weight matrix and the base matrix are identical, and in Condition 6(b), the weight matrix has the same form as the base matrix only when the weight matrix is $\left[\begin{matrix}1 & 1 & 0 \\ 1 & 1 & 1 \\ 1 & 0 & 1\end{matrix}\right]$. In the base matrix or the weight matrix shown in Conditions 6(a), 6(b), and 6(c), 0 denotes a zero matrix having a size of *Z* × *Z*, and 1 denotes an identity matrix *I* = (*P*⁰) having a size of *Z* × *Z* or a circulant permutation matrix *P^{v}* (*v* > 0). Further, 2 denotes a circulant matrix (*P*^{*v*1} + *P*^{*v*2}) having a size of *Z* × *Z* (*v*₁, *v*₂ ≥ 0, *v*₁ ≠ *v*₂).

In general, although an upper bound on the cycle length may be predicted from a base matrix or a weight matrix, the cycle characteristics of a parity-check matrix corresponding to the base matrix or the weight matrix cannot be determined. For example, when the submatrix B 1020 is $\left[\begin{matrix}I & I \\ {P}^{{v}_{1}} + {P}^{{v}_{2}} & I\end{matrix}\right]$ or $\left[\begin{matrix}I & I & 0 \\ {P}^{{v}_{1}} & I & I \\ {P}^{{v}_{2}} & 0 & I\end{matrix}\right]$, the base matrix or the weight matrix is the same, namely, $\left[\begin{matrix}1 & 1 \\ 2 & 1\end{matrix}\right]$ or $\left[\begin{matrix}1 & 1 & 0 \\ 1 & 1 & 1 \\ 1 & 0 & 1\end{matrix}\right]$, respectively, regardless of the values of *v*₁ and *v*₂, whereas the cycle characteristics are significantly different. In the case of $\left[\begin{matrix}I & I \\ {P}^{{v}_{1}} + {P}^{{v}_{2}} & I\end{matrix}\right]$, when at least one of *v*₁ and *v*₂ is 0, or when ${v}_{1} ≡ {v}_{2} \left(mod\frac{Z}{2}\right)$ (or ${v}_{1} - {v}_{2} ≡ \frac{Z}{2} \left(mod Z\right)$), a large number of 4-cycles are generated. Accordingly, *v*₁ and *v*₂ are basically configured as integers satisfying *v*₁, *v*₂(mod*Z*) > 0 and ${v}_{1} ≢ {v}_{2} \left(mod\frac{Z}{2}\right)$ (or ${v}_{1} - {v}_{2} ≢ \frac{Z}{2} \left(mod Z\right)$ ). Likewise, in the case of $\left[\begin{matrix}I & I & 0 \\ {P}^{{v}_{1}} & I & I \\ {P}^{{v}_{2}} & 0 & I\end{matrix}\right]$, when *v*₁ = 0, a large number of 4-cycles are generated. Accordingly, *v*₁ is basically configured as an integer satisfying *v*₁(mod*Z*) ≥ 1, and *v*₂ is basically configured as an integer satisfying *v*₂(mod*Z*) ≥ 0. The foregoing merely provides a method for eliminating 4-cycles, and the values of *v*₁ and *v*₂ may be restricted in various manners to obtain longer cycles.

When the communication system applies puncturing of information word bits described in Table 9, the following condition to be satisfied by the core matrix may additionally be imposed.

**Condition 7:** In an LDPC encoding system to which puncturing of information word bits is applied, the submatrix of the core matrix composed only of columns corresponding to the punctured information word bits includes at least one row having a row weight of 1.

Since punctured bits are regarded as bits lost during the reception process at the receiver, it is determined that the probability of a punctured bit being 0 is equal to the probability of the punctured bit being 1. Accordingly, this is generally represented by 1 when decoding is performed using LR values, and by 0 when decoding is performed using LLR values, although it may be determined in another form based on values used in the decoding process. When LDPC decoding is performed based on a parity-check matrix that does not satisfy Condition 7, the punctured information word bits may not be decoded unless maximum likelihood (ML) decoding or pseudo maximum likelihood (pseudo ML) decoding scheme is used. Since ML or pseudo ML decoding scheme is generally not used due to its complexity, the parity-check matrix may be determined to satisfy Condition 7 in order to ensure successful decoding.

When the LDPC code is a QC-LDPC code, the parity-check matrix may be represented based on a lifting size Z, a base matrix, and/or a weight matrix and/or an exponent matrix. Accordingly, it may also be expressed as the following Condition 8.

**Condition 8**: In a QC-LDPC encoding system in which puncturing of information word bits is applied in units of a lifting size Z or a multiple thereof, the submatrix of the base matrix, composed only of **a** columns corresponding to the submatrix of the core matrix composed only of a*Z columns corresponding to the punctured a*Z (a: an integer greater than or equal to 1) information word bits, includes at least one row having a weight of 1. Further, the submatrix of the weight matrix, composed only of **a** columns corresponding to the submatrix of the core matrix composed only of the a*Z columns, includes at least one row having a weight of 1 and an entry of 1.

For example, in a QC-LDPC encoding system in which puncturing of 2Z information word bits is always applied, Condition 8 means that a = 2.

Meanwhile, in the disclosure, at least one of the above conditions may be used to construct the parity-check matrix. That is, the parity-check matrix may be determined to satisfy one of the above conditions or may be determined to satisfy a combination of at least two of the above conditions.

As an embodiment of the disclosure, a method for improving the error-floor performance of an LDPC code is proposed. In general, the error-floor phenomenon of an LDPC code is greatly affected by the cycle characteristics of a Tanner graph. However, since, in a QC-LDPC code, the cycle characteristics of the Tanner graph are determined according to the relationship between the base matrix and the exponents or cyclic shift values of the circulant permutation matrices, not only the positions of the circulant permutation matrices constituting the parity-check matrix but also the cyclic shift values should be appropriately selected.

In the disclosure, algebraic characteristics to be satisfied by the submatrix B 1020 corresponding to the first parity bits (or the first parity-bit vector) ***w*₁** = (*w*_{1,0}, *w*_{1,1}, *w*_{1,2}, ... , *w*_{1*,M*1-1}) in the first part of the parity-check matrix composed of the submatrices A 1010 and B 1020 of FIG. 10 are proposed.

The submatrix B 1020 has a size of ***M*₁** × ***M*₁** (or ***m*_{*b*1}*Z*** × ***m*_{*b*1}*Z***), and corresponds to a base matrix or a weight matrix having a size of $\left(\frac{{M}_{1}}{Z}\right) \times \left(\frac{{M}_{1}}{Z}\right)$ (or ***m*_{*b*1}** × ***m*_{*b*1}**). Further, the first column block of the submatrix B 1020 is composed of three circulant permutation matrices. In this case, the circulant permutation matrices may include an identity matrix. That is, in the disclosure, a circulant permutation matrix is defined as a matrix obtained by cyclically shifting the respective entries of an identity matrix by i positions, and, when the value of i is 0, the circulant permutation matrix may be an identity matrix. This definition may be applied throughout the detailed description of the disclosure. Further, the remaining column blocks of the submatrix B 1020 are composed of two circulant permutation matrices or identity matrices. For convenience of description, only the case where the remaining column blocks have a double-diagonal structure composed of identity matrices is illustrated in the disclosure. However, the disclosure is not limited thereto.

Equation 15 illustrates a specific example of the submatrix B 1020. The submatrix B 1020 may be determined based on at least one of the matrices included in Equation 15. However, embodiments of the disclosure are not limited thereto, and various matrices satisfying the above characteristics (i.e., the first column block is composed of three circulant permutation matrices, and the remaining column blocks are composed of two circulant permutation matrices or identity matrices) may be considered. [Equation 15] $\begin{matrix}{B}_{1} = \left[\begin{matrix}{P}^{a} & I & O \\ {P}^{b} & I & I \\ {P}^{c} & O & I\end{matrix}\right] , {B}_{2 , 1} = \left[\begin{matrix}{P}^{a} & I & O & O \\ {P}^{b} & I & I & O \\ O & O & I & I \\ {P}^{c} & O & O & I\end{matrix}\right] , \\ {B}_{2 , 2} = \left[\begin{matrix}{P}^{a} & I & O & O \\ O & I & I & O \\ {P}^{b} & O & I & I \\ {P}^{c} & O & O & I\end{matrix}\right] , {B}_{3} = \left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right] \\ M \left({B}_{1}\right) = \left[\begin{matrix}1 & 1 & 0 \\ 1 & 1 & 1 \\ 1 & 0 & 1\end{matrix}\right] , M \left({B}_{2 , 1}\right) = \left[\begin{matrix}1 & 1 & 0 & 0 \\ 1 & 1 & 1 & 0 \\ 0 & 0 & 1 & 1 \\ 1 & 0 & 0 & 1\end{matrix}\right] , \\ M \left({B}_{2 , 2}\right) = \left[\begin{matrix}1 & 1 & 0 & 0 \\ 0 & 1 & 1 & 0 \\ 1 & 0 & 1 & 1 \\ 1 & 0 & 0 & 1\end{matrix}\right] , M \left({B}_{3}\right) = \left[\begin{matrix}1 & 1 & 0 & 0 & 0 \\ 0 & 1 & 1 & 0 & 0 \\ 1 & 0 & 1 & 1 & 0 \\ 0 & 0 & 0 & 1 & 1 \\ 1 & 0 & 0 & 0 & 1\end{matrix}\right] , \\ M \left({B}_{4 , 1}\right) = \left[\begin{matrix}1 & 1 & 0 & 0 & 0 & 0 \\ 0 & 1 & 1 & 0 & 0 & 0 \\ 1 & 0 & 1 & 1 & 0 & 0 \\ 0 & 0 & 0 & 1 & 1 & 0 \\ 0 & 0 & 0 & 0 & 1 & 1 \\ 1 & 0 & 0 & 0 & 0 & 1\end{matrix}\right] , M \left({B}_{4 , 2}\right) = \left[\begin{matrix}1 & 1 & 0 & 0 & 0 & 0 \\ 0 & 1 & 1 & 0 & 0 & 0 \\ 0 & 0 & 1 & 1 & 0 & 0 \\ 1 & 0 & 0 & 1 & 1 & 0 \\ 0 & 0 & 0 & 0 & 1 & 1 \\ 1 & 0 & 0 & 0 & 0 & 1\end{matrix}\right] , \\ V \left({B}_{2 , 1}\right) = \left[\begin{matrix}a & 0 & - 1 & - 1 \\ b & 0 & 0 & - 1 \\ - 1 & - 1 & 0 & 0 \\ c & - 1 & - 1 & 0\end{matrix}\right] , V \left({B}_{3}\right) = \left[\begin{matrix}a & 0 & - 1 & - 1 & - 1 \\ - 1 & 0 & 0 & - 1 & - 1 \\ b & - 1 & 0 & 0 & - 1 \\ - 1 & - 1 & - 1 & 0 & 0 \\ c & - 1 & - 1 & - 1 & 0\end{matrix}\right]\end{matrix}$

In Equation 15, *B*₁, *B*_{2,1}, *B*_{2,2}, and *B*₃ have a first column block composed of three different circulant permutation matrices *P^{a}, P^{b},* and *P^{c}.* Further, although Equation 15 illustrates only cases where the value of *m*_{*b*1} is 3, 4, 5, or 6 for convenience of description, the submatrix B 1020 may be similarly defined for integers greater than those values. Further, matrices transformable into the submatrix B 1020 having the above form through an appropriate invertible transform process may be regarded as algebraically identical matrices.

In the disclosure, a method for improving cycle characteristics is proposed not only for *B*₁, *B*_{2,1}, *B*_{2,2}, and *B*₃ of Equation 15, but also for a larger submatrix B 1020 having a similar form. For convenience of description, detailed descriptions of a method for analyzing cycle characteristics of a QC-LDPC code and some algebraic characteristics are omitted in the disclosure, and reference is made to Reference [Myung2005].

[Myung2005]
S. Myung, K. Yang, and J. Kim, "Quasi-Cyclic LDPC Codes for Fast Encoding," IEEE Transactions on Information Theory, vol. 51, No.8, pp. 2894-2901, Aug. 2005.

When, as in Equation 15, the remaining column blocks other than the first column block in the submatrix B 1020 have a dual-diagonal structure having a size composed of identity matrices, conventionally, for convenience of encoding, at least two values among the exponents (or cyclic shift values) *a, b,* and c of the circulant permutation matrices in the first column block are configured to be the same value. In this case, a *ϕ* matrix having a size of *Z* × *Z* used in the encoding process becomes an identity matrix *I* or a simple circulant permutation matrix *P^{x},* and the inverse matrix *ϕ*⁻¹ of *ϕ* is simplified as an identity matrix *I* or *P^{-x}*, thereby simplifying the encoding process. (For details of the encoding process of a QC-LDPC code, see [Myung2005].) As a specific example, when *a* = *c* is configured, *ϕ* becomes *P^{b}* and *ϕ*⁻¹ becomes *P*^{-*b*}, thereby enabling efficient encoding. Likewise, when *a* = *b* is configured, *ϕ* becomes *P^{c}* and *ϕ*⁻¹ becomes *P^{-c},* thereby enabling efficient encoding.

However, when *a = c* ≠ *b,* Z cycles having a length of 2*m*_{*b*1} always exist on a Tanner graph due to the structure shown in Equation 16 below. In other words, when the value of *m*_{*b*1} is fixed, cycles having a length of 2*m*_{*b*1} always exist regardless of the lifting size Z and the value of exponent *a*(= *c*). (For details of cycle characteristics of a QC-LDPC code, see [Myung2005].) [Equation 16] $\left[\begin{matrix}{P}^{a} & I & ∗ & ∗ & ∗ \\ ∗ & I & I & ∗ & ∗ \\ ∗ & ∗ & ⋱ & ⋱ & ∗ \\ ∗ & ∗ & ∗ & I & I \\ {P}^{a} & ∗ & ∗ & ∗ & I\end{matrix}\right]$

Furthermore, when *a* = *b*, cycles having a length shorter than 2*m*_{*b*1} always exist due to the structure shown in Equation 17 below, regardless of the lifting size Z and the value of exponent *a*(= *b*). [Equation 17] $\begin{matrix} \\ \left[\begin{matrix}{P}^{a} & I & ∗ \\ {P}^{b} & I & ∗ \\ ∗ & ∗ & ∗\end{matrix}\right] , \left[\begin{matrix}{P}^{a} & I & ∗ & ∗ \\ ∗ & I & I & ∗ \\ {P}^{b} & ∗ & I & ∗ \\ ∗ & ∗ & ∗ & ∗\end{matrix}\right]\end{matrix}$

When the value of *m*_{*b*1} is sufficiently large, the cycle characteristics of the Tanner graph corresponding to the structures shown in Equations 16 and 17 may not significantly affect the performance of the LDPC code. However, when the value of *m*_{*b*1} is relatively small, the BLER may increase due to the error-floor phenomenon, and this becomes a non-negligible problem as the target BLER of the system decreases.

To address this problem, the disclosure proposes a method for improving cycle characteristics by restricting the exponents (or cyclic shift values) *a, b,* and *c* of the circulant permutation matrices constituting the first column block of the submatrix B 1020 having the structure shown in Equation 15 so as to satisfy specific algebraic conditions. The disclosure also explains that the proposed method improves the cycle characteristics while increasing, to a reasonable level, the computational complexity associated with operations on the *ϕ*⁻¹ matrix required in the LDPC encoding process.

When the lifting size Z of a parity-check matrix for a QC-LDPC code is Z = *p* · 2*^{L}* (where p is an odd integer and L is an integer greater than or equal to 0), the exponents (or cyclic shift values) *a, b,* and *c* of the circulant permutation matrices constituting the first column block of the submatrix B 1020 are different integers and satisfy at least some or all of the following conditions:
**Exponent Condition 1a**: At least one of the differences between two exponents (cyclic shift values) has a greatest common divisor with the lifting size Z that is either 1 or the smallest divisor of Z greater than 1. (That is, it is relatively prime to Z or has, as its greatest common divisor with Z, the smallest divisor of Z greater than 1.)
**Exponent Condition 1b**: Two of the differences between two exponents have a greatest common divisor with the lifting size Z that is either 1 or the smallest divisor of Z greater than 1.
**Exponent Condition 2a**: At least one of the differences between two exponents is $\frac{Z}{{2}^{i}}$ (0 ≤ *i* ≤ *L*).
**Exponent Condition 2b**: At least one of the differences between two exponents is $\frac{Z}{{2}^{i}}$ (1 ≤ *i* < *L*) when *p* = 1 and *L* > 1, and $\frac{Z}{{2}^{i}}$ (1 ≤ *i* ≤ *L*) when *p* is an odd integer greater than or equal to 3 and L>0.

For reference, the differences between exponents used in the above exponent conditions refer to | *a - b* |, | *b - c* |, | *c* - *a* |, and the like.

According to Exponent Condition 1a, when the difference between two exponents is relatively prime to Z, the length of the cycle determined by the circulant permutation matrices associated with the two exponents is maximized. For example, when a value of | *a* - *b* | is relatively prime to Z, the length of the cycle on the Tanner graph determined by $\left[\begin{matrix}{P}^{a} & I & ∗ \\ {P}^{b} & I & ∗ \\ ∗ & ∗ & ∗\end{matrix}\right]$ in Equation 17 is 4Z. When the greatest common divisor of | *a* - *b* | and Z is D, the cycle length is 4*Z*/D. As a result, as the value of Z increases, the cycle length also increases accordingly.

As another example, when a value of | *a* - *c* | is relatively prime to *Z*, the length of the cycle determined by the structure of Equation 16 is 2*m*_{*b*1}*Z*. When the greatest common divisor of | *a* - *c* | and *Z* is *D,* the cycle length is 2*m*_{*b*1}*Z*/*D*. As a result, the cycle length is not fixed regardless of the value of *Z*; rather, it increases as the value of *Z* increases. Although it is desirable, from the standpoint of cycle characteristics alone, that the difference between two exponents be relatively prime to *Z*, the exponents may be selected such that the greatest common divisor *D* is small (for example, equal to the smallest divisor of *Z* greater than 1) according to other conditions. For example, when the difference between two exponents cannot be made relatively prime to *Z*, it is desirable to select the exponents such that the greatest common divisor *D* is small.

The exponent condition 1b is a condition that further limits the exponent condition as compared to the exponent condition 1a in order to further improve the cycle characteristics. For example, when the values of |*a* - *b*| and |*b - c*| are relatively prime to *Z*, not only are the cycle characteristics associated with the exponents a and b improved as in $\left[\begin{matrix}{P}^{a} & I & ∗ \\ {P}^{b} & I & ∗ \\ ∗ & ∗ & ∗\end{matrix}\right]$, but also the cycle characteristics associated with the exponents b and c are likewise improved as in $\left[\begin{matrix}∗ & ∗ & ∗ \\ {P}^{b} & ∗ & I \\ {P}^{c} & ∗ & I\end{matrix}\right]$. (The same also applies to Equation 15 and to other forms of submatrix B expanded based on Equation 15.)

Submatrix B of Equation 15 and other forms expanded based on Equation 15 are defined such that, when *a, b,* and *c* are all different, the *ϕ* matrix required in the encoding process is defined by *ϕ = P^{a} + P^{b} + P^{c}.* For such a *ϕ* matrix, it is not easy to obtain *ϕ*⁻¹, but also the *ϕ*⁻¹ matrix generally has a high density of weights rather than a low-density characteristic. That is, a *ϕ* matrix having a low-density characteristic does not guarantee that the *ϕ*⁻¹ matrix has a low-density characteristic. Since such a high-density characteristic of the *ϕ*⁻¹ matrix increases the encoding complexity, it is desirable that the density of the *ϕ*⁻¹ matrix be as low as possible, and it is also desirable that the *ϕ*⁻¹ matrix have a simple structure.

The exponent conditions 2a and 2b are conditions for simplifying the *ϕ*⁻¹ matrix as much as possible for efficient LDPC encoding. For example, when $\left|a-c\right| = \frac{Z}{{2}^{i}}$ in the exponent condition 2a, *ϕ*^{2*i*} = *P*^{2*ia*} + *P*^{2*ib*} + *P*^{2*ic*} = *P*^{2*ia*}(*I* + *P*^{2*i*(*c-a*)}) *+ P*^{2*ib*} = *P*^{2*i·b*} and thus *ϕ*⁻¹ = *P*^{2*ib*} · *ϕ*^{2*i*-1}. Here, *ϕ*^{2*i*-1} is given by *ϕ*^{2*i*-1} = *ϕ*^{2*i*-1} · *ϕ*^{2*i*-2} · ··· · *ϕ*² · *ϕ* = (*P*^{2(*i-*1)*a*} + *P*^{2(*i-*1)*b*} + *P*^{2(*i-*1)*c*})(*P*^{2(*i-*2)*a*} + *P*^{2(*i-*2)*b*} + *P*^{2(*i-*2)*c*}) *.....* (*P*^{2*a*} + *P*^{2*b*} + *P^{2c}*) · (*P^{a}* + *P^{b}* + *P^{c}*). Accordingly, although *ϕ*⁻¹ may be determined relatively simply, it can be seen that the computational complexity due to *ϕ*⁻¹ increases as the value of *i* increases. Therefore, the value of i may be appropriately limited according to the complexity allowable in the system. In general, the value of *i* is preferably within a range of 0 ≤ *i* ≤ 4, although a larger value may be used depending on the allowable range of the system.

For reference, for any bit sequence *v^{T}* having a length of Z, the operation *P^{x}* · *v^{T}*, in which the bit sequence is multiplied by a circulant permutation matrix *P^{x}* having a size of *Z* × *Z*, is equivalent to circularly shifting the bit sequence *v^{T}* by *x* bits rather than performing an actual matrix multiplication operation. That is, since the operation can actually be implemented as a bit shift operation rather than a matrix multiplication operation, the above operation denotes an operation or process having very low computational complexity. In addition, in the process of calculating *Φ*^{2*i*-1} *· v^{T}, the* computational complexity can be minimized through stepwise computation, such as *ϕ*^{2*i*-1} *· v^{T}* = *ϕ*²ⁱ⁻¹ (···(*ϕ*²(*ϕ* · *v^{T}*))), rather than by expanding each term of *ϕ*^{2*i*-1} and performing the corresponding calculations. As a simple example, the operation may be performed as follows: $\begin{matrix}\left({P}^{2 a}+{P}^{2 b}+{P}^{2 c}\right) ⋅ \left({P}^{a}+{P}^{b}+{P}^{c}\right) ⋅ {{v}_{¯}}^{T} \\ = {P}^{3 a} \left(I+{P}^{2 \left(b-a\right)}+{P}^{2 \left(c-a\right)}\right) ⋅ \left(I+{P}^{b - a}+{P}^{c - a}\right) ⋅ {{v}_{_}}^{T} \\ = {P}^{3 a} \left(I+{P}^{2 \left(b-a\right)}+{P}^{2 \left(c-a\right)}\right) ⋅ \left({{v}_{_}}^{T}+{P}^{b - a}⋅{{v}_{_}}^{T}+{P}^{c - a}⋅{{v}_{_}}^{T}\right) \\ = {P}^{3 a} \left(I+{P}^{2 \left(b-a\right)}+{P}^{2 \left(c-a\right)}\right) ⋅ {{v}_{_}}_{1}^{T} \\ = {P}^{3 a} \left({{v}_{_}}_{1}^{T}+{P}^{2 \left(b-a\right)}⋅{{v}_{_}}_{1}^{T}+{P}^{2 \left(c-a\right)}⋅{{v}_{_}}_{1}^{T}\right) = {P}^{3 a} ⋅ {{v}_{_}}_{2}^{T} .\end{matrix}$

In the exponent condition 2a, even when $\left|a-b\right| = \frac{Z}{{2}^{i}}$ or $\left|b-c\right| = \frac{Z}{{2}^{i}}$, encoding may be performed by determining *ϕ*⁻¹ in the same manner. However, when the differences between two exponents are all in the form of $\frac{Z}{{2}^{i}}$, the cycle characteristics are likely to deteriorate. Therefore, for efficient encoding and good cycle characteristics, a method may be considered in which at least one of the differences between two exponents satisfies the characteristic of being $\frac{Z}{{2}^{i}}$ (0 ≤ *i* ≤ *L*), and the remaining exponent differences satisfy the exponent condition 1a or the exponent condition 1b. In addition, when there is a case in which the difference between two exponents is $\frac{Z}{{2}^{i}}$ and at least one of the exponent condition 1a or the exponent condition 1b is satisfied, the corresponding exponents may be selected.

The exponent condition 2b is a condition that further limits the exponent condition as compared to the exponent condition 2a, thereby enabling efficient encoding while further improving the cycle characteristics. When the exponent condition 2b is satisfied, the encoding complexity is somewhat increased as compared to that of the conventional 5G LDPC code, but has an advantage in that the cycle characteristics are improved. Of course, if there is no case satisfying the exponent condition 2b, the exponents may be determined in consideration of the exponent condition 2a. For reference, except for the case in which $\frac{Z}{{2}^{i}} = 1$ is satisfied in the exponent condition 2a, it can be seen that the difference between two exponents is not always relatively prime to Z. That is, Z and the difference between two exponents have a common divisor greater than 1. The existence of *i* satisfying $\frac{Z}{{2}^{i}} = 1$ means that *Z* = 2*^{L}*, and when the exponent condition 2b is satisfied, the condition 1 ≤ *i < L* causes *Z* and the difference between two exponents not to be relatively prime and to have 2^{*L*-*i*} as a common divisor.

As an embodiment of the disclosure, a more specific example of configuring submatrix B 1020 of FIG. 10 by using the exponent conditions will be described.

First, as in 5G, a communication system or broadcasting system in which lifting size sets are defined as shown in Tables 3 to 8 and only lifting sizes included in the lifting size sets can be applied is considered. In addition, a separate parity-check matrix or exponent matrix may be defined for each lifting size set. That is, in the case of Tables 3 to 8, a parity-check matrix or an exponent matrix may be defined for each of a total of eight set indexes.

Assume that *a, b,* and *c* are determined as follows in submatrix B of Equation 15 and other forms expanded based on Equation 15. In general, since values of exponents *a, b,* and *c* for submatrix B of a parity-check matrix corresponding to *i_{LS} = k* (*k =* 0,1,2, ...) may all be different, they are expressed as *aₖ, bₖ,* and *cₖ* for convenience.

### Exponent Selection Example 1 (i_{LS} = k)

- *aₖ* is an arbitrary integer.
- *bₖ* is given by *bₖ* = *aₖ* + *sₖ*, where *sₖ* is an integer satisfying gcd(*sₖ, Zₖ*) = 1, that is, *aₖ* and *bₖ* among the exponents corresponding to submatrix B are integers satisfying gcd(|*aₖ* - *bₖ*|, *Zₖ*) = 1. Here, gcd(*x*, *y*) denotes the greatest common divisor of *x* and *y*, and *Zₖ* denotes an arbitrary lifting size belonging to the lifting size set corresponding to *i_{LS} = k.*
- *cₖ* is given by *cₖ* = *aₖ* + *tₖ*, where *tₖ* is one of the lifting sizes smaller than the largest lifting size *Z*_{*k*,max} among the lifting size values belonging to the lifting size set corresponding to *i_{LS} = k.*

For submatrix B determined through the exponent selection example 1, when differences between respective exponents are obtained, since |*aₖ* - *bₖ*| = |*sₖ*| for an arbitrary lifting size *Zₖ,* the exponent condition 1a is satisfied, and since, in |*bₖ - cₖ*| = |*sₖ - tₖ*|, *tₖ* is one of the *Zₖ* values and the respective *Zₖ* values have a multiple relationship with each other (2*ⁱ* multiple relationship), 1 = gcd(*sₖ, Zₖ*) = gcd(*sₖ* - *Zₖ*, *Zₖ*) = gcd(*sₖ - tₖ, Zₖ*) is satisfied according to the definition of *sₖ,* and thus the exponent condition 1b is also satisfied. However, since $\left|{c}_{k}-{a}_{k}\right| = {t}_{k} = \frac{{Z}_{max}}{{2}^{i}} = p ⋅ {2}^{\left(L-i\right)}$ , whether the exponent condition 2a and the exponent condition 2b are satisfied varies depending on the lifting size *Zₖ*. For example, when *Zₖ > tₖ*, the exponent condition 2a and the exponent condition 2b are always satisfied, but when *Zₖ* ≤ *tₖ*, *cₖ* ≡ *aₖ + tₖ* ≡ *aₖ* (mod *Zₖ*) is satisfied, and thus the circulant permutation matrices *P^{ak}* and *P^{ck}* having a size of *Zₖ* × *Zₖ* are substantially the same, so that the exponent condition 2a and the exponent condition 2b may not be satisfied. In other words, when *Zₖ* ≤ *tₖ*, this means that a structure as in Equation 16 is obtained and the cycle characteristics are not improved. In conclusion, in order to improve the cycle characteristics for lifting sizes having various lengths, it is desirable that the value of *tₖ* be determined to be as small as possible.

However, when the value of lifting size *Zₖ* for LDPC encoding is relatively large as compared to the value of *tₖ* (that is, when the value of *i* is large in $\frac{{Z}_{k}}{{t}_{k}} = {2}^{i}$ ), there is a high possibility that the encoding complexity greatly increases due to an operation related to the *ϕ*⁻¹ matrix. Therefore, the value of *tₖ* may be selected in consideration of the cycle characteristics and the encoding complexity. When only improvement of the cycle characteristics is considered, the smallest lifting size among the lifting size values belonging to the lifting size set corresponding to *i_{LS} = k* may be selected as *tₖ.* In addition, when a limited increase in encoding complexity is considered, a lifting size greater than the smallest lifting size and smaller than the largest lifting size among the lifting size values belonging to the lifting size set corresponding to *i_{LS} = k* may be selected as *tₖ*. In general, when the lifting sizes included in the lifting size set are *Z*₁ *=* p *·* 2^{*j*1}, *Z*₂ = p *·* 2^{*j*2}, ..., *Z*ₘₐₓ = *p ·* 2^{*j*max} (*j*₁ < *j*₂ < ... < *j*ₘₐₓ), the value of *tₖ* may be configured as *tₖ = p · 2ⁱ* (*j*₁ *< i* < *j*ₘₐₓ). In general, if the values of *j*₁, *j*₂, ..., *j*ₘₐₓ are not consecutive integer values, the value of *i* may be selected as an integer other than *j*₂, *j*₃, .... In addition to the above embodiment, also for other embodiments, *tₖ* may be selected based on various conditions as described above, but a detailed description may be omitted for convenience of description.

As a specific example of the exponent selection method, examples of exponent selection are described below when, for convenience, *a* = 1, that is, *P^{a}* = *P*¹.

### Exponent Selection Example 2 (i_{LS} = k)

- ${a}_{k} = 1 \left(\to {P}^{a}=P\right)$
- b*ₖ* = 0 (when s*ₖ* = -1 is configured, gcd(|*aₖ* - *bₖ*|, *Zₖ*) = 1, *P^{b}* = I)
- *cₖ* is given by *cₖ =* 1 *+ tₖ* (or *cₖ =* 1 *- tₖ*), where *tₖ* is one of the lifting size values smaller than the largest lifting size *Z*_{*k*,max} among the lifting size values belonging to the lifting size set corresponding to *i_{LS} = k.*

For submatrix B determined through the exponent selection example 2, when differences between respective exponents are obtained, |*aₖ* - *bₖ*| = 1, and thus gcd(|*aₖ* - *bₖ*|, *Zₖ*) = 1 is always satisfied for an arbitrary lifting size *Zₖ* , |*bₖ - cₖ*| = 1 *+ tₖ* and thus 1 = gcd(1, *Zₖ*) = gcd(1 + *Zₖ, Zₖ*) = gcd(1 *+ tₖ, Zₖ*) is satisfied, so that the exponent condition 1a and the exponent condition 1b can be satisfied. When *bₖ* = 0 as in the exponent selection example 2, not only for *aₖ =* 1 but also, in general, for an arbitrary *aₖ* satisfying gcd(*aₖ*, *Zₖ*) = 1), the exponent condition 1a and the exponent condition 1b can be satisfied. That is, for an integer *a* satisfying *gcd*(*a*, *Zₖ*) = 1, submatrix B configured as *aₖ = a, bₖ* = 0, *cₖ = a + tₖ* satisfies the exponent condition 1a and the exponent condition 1b. In addition, since $\left|{c}_{k}-{a}_{k}\right| = {t}_{k} = \frac{{Z}_{max}}{{2}^{i}} = p ⋅ {2}^{\left(L-i\right)}$, whether the exponent condition 2a and the exponent condition 2b are satisfied varies depending on the lifting size *Zₖ.* The value of *tₖ* (or *cₖ*) may be selected based on various conditions in consideration of improvement of the cycle characteristics and the encoding complexity, as described above.

A specific embodiment related to the exponent selection example 2 will be described below.

When a lifting size set as shown in Table 8 is given, a specific example of submatrix B is shown in Equation 18 below. Equation 18 shows an example of submatrix B in the parity-check matrix for *i_{LS} =* 0 of Table 8. (This is an example in which (*P^{a}, P^{b}, P^{c}*) of the matrices in Equation 15 are configured.) Submatrix B may be determined based on at least one of the matrices included in Equation 18 below. However, embodiments of the disclosure are not limited thereto. That is, in the following embodiment, the case in which 32 is selected as the lifting size is described as an example, but any one of the lifting sizes included in Table 8 may be selected. Accordingly, various matrices may be considered based on c determined according to the lifting size. [Equation 18] $\begin{matrix}- a = 1 , b = 0 , c = 1 + 32 = 33 \left(32 selected from the lifting sizes\right) \\ {B}_{1} = \left[\begin{matrix}{P}^{1} & I & O \\ I & I & I \\ {P}^{33} & O & I\end{matrix}\right] , {B}_{2 , 1} = \left[\begin{matrix}{P}^{1} & I & O & O \\ I & I & I & O \\ O & O & I & I \\ {P}^{33} & O & O & I\end{matrix}\right] , {B}_{2 , 2} = \left[\begin{matrix}{P}^{1} & I & O & O \\ O & I & I & O \\ I & O & I & I \\ {P}^{33} & O & O & I\end{matrix}\right] , \\ {B}_{3} = \left[\begin{matrix}{P}^{1} & I & O & O & O \\ O & I & I & O & O \\ I & O & I & I & O \\ O & O & O & I & I \\ {P}^{33} & O & O & O & I\end{matrix}\right] , {B}_{4 , 1} = \left[\begin{matrix}{P}^{1} & I & O & O & O & O \\ O & I & I & O & O & O \\ O & O & I & I & O & O \\ I & O & O & I & I & O \\ O & O & O & O & I & I \\ {P}^{33} & O & O & O & O & I\end{matrix}\right] , \\ {B}_{4 , 2} = \left[\begin{matrix}{P}^{1} & I & O & O & O & O \\ O & I & I & O & O & O \\ I & O & I & I & O & O \\ O & O & O & I & I & O \\ O & O & O & O & I & I \\ {P}^{33} & O & O & O & O & I\end{matrix}\right] .\end{matrix}$

In the case of Equation 18, when the value of the lifting size Z in the 0th lifting size set is selected to be 32 or less, such as 8, 16, or 32, *P*³³ = *P*¹ from 33 ≡ 1 (mod *Z*), and thus the *ϕ* matrix substantially becomes the identity matrix *I* and *ϕ*⁻¹ also becomes the identity matrix *I*. Accordingly, while the encoding process becomes simple, there is a disadvantage in that the cycle characteristics are not improved. If improvement of the cycle characteristics and a limited increase in encoding complexity are considered, the exponent pair (*a, b, c*) corresponding to (*P^{a}, P^{b}, P^{c}*) in the submatrix having the structure of Equation 18 may have the following combinations.

**[Table 10]**

| ***Set index (i_{LS})*** | (***a**, **b***) | ***c*** |
|---|---|---|
| 0 | | 17 or 33 or 65 (or 129) |
| 1 | | 25 or 49 or 97 (or 193) |
| 2 | | 21 or 41 or 81 (or 161) |
| 3 | (*a, b*) = (1,0) | 15 or 29 or 57 (or 113) |
| 4 | | 19 or 37 or 73 (or 145) |
| 5 | | 23 or 45 or 89 (or 177) |
| 6 | | 27 or 53 (or 105) |
| 7 | | 31 or 61 (or 121) |

Table 10 is merely an example, and in general, one lifting size value *t* may be selected from among lifting size values smaller than Z_max, and *c* may be determined as *c = t +* 1.

As an embodiment of the disclosure, the value of c may be determined based on the largest lifting size among lifting sizes smaller than a specific reference value. More specifically, if the reference value is configured as 96, in a system using lifting size sets as shown in Tables 3 to 8, the numbers that are 96 or less in the respective lifting size sets are, in order, 64, 96, 80, 56, 72, 88, 52, and 60. Accordingly, if the value of c corresponding to a parity-check matrix defined according to each lifting size set index is determined based on the reference value in each lifting size set, the value of *c* may be defined as, in order, 65, 97, 81, 57, 73, 89, 53, and 61, according to the respective lifting size set indexes. If the reference value is configured as 48, likewise, the value of *c* may be defined as, in order, 33, 49, 41, 29, 37, 45, 27, and 31, according to the respective lifting size set indexes. For reference, when a lifting size set excluding the numbers in parentheses in Table 3 or Table 8 is used, if the i-th largest lifting size among the lifting sizes included in the lifting size set for *i_{LS} =* 1 is determined as the reference value, the value of *c* corresponding to a parity-check matrix defined according to each lifting size set index is characterized in that it is determined as an integer obtained by adding 1 to the i-th largest lifting size in each set.

In addition, for uniformity of the encoding method, the i-th largest lifting size may be selected in each lifting size set (i=2, 3, 4, ...). For example, in a system using lifting size sets as shown in Table 3, the fifth largest numbers in the respective lifting size sets are 16, 24, 20, 14, 18, 22, 13, and 15. Accordingly, if the value of *c* corresponding to a parity-check matrix defined according to each lifting size set index is determined based on the fifth largest number in each lifting size set (i=5), the value of *c* may be defined as, in order, 17, 25, 21, 15, 19, 23, 14, and 16, according to the respective lifting size set indexes. Likewise, if the value of *c* corresponding to a parity-check matrix defined according to each lifting size set index is determined based on the fourth largest number in each lifting size set (i=4), the value of *c* may be defined as, in order, 33, 49, 41, 29, 37, 45, 27, and 31, according to the respective lifting size set indexes. Likewise, if the value of *c* corresponding to a parity-check matrix defined according to each lifting size set index is determined based on the third largest number in each lifting size set (i=3), the value of *c* may be defined as, in order, 65, 97, 81, 57, 73, 89, 53, and 61, according to the respective lifting size set indexes. Likewise, if the value of *c* corresponding to a parity-check matrix defined according to each lifting size set index is determined based on the second largest number in each lifting size set (i=2), the value of *c* may be defined as, in order, 129, 193, 161, 113, 145, 177, 105, and 121, according to the respective lifting size set indexes.

If a system uses lifting size sets of the values excluding the values in parentheses in Table 8, the fifth largest numbers in the respective lifting size sets are 32, 48, 40, 28, 36, 44, 26, and 30. Accordingly, if the value of *c* corresponding to a parity-check matrix defined according to each lifting size set index is determined based on the fifth largest number in each lifting size set (i=5), the value of *c* may be defined as, in order, 33, 49, 41, 29, 37, 45, 27, and 31, according to the respective lifting size set indexes. Likewise, if the value of c corresponding to a parity-check matrix defined according to each lifting size set index is determined based on the fourth largest number in each lifting size set (i=4), the value of *c* may be defined as, in order, 65, 97, 81, 57, 73, 89, 53, and 61, according to the respective lifting size set indexes. Likewise, if the value of c corresponding to a parity-check matrix defined according to each lifting size set index is determined based on the third largest number in each lifting size set (i=3), the value of *c* may be defined as, in order, 129, 193, 161, 113, 145, 177, 105, and 121, according to the respective lifting size set indexes. Likewise, if the value of c corresponding to a parity-check matrix defined according to each lifting size set index is determined based on the second largest number in each lifting size set (i=2), the value of *c* may be defined as, in order, 257, 385, 321, 225, 289, 353, 209, and 241, according to the respective lifting size set indexes.

In addition, according to the (*P^{a}, P^{b}, P^{c}*) = (*P, I, P^{c}*) combination shown in Equation 18, Table 10, and the embodiments corresponding thereto, the *ϕ* matrix becomes *ϕ* = *P + I + P^{c}.* According to the exponent selection example 2, when the value of the lifting size *Zₖ* is less than or equal to (c - 1), c ≡ 1 (mod *Zₖ*) is satisfied, and thus *P^{a} = P = P^{c}.* Accordingly, although the cycle characteristics are not improved, efficient LDPC encoding is possible by using the fact that *ϕ = I + P + P^{c} = I = ϕ*⁻¹. When the value of the lifting size *Zₖ* is greater than (*c* - 1), there exists i satisfying (*P*)^{2*i*} = (*P^{c}*)²*ⁱ (i* ≥ 1), and thus *ϕ*²*ⁱ = I.* Accordingly, efficient LDPC encoding is possible, although the encoding complexity increases, by using the property that *ϕ*⁻¹ = *ϕ*^{2*i*-1} = *ϕ*^{2*i*-1} · *ϕ*^{2*i*-2} · ··· · *ϕ*² · *ϕ.* Here, the cycle length determined by *P^{a}* and *P^{c}* increases from the conventional 2*m*_{*b*1} to 2*m*_{*b*1} · *Z*/*D* = 2*m*_{*b*1} · 2*ⁱ* = 2^{*i*+1} · *m*_{*b*1}. Since the cycle lengths determined by *P^{a}* and *P^{b}* or by *P^{b}* and *P^{c}* satisfy the exponent condition 1a and the exponent condition 1b, they increase significantly in proportion to the value of Z.

As a specific example of the exponent selection method, examples of exponent selection are described below when, for convenience, *a* = 0, that is, *P^{a} = I*.

### Exponent Selection Example 3 (i_{LS} = k)

- ${a}_{k} = 0 \left(\to {P}^{a}=I\right)$
- *bₖ* = 0 (when *sₖ* = 1 is configured, gcd(|*aₖ* - *bₖ*|, *Zₖ*) = 1, *P^{b}* = *P*)
- *cₖ* is given by *cₖ* = *tₖ* (or *cₖ* = *-tₖ*), where *tₖ* is one of the lifting size values smaller than the largest lifting size *Z*_{*k*,max} among the lifting size values belonging to the lifting size set corresponding to *i_{LS} = k.*

For submatrix B determined through the exponent selection example 3, when differences between respective exponents are obtained, |*aₖ* - *bₖ*| = 1, and thus gcd(|*aₖ* - *bₖ*|, *Zₖ*) = 1 is always satisfied for an arbitrary lifting size *Zₖ* , |*bₖ - cₖ*| = *tₖ* - 1 and thus 1 = gcd(1, *Zₖ*) = gcd(*Zₖ -* 1, *Zₖ*) = gcd(*tₖ* - 1,*Zₖ*) is satisfied, so that the exponent condition 1a and the exponent condition 1b can be satisfied. When *bₖ* = 1 as in the exponent selection example 3, not only for *aₖ* = 0 but also, in general, for an arbitrary *bₖ* satisfying gcd(*bₖ*, *Zₖ*) = 1), the exponent condition 1a and the exponent condition 1b can be satisfied. That is, for an integer *b* satisfying gcd(b, *Zₖ*) = 1, submatrix B configured as *aₖ* = 0, *bₖ = b, cₖ = tₖ* satisfies the exponent condition 1a and the exponent condition 1b. In addition, since $\left|{c}_{k}-{a}_{k}\right| = {t}_{k} = \frac{{Z}_{max}}{{2}^{i}} = p ⋅ {2}^{\left(L-i\right)}$, whether the exponent condition 2a and the exponent condition 2b are satisfied varies depending on the lifting size *Zₖ*. The value of *tₖ* (or *cₖ*) may be selected based on various conditions in consideration of improvement of the cycle characteristics and the encoding complexity, as described above.

A specific embodiment related to the exponent selection example 3 will be described below.

When a lifting size set as shown in Table 8 is given, a specific example of submatrix B is shown in Equation 19 below. Equation 19 shows an example of submatrix B in the parity-check matrix for *i_{LS}* = 0 of Table 8. (This is an example in which (*P^{a}, P^{b}, P^{c}*) of the matrices in Equation 15 are configured.) Submatrix B may be determined based on at least one of the matrices included in Equation 19 below. However, embodiments of the disclosure are not limited thereto. That is, in the following embodiment, the case in which 32 is selected as the lifting size is described as an example, but any one of the lifting sizes included in Table 8 may be selected. Accordingly, various matrices may be considered based on c determined according to the lifting size. [Equation 19] $\begin{matrix}- a = 0 , b = 1 , c = 32 \left(32 selected from the lifting sizes\right) \\ {B}_{1} = \left[\begin{matrix}I & I & O \\ P & I & I \\ {P}^{32} & O & I\end{matrix}\right] , {B}_{2 , 1} = \left[\begin{matrix}I & I & O & O \\ P & I & I & O \\ O & O & I & I \\ {P}^{32} & O & O & I\end{matrix}\right] , {B}_{2 , 2} = \left[\begin{matrix}I & I & O & O \\ O & I & I & O \\ P & O & I & I \\ {P}^{32} & O & O & I\end{matrix}\right] , {B}_{3} = \\ \left[\begin{matrix}I & I & O & O & O \\ O & I & I & O & O \\ P & O & I & I & O \\ O & O & O & I & I \\ {P}^{32} & O & O & O & I\end{matrix}\right] , {B}_{4 , 1} = \left[\begin{matrix}I & I & O & O & O & O \\ O & I & I & O & O & O \\ O & O & I & I & O & O \\ P & O & O & I & I & O \\ O & O & O & O & I & I \\ {P}^{32} & O & O & O & O & I\end{matrix}\right] , \\ {B}_{4 , 2} = \left[\begin{matrix}I & I & O & O & O & O \\ O & I & I & O & O & O \\ P & O & I & I & O & O \\ O & O & O & I & I & O \\ O & O & O & O & I & I \\ {P}^{32} & O & O & O & O & I\end{matrix}\right] .\end{matrix}$

In the case of Equation 19, when the value of the lifting size Z in the 0th lifting size set is selected to be 32 or less, such as 8, 16, or 32, *P*³² = *P*⁰ *= I* from 33 ≡ 0 (mod *Z*) , and thus the *ϕ* matrix substantially becomes the circulant permutation matrix *P* and *ϕ*⁻¹ also becomes circulant permutation matrix *P*⁻¹. Accordingly, while the encoding process becomes simple, there is a disadvantage in that the cycle characteristics are not improved. If improvement of the cycle characteristics and a limited increase in encoding complexity are considered, the exponent pair (*a, b, c*) corresponding to (*P^{a}, P^{b}, P^{c}*) in the submatrix having the structure of Equation 18 may have the following combinations.

**[Table 11]**

| ***Set index (i_{LS})*** | **(*a, b*)** | ***c*** |
|---|---|---|
| 0 | | 16 or 32 or 64 (or 128) |
| 1 | | 24 or 48 or 96 (or 192) |
| 2 | | 20 or 40 or 80 (or 160) |
| 3 | (*a, b*) = (0,1) | 14 or 28 or 56 (or 112) |
| 4 | | 18 or 36 or 72 (or 144) |
| 5 | | 22 or 44 or 88 (or 176) |
| 6 | | 26 or 52 (or 104) |
| 7 | | 30 or 60 (or 120) |

Table 11 is merely an example, and in general, one lifting size value *t* may be selected from among lifting size values smaller than Z_max, and *c* may be determined as *c = t.*

As an embodiment of the disclosure, the value of *c* may be determined based on the largest lifting size among lifting sizes smaller than a specific reference value. More specifically, if the reference value is configured as 96, in a system using lifting size sets as shown in Tables 3 to 8, the numbers that are 96 or less in the respective lifting size sets are, in order, 64, 96, 80, 56, 72, 88, 52, and 60. Accordingly, if the value of c corresponding to a parity-check matrix defined according to each lifting size set index is determined based on the reference value in each lifting size set, the value of c may be defined as, in order, 64, 96, 80, 56, 72, 88, 52, and 60, according to the respective lifting size set indexes. If the reference value is configured as 48, likewise, the value of c may be defined as, in order, 32, 48, 40, 28, 36, 44, 26, and 30, according to the respective lifting size set indexes. For reference, when a lifting size set excluding the numbers in parentheses in Table 3 or Table 8 is used, if the i-th largest lifting size among the lifting sizes included in the lifting size set for *i_{LS} =* 1 is determined as the reference value, the value of c corresponding to a parity-check matrix defined according to each lifting size set index is characterized in that it is determined as the i-th largest lifting size in each set.

In addition, for uniformity of the encoding method, the i-th largest lifting size may be selected in each lifting size set (i=2, 3, 4, 5. 6, ...). For example, in a system using lifting size sets as shown in Table 3, the fifth largest numbers in the respective lifting size sets are 16, 24, 20, 14, 18, 22, 13, and 15. Accordingly, if the value of *c* corresponding to a parity-check matrix defined according to each lifting size set index is determined based on the fifth largest number in each lifting size set (i=5), the value of *c* may be defined as, in order, 16, 24, 20, 14, 18, 22, 13, and 15, according to the respective lifting size set indexes. Likewise, if the value of *c* corresponding to a parity-check matrix defined according to each lifting size set index is determined based on the fourth largest number in each lifting size set (i=4), the value of *c* may be defined as, in order, 32, 48, 40, 28, 36, 44, 26, and 30, according to the respective lifting size set indexes. Likewise, if the value of c corresponding to a parity-check matrix defined according to each lifting size set index is determined based on the third largest number in each lifting size set (i=3), the value of *c* may be defined as, in order, 64, 96, 80, 56, 72, 88, 52, and 60, according to the respective lifting size set indexes. Likewise, if the value of *c* corresponding to a parity-check matrix defined according to each lifting size set index is determined based on the second largest number in each lifting size set (i=2), the value of *c* may be defined as, in order, 128, 192, 160, 112, 144, 176, 104, and 120, according to the respective lifting size set indexes.

If a system uses lifting size sets of the values excluding the values in parentheses in Table 8, the fifth largest numbers in the respective lifting size sets are 32, 48, 40, 28, 36, 44, 26, and 30. Accordingly, if the value of *c* corresponding to a parity-check matrix defined according to each lifting size set index is determined based on the fifth largest number in each lifting size set (i=5), the value of *c* may be defined as, in order, 32, 48, 40, 28, 36, 44, 26, and 30, according to the respective lifting size set indexes. Likewise, if the value of c corresponding to a parity-check matrix defined according to each lifting size set index is determined based on the fourth largest number in each lifting size set (i=4), the value of *c* may be defined as, in order, 64, 96, 80, 56, 72, 88, 52, and 60, according to the respective lifting size set indexes. Likewise, if the value of *c* corresponding to a parity-check matrix defined according to each lifting size set index is determined based on the third largest number in each lifting size set (i=3), the value of *c* may be defined as, in order, 128, 192, 160, 112, 144, 176, 104, and 120, according to the respective lifting size set indexes. Likewise, if the value of c corresponding to a parity-check matrix defined according to each lifting size set index is determined based on the second largest number in each lifting size set (i=2), the value of *c* may be defined as, in order, 256, 384, 320, 224, 288, 353, 208, and 240, according to the respective lifting size set indexes.

In addition, according to the (*P^{a}, P^{b}, P^{c}*) = (*I, P, P^{c}*) combination shown in Equation 19, Table 11, and the embodiments corresponding thereto, the *ϕ* matrix becomes *ϕ = P + I + P^{c}.* According to the exponent selection example 3, when the value of the lifting size *Zₖ* is less than or equal to *c, c* ≡ 0 (mod *Zₖ*) is satisfied, and thus *P^{a} = I = P^{c}.* Accordingly, although the cycle characteristics are not improved, efficient LDPC encoding is possible by using the fact that *ϕ = P, ϕ*⁻¹ = *P*⁻¹ are satisfied. When the value of the lifting size *Zₖ* is greater than *c*, there exists i satisfying (*P^{c}*)^{2*i*} = *I*, and thus (i ≥ 1) *ϕ*²*ⁱ = I.* Accordingly, efficient LDPC encoding is possible, although the encoding complexity increases, by using the property that *ϕ*⁻¹ = *ϕ*^{2*i*-1} = *ϕ*^{2*i*-1} · *ϕ*^{2*i*-2} · ··· · *ϕ*² · *ϕ.* Here, the cycle length determined by *P^{a}* and *P^{c}* increases from the conventional 2*m*_{*b*1} to 2*m*_{*b*1} · *Z*/*D =* 2*m*_{*b*1} · 2*ⁱ* = 2^{*i*+1} · *m*_{*b*1}. Since the cycle lengths determined by *P^{a}* and *P^{b}* or by *P^{b}* and *P^{c}* satisfy the exponent condition 1a and the exponent condition 1b, they increase significantly in proportion to the value of Z.

The exponent selection example 1, the exponent selection example 2, and the exponent selection example 3 are methods of selecting exponents of some circulant permutation matrices constituting submatrix B 1020 in the parity-check matrix of FIG. 10 in consideration of both improvement of the cycle characteristics and the encoding complexity. The exponent selection examples propose a method in which, when the lifting size is small and the code length is short, the cycle characteristics are not improved but the encoding complexity is very low, and as the lifting size increases, the encoding complexity increases somewhat while the cycle characteristics are improved. In general, since an LDPC code may be more sensitively affected by an error floor phenomenon due to the cycle characteristics as the code length increases, the above methods, in which the cycle characteristics are also further improved as the code length increases with an increase in the lifting size, may be regarded as methods capable of improving the error floor phenomenon according to the code length of the LDPC code.

Of course, when the lifting size is small and the code length is short, the cycle characteristics do not significantly affect the error floor phenomenon, but a method of improving the cycle characteristics may also be applied even when the lifting size is small.

As an embodiment of the disclosure, a method of improving the cycle characteristics when the code length is short will be described.

### Exponent Selection Example 4 (i_{LS} = k)

- *aₖ* is an arbitrary integer.
- *bₖ* is given by *bₖ* = *aₖ* + *sₖ,* where *sₖ* is an integer satisfying gcd(*sₖ, Zₖ*) = 1, that is, *aₖ* and *bₖ* among the exponents corresponding to submatrix B are integers satisfying gcd(|*aₖ* - *bₖ*|, *Zₖ*) = 1. Here, gcd(*x*, *y*) denotes the greatest common divisor of *x* and *y*, and *Zₖ* denotes an arbitrary lifting size belonging to the lifting size set corresponding to *i_{LS} = k.* (*Zₖ* = *pₖ ·* 2*^{Lk}*, where *pₖ* is an odd number and *Lₖ* ≥ 0)
- *cₖ* is given by ${c}_{k} = {a}_{k} + \frac{{Z}_{k}}{{2}^{min \left(J, {L}_{k}\right)}} = {a}_{k} + {p}_{k} ⋅ {2}^{{L}_{k} - {2}^{min \left(J, {L}_{k}\right)}}$

Or, ${c}_{k} = \left\{\begin{matrix}{a}_{k} + {p}_{k} , & {L}_{k} < J \\ {a}_{k} + \frac{{Z}_{k}}{{2}^{J}} , & {L}_{k} \geq J\end{matrix}\right. \left(=\left\{\begin{matrix}{a}_{k} + {p}_{k} , & {L}_{k} < J \\ {a}_{k} + {p}_{k} ⋅ {2}^{{L}_{k} - J} , & {L}_{k} \geq J\end{matrix}\right.\right)$

If the size of *Zₖ* supported by the system is always greater than or equal to *pₖ ·* 2*^{J}*, *cₖ* may be simply expressed as ${c}_{k} = {a}_{k} + \frac{{Z}_{k}}{{2}^{J}} \left(={a}_{k}+{p}_{k}⋅{2}^{{L}_{k} - J}\right)$.

The exponent selection example 4 describes a method in which the respective exponents of the circulant permutation matrices (*P^{a}, P^{b}, P^{c}*) are not all fixed values, but at least one thereof is variably determined based on the lifting size Z. Accordingly, the method proposed in the disclosure may be applied not only to the lifting size sets of Tables 3 to 8 but also to cases in which various other lifting size sets are defined.

If *Lₖ < J* in *Zₖ = pₖ* · 2*^{Lk},* since $Z \frac{{Z}_{k}}{{2}^{J}}$ is not an integer, *cₖ* may be configured to be *cₖ* = *aₖ* + *pₖ* in the above example. That is, the value of *cₖ* may be variably determined according to the *Zₖ* values supported by the system and the given value of J. If the *Zₖ* values supported by the system are greater than or equal to *pₖ* · 2*^{J}*, since $\frac{{Z}_{k}}{{2}^{J}}$ is always an integer, *cₖ* may be determined by a single method, such as ${c}_{k} = {a}_{k} + \frac{{Z}_{k}}{{2}^{J}}$.

The method of the exponent selection example 4 satisfies the exponent condition 1a and the exponent condition 1b, and whether the exponent condition 2a and the exponent condition 2b are satisfied varies depending on the lifting size *Zₖ.* For example, when the range of supported *Zₖ* values is greater than or equal to *pₖ* · 2*^{J}*, the exponent condition 2a and the exponent condition 2b are satisfied, whereas when the range of supported *Zₖ* values is smaller than *pₖ* · 2*^{J}*, they are not satisfied.

According to the embodiment of the exponent selection example 4, when *Zₖ* ≥ *pₖ* · 2*^{J}* (or *Lₖ* ≥ *J*), the cycle length determined by *P^{a}* and *P^{c}* increases from the conventional 2*m*_{*b*1} to 2^{*J*+1} · *m*_{*b*1}, and when *Zₖ* < *pₖ* · 2*^{J}* (or *Lₖ < J*), the cycle length increases to 2^{*Lk*+1} · *m*_{*b*1}. (When *Lₖ* = 0, the cycle length does not increase.) Since the cycle lengths determined by *P^{a}* and *P^{b}* or by *P^{b}* and *P^{c}* satisfy the exponent condition 1a and the exponent condition 1b, they increase significantly in proportion to the value of Z.

In addition, when *Zₖ* ≥ *pₖ* · 2*^{J}* (or *Lₖ* ≥ *J*), since the *ϕ* matrix is given by $ϕ = {P}^{{a}_{k}} + {P}^{{a}_{k} + {s}_{k}} + {P}^{{a}_{k} + \frac{Z}{{2}^{J}}} = {P}^{{a}_{k}} \left(I+{P}^{{s}_{k}}+{P}^{\frac{Z}{{2}^{J}}}\right)$, LDPC encoding may be possible by using ${ϕ}^{{2}^{J}} = {P}^{{a}_{k} ⋅ {2}^{J}} ⋅ \left(I+{P}^{{s}_{k} ⋅ {2}^{J}}+{P}^{Z}\right) = {P}^{\left({a}_{k}+{s}_{k}\right) ⋅ {2}^{J}}$ *ϕ*⁻¹ = *P*^{-(*ak*+*sk*)·2*J*} · *ϕ*^{2*J*-1} = *P*^{-(*ak*+*sk*)*·*2*J*} · *ϕ*^{2*J*-1} · *ϕ*^{2*J*-2} · ··· · *ϕ*² · *ϕ*. When *Zₖ* < *pₖ* · 2*^{J}* (or *Lₖ* < *J*), since the *ϕ* matrix is given by *ϕ* = *P^{ak}* + *P^{ak+sk}* + *P^{ak+pk} = P^{ak}*(*I* + *P^{sk} + P^{pk}*), there exists an integer *j* (*j* < *J*) satisfying *ϕ*^{2*j*} = *p^{ak·2j}* (*I* + *P*^{*sk·*2*j*} + *P^{Z}*) = *P*^{(*ak*+*sk*)·2*j*} and thus LDPC encoding may be performed in a similar manner.

The method of the exponent selection example 4 has a disadvantage in that the maximum cycle length that can be improved according to the value of J is fixed regardless of the lifting size Z, but has an advantage in that the cycle characteristics are improved even when the lifting size Z is small. In other words, rather than all of the exponents of the circulant permutation matrices (*P^{a}, P^{b}*, *P^{c}*) being fixed integer values, at least one of the exponents of the circulant permutation matrices is variably determined based on the lifting size Z, whereby the cycle characteristics can be improved for various lifting sizes.

As a specific example of the exponent selection example 4, examples of exponent selection are described below when, for convenience, *a* = 1, that is, *P^{a} = P*¹.

### Exponent Selection Example 5 (i_{LS} = k)

- ${a}_{k} = 1 \left({P}^{a}=P\right)$
- ${b}_{k} = 0 \left({P}^{b}=I\right)$
- *cₖ* is given by ${c}_{k} = 1 + \frac{{Z}_{k}}{{2}^{min \left(J, {L}_{k}\right)}} = 1 + {p}_{k} ⋅ {2}^{{L}_{k} - {2}^{min \left(J, {L}_{k}\right)}}$

Or *cₖ* is given by ${c}_{k} = \left\{\begin{matrix}1 + {p}_{k} , & {L}_{k} < J \\ 1 + \frac{{Z}_{k}}{{2}^{J}} , & {L}_{k} \geq J\end{matrix}\right. \left(=\left\{\begin{matrix}1 + {p}_{k} , & {L}_{k} < J \\ 1 + {p}_{k} {2}^{{L}_{k} - J} , & {L}_{k} \geq J\end{matrix}\right.\right)$.

If the size of *Zₖ* supported by the system is always greater than or equal to *pₖ* · 2*^{J} , cₖ* may be simply expressed as ${c}_{k} = 1 + \frac{{Z}_{k}}{{2}^{J}} \left(=1+{p}_{k}⋅{2}^{{L}_{k} - J}\right)$.

When *bₖ* = 0 as in the exponent selection example 5, not only for *aₖ* = 1 but also for an arbitrary *aₖ* satisfying gcd(*aₖ, Zₖ*) = 1, the exponent condition 1a and the exponent condition 1b are satisfied. That is, for an integer *a* satisfying gcd(*a*, *Zₖ*) = 1, submatrix B configured as *aₖ* = *a* , *bₖ* = 0 , *cₖ =* 1 *+ pₖ* · 2^{max(*Lk*-*J*,0)} (or ${c}_{k} = \left\{\begin{matrix}a + {p}_{k} , & {L}_{k} < J \\ a + \frac{{Z}_{k}}{{2}^{J}} , & {L}_{k} \geq J\end{matrix}\right.$) satisfies the exponent condition 1a and the exponent condition 1b.

According to the method of the exponent selection example 5, *ϕ*^{2*J*} = *P*^{*a*·2*J*} + *I* + *P*^{*a*·2*J*+*Z*} = *I* and thus efficient encoding is possible by using *ϕ*⁻¹ = *ϕ*^{2*J*-1} · *ϕ*^{2*J*-2} · ··· · *ϕ*² · *ϕ*.

As a more specific example of the exponent selection example 4, examples of exponent selection are described below when, for convenience, *a* = 0, that is, *P^{a}* = *I.*

### Exponent Selection Example 6 (i_{LS} = k)

- ${a}_{k} = 0 \left({P}^{a}=I\right)$
- ${b}_{k} = 1 \left({P}^{b}=P\right)$
- *cₖ* is given by ${c}_{k} = \frac{{Z}_{k}}{{2}^{min \left(J, {L}_{k}\right)}} = {p}_{k} ⋅ {2}^{{L}_{k} - {2}^{min \left(J, {L}_{k}\right)}}$

Or *cₖ* is given by ${c}_{k} = \left\{\begin{matrix}{p}_{k} , & {L}_{k} < J \\ \frac{{Z}_{k}}{{2}^{J}} , & {L}_{k} \geq J\end{matrix}=\left\{\begin{matrix}{p}_{k} , & {L}_{k} < J \\ {p}_{k} ⋅ {2}^{{L}_{k} - J} , & {L}_{k} \geq J\end{matrix}\right.\right.$.

If the size of *Zₖ* supported by the system is always greater than or equal to *pₖ ·* 2*^{J} , cₖ* may be simply expressed as ${c}_{k} = \frac{{Z}_{k}}{{2}^{J}} \left(={p}_{k}⋅{2}^{{L}_{k} - J}\right)$.

When *aₖ* = 0 as in the exponent selection example 6, not only for *bₖ* = 1 but also for an arbitrary *bₖ* satisfying gcd(*bₖ*, *Zₖ*) = 1, the exponent condition 1a and the exponent condition 1b are satisfied. That is, for an integer *b* satisfying *gcd*(*b, Zₖ*) = 1, submatrix B configured as *aₖ* = 0, *bₖ = b, cₖ = pₖ* · 2^{max(*Lk*-*J*,0)} (or ${c}_{k} = \left\{\begin{matrix}{p}_{k} , & {L}_{k} < J \\ \frac{{Z}_{k}}{{2}^{J}} , & {L}_{k} \geq J\end{matrix}\right.$) satisfies the exponent condition 1a and the exponent condition 1b.

According to the method of the exponent selection example 6, efficient encoding is possible based on *ϕ*^{2*J*} = *I + P*^{*b*·2}*^{J} + P^{Z}* = *P*^{*b*·2*J*} ${ϕ}^{- 1} = {P}^{- b ⋅ {2}^{J}} ⋅ {ϕ}^{{2}^{J} - 1} = {P}^{- b ⋅ {2}^{J}} ⋅ {ϕ}^{{2}^{J - 1}} ⋅ {ϕ}^{{2}^{J - 2}} ⋅ ⋯ ⋅ {ϕ}^{2} ⋅ ϕ .$

The exponent selection methods of the exponent selection example 4, the exponent selection example 5, and the exponent selection example 6 enable the cycle length to be improved up to 2^{*J*+1} · *m*_{*b*1} in consideration of efficient encoding. If the value of *m*_{*b*1} is relatively large, the cycle characteristics can be sufficiently improved even when the value of J is not large. In general, the value of J may be determined in consideration of the value of parameter *m*_{*b*1} indicating the number of rows of the core matrix portion in a parity-check matrix given in the system and target BLER values. For example, when the target BLER is relatively high or the value of *m*_{*b*1} of the core matrix is large, J=1 or 2 may be sufficient, whereas when the target BLER is relatively low or the value of *m*_{*b*1} of the core matrix is small, it is desirable to configure J as 2, 3, 4, ....

In general, since the degree to which the performance of a code is affected by the cycle characteristics varies according to the code length, it is also possible to configure the value of J differently according to the lifting size. That is, at least one of the exponents may be determined according to the lifting size, and when the lifting size is relatively small, the value of *J*₁ may be configured to be small, whereas when the lifting size is relatively large, the value of *J*₂ may be configured to be large (*J*₁ < *J*₂). When the value of J is configured differently according to the lifting size, a reference lifting size and appropriate values of *J*₁ and *J*₂ should be determined.

Various possible exponent selection methods, including the exponent selection examples 1 to 6, may be variably applied according to the target BLER and/or the lifting size of the system. For example, when the target BLER of the system is high, since the cycle characteristics do not significantly affect the decoding performance of the code, encoding may be performed using the conventional method having the highest encoding efficiency even though the cycle characteristics are not improved. However, when the target BLER is low, the exponent selection methods proposed in the disclosure may be applied. Here, whether the target BLER is high or low may be relatively determined when there are a plurality of target BLERs applicable in the system. For example, when a first target BLER is 10⁻¹ and a second target BLER is 10⁻⁵, the first target BLER may be regarded as being higher than the second target BLER. When the first target BLER is 10⁻¹, the second target BLER is 10⁻⁵, and the third target BLER is 10⁻⁶ (or 10⁻⁷), the first target BLER may be determined to be higher than the second target BLER and the third target BLER, and the first target BLER and the second target BLER may also be determined to be higher than the third target BLER. As described above, when there are a plurality of target BLERs applicable in the system, whether the BLER is high or low may be determined based on a particular BLER value, and then the exponent selection methods proposed in the disclosure may be variably applied based thereon.

However, this is an embodiment of the disclosure, and the exponent selection methods proposed in the disclosure may be applied when the target BLER is high or regardless of the target BLER, and may be variably applied based on other factors. In addition, since the exponent selection methods described throughout the disclosure refer to methods of selecting exponents of circulant permutation matrices included in a submatrix of a parity-check matrix (specifically, submatrix B), the exponent selection methods of the disclosure may be described as methods of determining a parity-check matrix or methods of determining a submatrix included in a parity-check matrix. In addition, since the lifting size is closely related to the code length or the TBS, all processes determined based on the lifting size among the embodiments disclosed in the disclosure may be modified to be determined based on the code length or the TBS. In addition, in the exponent selection examples 1 to 6, the lifting size *Zₖ* is expressed, for convenience, as "*Zₖ* = *pₖ* · 2*^{Lk}, Lₖ* ≥ 0, and *pₖ* is an odd number." However, in general, the exponent selection methods may be applied in the same manner even when *pₖ* is not limited to an odd number, as in Tables 7-1 or 7-2, in which "*Zₖ* = *pₖ* · 2*^{Lk}*, *Lₖ* ≥ 0, and *pₖ* is the smallest lifting size in the k-th lifting size set."

As a specific example of applying the value of J in the exponent selection examples 4 to 6, when the system target BLER is determined to be high, the value of J may be configured as a small value *J*₁, and when the system target BLER is determined to be low, the value of J may be configured as a relatively large value *J*₂ (*J*₁ < *J*₂). In addition, such an exponent selection method or determination of the value of J may be performed in consideration of the lifting size together. In general, "A" reference BLERs values and/or reference lifting sizes may be established, and a total of (A+1) different values of J may be used for classification. For example, if there are a first reference value, a second reference value, ..., the values of J may be subdivided as *J*₁ < *J*₂, *J*₁ < *J*₂ < *J*₃, ..., and the like. In general, J may also be configured as 0. In this case, *P^{a} = P^{c},* and thus the cycle characteristics are not improved. This corresponds to the conventional method capable of the simplest encoding.

For reference, various methods for determining the target BLER at a UE or a base station may be applied according to the system. For example, the system target BLER may be directly indicated by higher-layer signaling, such as configured radio resource control (RRC) information, may be indirectly indicated according to a configured CQI table or MCS table, or may be indirectly indicated according to a configured service scenario.

As an embodiment of the disclosure, a method for improving the error floor performance of an LDPC code is proposed. In the disclosure, when submatrix B 1020 corresponding to first parity bits in a first part of a parity-check matrix including submatrix A 1010 and submatrix B 1020 in FIG. 10 has the form of Equation 20 below, algebraic characteristics that the first part of the parity-check matrix should satisfy are proposed. [Equation 20] $\left[\begin{matrix}I & I \\ {P}^{a} + {P}^{b} & I\end{matrix}\right]$

The size of submatrix B 1020 of Equation 20 is *M*₁ × *M*₁ (or 2*Z* × 2*Z*), and corresponds to a 2×2 base matrix or weight matrix. In addition, the first column block of submatrix B 1020 is composed of one *Z* × *Z* circulant permutation matrix and a *Z* × *Z* circulant matrix in which two circulant permutation matrices are superimposed, and the second column block includes two *Z* × *Z* identity matrices (or circulant permutation matrices). In the disclosure, for convenience, only the case in which the second column blocks are composed of identity matrices is illustrated, but the disclosure is not necessarily limited thereto. In addition, matrices that can be transformed into submatrix B 1020 having the above form through an appropriate invertible transform process may be regarded as algebraically identical matrices.

In the case of submatrix B 1020 of Equation 20, since the *ϕ* matrix having a size of *Z* × *Z* used in the encoding process becomes *I + P^{a} + P^{b} ,* efficient encoding is enabled according to exponent selection as in the foregoing embodiments. However, in the structure of Equation 20, in order to eliminate a cycle having a length of 4, conditions such as *a, b*(mod *Z*) > 0 and $≢ b \left(mod\frac{Z}{2}\right)$ (or $a - b ≢ \frac{Z}{2} \left(mod Z\right)$ ) should be satisfied. Since a cycle having a length of 4 degrades the decoding performance of the code, it is desirable to eliminate the cycle. Hereinafter, an exponent selection method that enables efficient encoding by improving the cycle characteristics for submatrix B of Equation 20 while increasing the complexity of operations related to the *ϕ*⁻¹ matrix required in the LDPC encoding process to a reasonable level will be described. In the embodiments of the disclosure, it is assumed that the above conditions for eliminating a cycle having a length of 4 are basically satisfied.

When the lifting size Z for a parity-check matrix of a QC LDPC code is given as *Z = p* · 2*^{L}* (where *p* is an odd number and *L* is an integer greater than or equal to 0), the exponents (or cyclic shift values) 0, *a*, and *b* of the circulant permutation matrices constituting the first column block of submatrix B 1020 are different integers, and satisfy at least some or all of the following conditions:
**Exponent Condition 3:** *a* has a greatest common divisor with the lifting size Z of 1 or a smallest number among divisors of Z greater than 1. (That is, *a* is relatively prime to Z or has a smallest divisor of Z greater than 1 as a greatest common divisor.)
**Exponent Condition 4:** For an integer *i* satisfying 2 ≤ *i* < *l*₁, $\left|a-b\right| ≢ \frac{Z}{i} \left(mod Z\right)$
**Exponent Condition 5:** For an integer *i* satisfying 0 ≤ *i* < *l*₂, *i* · *a* ≢ (*i* + 1)*b* (mod *Z*) and (*i +* 1)*a* ≢ *i* · *b* (mod *Z*)
**Exponent Condition 6:** $b = \frac{q ⋅ Z}{{2}^{J}}$ (0 *< J* ≤ *L,* where *q* is an odd number)

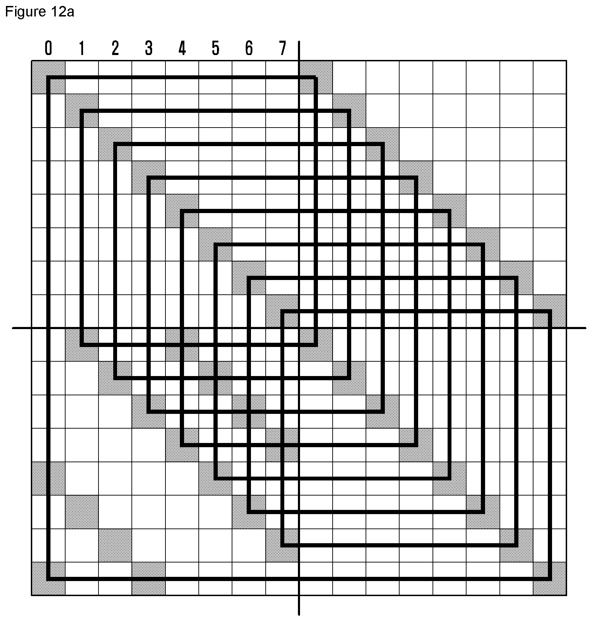

According to the exponent condition 3, when *a* is relatively prime to Z, the length of a cycle on a Tanner graph determined by $\left[\begin{matrix}I & I \\ {P}^{a} & I\end{matrix}\right]$ in the matrix of Equation 20 becomes 4Z. A simple example of the cycle characteristics according to the exponent condition 3 is shown in FIG. 12A.

FIG. 12A is an exemplary diagram for describing cycle characteristics in a submatrix of a parity-check matrix for an LDPC code satisfying the characteristics proposed in the disclosure.

FIG. 12A illustrates cycle characteristics induced by $\left[\begin{matrix}I & I \\ {P}^{1} & I\end{matrix}\right]$ in $\left[\begin{matrix}I & I \\ {P}^{1} + {P}^{4} & I\end{matrix}\right]$ when Z=8, and illustrates a cycle having a length of 32. In general, if the greatest common divisor of *a* and *Z* is *D,* the cycle length is 4*Z*/*D.* Accordingly, as the value of *Z* increases, the cycle length increases. Considering only the cycle characteristics, it is desirable that *a* be relatively prime to Z. However, depending on the circumstances, the exponent may be selected such that the greatest common divisor *D* is small (that is, the smallest divisor of Z greater than 1) according to another condition. For example, when the characteristic that *a* is relatively prime to Z cannot be satisfied, it is desirable to select an exponent such that the greatest common divisor *D* is small.

The exponent condition 4 is a condition for improving the cycle characteristics on a Tanner graph determined by $\left[\begin{matrix}∗ & ∗ \\ {P}^{a} + {P}^{b} & ∗\end{matrix}\right]$ in the matrix of Equation 20. When the exponent condition 4 is satisfied, all cycles having a length of 2(*l*₁ - 1) or less are eliminated in the above structure, and thus only cycles having a length of 2*l*₁ or greater exist.

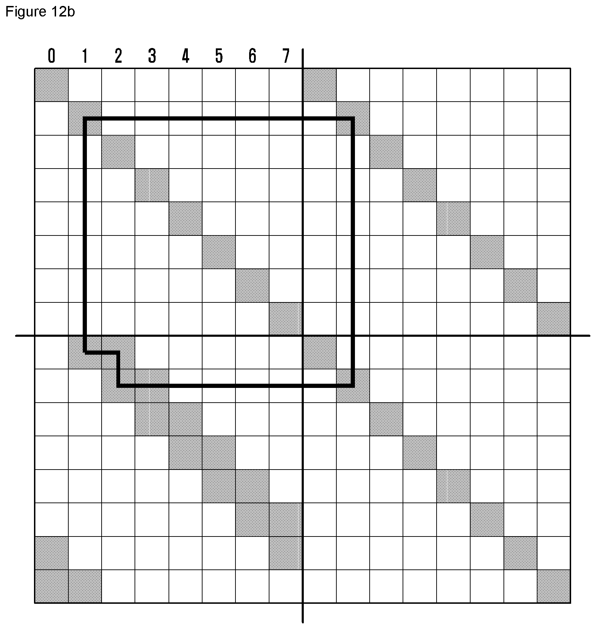

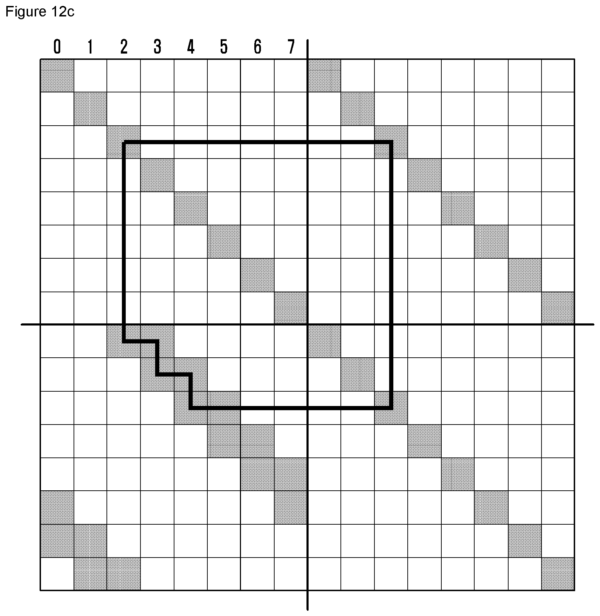

The exponent condition 5 is a condition for improving the cycle characteristics on a Tanner graph determined by $\left[\begin{matrix}I & I \\ {P}^{a} + {P}^{b} & I\end{matrix}\right]$ in the matrix of Equation 20. When the exponent condition 5 is satisfied, for an integer *i* satisfying 0 ≤ *i* < *l*₂, all cycles having a length of (4 + 2*i*) or less are eliminated in the above structure, and thus only cycles having a length of (4 + 2*l*₂) or greater exist. A simple example of the cycle characteristics according to the exponent condition 5 is shown in FIGS. 12B and 12C.

FIG. 12B is an exemplary diagram for describing cycle characteristics in a submatrix of a parity-check matrix for an LDPC code satisfying the characteristics proposed in the disclosure.

Specifically, FIG. 12B illustrates cycle characteristics induced by $\left[\begin{matrix}I & I \\ {P}^{1} + {P}^{2} & I\end{matrix}\right]$ when Z=8. For *i* = 0 , 0 · 1 ≢ 1 · 2 (mod 8) and 1 · 1 ≢ 0 · 2 (mod 8) are satisfied. However, since 2 · 1 ≡ 1 · 2 (mod 8) is satisfied for *i* = 1, a cycle having a length of 4 is eliminated, but a cycle having a length of 6 may exist.

FIG. 12C is an exemplary diagram for describing cycle characteristics in a submatrix of a parity-check matrix for an LDPC code satisfying the characteristics proposed in the disclosure.

Specifically, FIG. 12C illustrates cycle characteristics induced by $\left[\begin{matrix}I & I \\ {P}^{2} + {P}^{3} & I\end{matrix}\right]$ when Z=8. For *i* = 0, 0·2≢1·3 (mod 8) and 1·2≢0·3 (mod 8), and 1·2≢2·3 (mod 8) and 2·2≢1·3 (mod 8) are satisfied. However, since 3 · 2 ≡ 2 · 3 (mod 8) is satisfied for *i* = 2, cycles having lengths of 4 and 6 are eliminated, but a cycle having a length of 8 may exist.

The exponent condition 6 is a condition for simplifying the *ϕ*⁻¹ matrix as much as possible for efficient LDPC encoding. The *ϕ* matrix required in the process of performing LDPC encoding based on a parity-check matrix including submatrix B of Equation 20 may be defined as *ϕ = I + P^{a} + P^{b} .* At this time, when $b = \frac{Z}{{2}^{J}}$, since *ϕ* is given by $ϕ = I + {P}^{a} + {P}^{\frac{qZ}{{2}^{J}}}$, *ϕ*^{2*J*} = *I* + *P*^{2*Ja*} + *P^{q·Z}* = *P*^{2*Ja*}, and thus *ϕ*⁻¹ = *P*^{-2*Ja*} · *ϕ*^{2*J*-1}. Accordingly, relatively efficient encoding is possible using the *ϕ*⁻¹ matrix. In the exponent condition 6, if the lifting size Z is an odd number, the value of *b* cannot be an integer. Accordingly, this embodiment may be applied only when all lifting sizes are even numbers. That is, this embodiment is applicable only when L is an integer greater than or equal to 1 in *Z = p* · 2*^{L}.* For example, as shown in Table 9, the minimum lifting size in each of the lifting size sets should be an even number.

**[Table 9]**

| ***Set index* (*i_{LS}*)** | ***Set of lifting sizes (Z)*** |
|---|---|
| 0 | {(8,) 16, 32, 64, 128, 256(, 512)} |
| 1 | {(12,) 24, 48, 96, 192, 384(, 768)} |
| 2 | {20, 40, 80, 160, 320(, 640}} |
| 3 | {28, 56, 112, 224, 448(, 896)} |
| 4 | {(18,) 36, 72, 144, 288(, 576)} |
| 5 | {(22,) 44, 88, 176, 352(, 704}} |
| 6 | {(26,} 52, 104, 208, 416(, 832)} |
| 7 | {(30,) 60, 120, 240, 480(, 960)} |

As an embodiment of the disclosure, a more specific example of configuring submatrix B 1020 of FIG. 10 using the above exponent conditions will be described.

First, a communication system or broadcasting system is considered in which lifting size sets are defined as shown in Tables 3 to 9, as in 5G, and only lifting sizes included in the lifting size sets can be applied. In addition, a separate parity-check matrix or exponent matrix may be defined for each lifting size set. That is, in the case of Tables 3 to 9, a parity-check matrix, an exponent matrix, or the like may be defined for each of a total of eight set indexes.

Assume that *a* and b in submatrix B based on Equation 20 are determined as follows. In the disclosure, only the case where *a* = 1 is described for convenience. However, the value of *a* may be selected from values that are relatively prime to Z or have a small greatest common divisor with Z. In general, since the exponent values of submatrix B of the parity-check matrix corresponding to *i_{LS} = k* (*k* = 0, 1, 2, ...) may all be different, they are denoted by *bₖ.* In addition, *Zₖ* denotes an arbitrary lifting size included in the lifting size set corresponding to *i_{LS} = k,* and may be expressed in the form of *Zₖ = pₖ* · 2*^{Lk}* (where *pₖ* is an odd number or a minimum lifting size, and *Lₖ* ≥ 1).

### Exponent selection Example 7 (i_{LS} = k)

- $\left[\begin{matrix}I & I \\ {P}^{1} + {P}^{{b}_{k}} & I\end{matrix}\right]$
- ${b}_{k} = \frac{{Z}_{k}}{{2}^{min \left(J, {L}_{k}\right)}} = {p}_{k} ⋅ {2}^{{L}_{k} - min \left(J, {L}_{k}\right)}$
(provided that, $\frac{{Z}_{k}}{{2}^{min \left(J, {L}_{K}\right)}} > 1$, that is, *Zₖ* > 2^{min(*J,Lk*)} should be satisfied.)

In the exponent selection example 7, if the sizes of *Zₖ* supported by the system are all multiples of 2*^{J}*, *bₖ* may be simply expressed as ${b}_{k} = \frac{{Z}_{k}}{{2}^{J}} = {p}_{k} ⋅ {2}^{{L}_{k} - J}$ (provided that *Zₖ* > 2*^{J}*). In this case, this means that the minimum lifting size in each lifting size set as shown in Table 9 is a multiple of 2*^{J}*. For example, when J=2 is configured, this means that the minimum lifting sizes are each a multiple of 4, and when J=3 is configured, this means that the minimum lifting sizes are each a multiple of 8. In Tables 3 to 9, when *Zₖ* is in the form of *Zₖ* = 2*^{Lk},* as in the lifting size set of *i_{LS}* = 0, the minimum lifting size is 2^{*J*+1} in order to satisfy the condition *Zₖ >* 2*^{J}*. For example, when J=2 or 3 is configured, the minimum lifting sizes are 8 and 16, respectively. In the disclosure, for convenience of description, only the case in which the minimum lifting size in each lifting size set is a multiple of 2*^{J}* is described. In general, even when the minimum lifting size in each lifting size set is a multiple of 2 but is not a multiple of 2*^{J}*, an exponent selection method may be applied by the method described in the disclosure.

According to the exponent selection example 7, the exponent condition 3 and the exponent condition 6 are satisfied.

In addition, since $\left|a-b\right| = \frac{{Z}_{k}}{{2}^{J}} - 1$, according to the exponent condition 4, there is no cycle having a length of 4 induced by $\left[\begin{matrix}∗ & ∗ \\ {P}^{a} + {P}^{b} & ∗\end{matrix}\right]$. If *Zₖ* does not have 3 as a prime factor (that is, if *pₖ* is not an odd number that is a multiple of 3), $\frac{Z}{3}$ cannot be an integer, and thus there is also no cycle having a length of 6. If *Zₖ* has 3 as a prime factor, this means that *Zₖ* is in the form of *Zₖ* = 3 · 2*^{Lk}.* Accordingly, $\frac{Z}{3} - \left|a-b\right| = {2}^{{L}_{k}} - \left(3⋅{2}^{{L}_{k} - J}-1\right) = {2}^{{L}_{k} - J} \left({2}^{J}-3\right) + 1$. If J=2 and *Lₖ* ≥ 2 , then $\frac{Z}{3} - \left|a-b\right| = {2}^{{L}_{k} - 2} + 1$, and *2*^{*Lk*-2} + 1 ≢ 0 (mod 3 · *2^{Lk}*). Accordingly, there is no cycle having a length of 6 for any lifting size. In addition, when J=2, since $\left|a-b\right| ≢ \frac{{Z}_{k}}{4} \left(mod {Z}_{k}\right)$ is satisfied from $\left|a-b\right| = \frac{{Z}_{k}}{4} - 1$, there is also no cycle having a length of 8 induced by $\left[\begin{matrix}∗ & ∗ \\ {P}^{a} + {P}^{b} & ∗\end{matrix}\right]$. Accordingly, when J is selected as an integer greater than or equal to 2, the length of a cycle induced by $\left[\begin{matrix}∗ & ∗ \\ {P}^{a} + {P}^{b} & ∗\end{matrix}\right]$ is at least 10. As the value of J increases, the cycle characteristics can be further improved. However, since the encoding complexity increases and restrictions on the lifting size also increase, it is desirable to select an appropriate value of J according to the requirements of the system.

According to the exponent selection example 7, $i ⧥ \left(i+1\right) \frac{{Z}_{k}}{{2}^{J}} \left(mod {Z}_{k}\right)$ is satisfied from 0 to a relatively large integer *i*. However, when *i* = 1 and *Zₖ* = 2^{*J*+1} , since $\left(i+1\right) ≡ i ⋅ \frac{{Z}_{k}}{{2}^{J}} \left(mod {Z}_{k}\right)$ is satisfied, according to the exponent condition 5, only a cycle having a length of 4 among cycles induced by $\left[\begin{matrix}I & I \\ {P}^{1} + {P}^{{b}_{k}} & I\end{matrix}\right]$ is eliminated as in FIGS. 12B and 12C. Accordingly, in order to eliminate cycles having longer lengths, it is desirable that J is configured as an integer greater than or equal to 2, and that the exponent selection method is applied to a lifting size satisfying *Lₖ* ≥ *J* + 2 . For example, when J=2 and *Lₖ = J* + 2 , $i ⋅ {b}_{k} - \left(i+1\right) = i ⋅ \frac{{Z}_{k}}{{2}^{2}} - \left(i+1\right) = i ⋅ {p}_{k} ⋅ {2}^{2} - \left(i+1\right) = \left(4{p}_{k}-1\right) i - 1$ $- i = 1 ; \left(4{p}_{k}-1\right) i - 1 = 4 {p}_{k} - 2 ≢ 0 \left(mod {p}_{k}{2}^{4}\right)$ $- i = 2 ; \left(4{p}_{k}-1\right) i - 1 = {2}^{3} {p}_{k} - 3 ≢ 0 \left(mod {p}_{k}{2}^{4}\right)$ $- i = 3 ; \left(4{p}_{k}-1\right) i - 1 = 12 {p}_{k} - 4 ≢ 0 \left(mod {p}_{k}{2}^{4}\right)$ $- i = 4 ; \left(4{p}_{k}-1\right) i - 1 = {2}^{4} {p}_{k} - 5 ≢ 0 \left(mod {p}_{k}{2}^{4}\right)$ may be satisfied. Accordingly, according to the exponent condition 5, it can be seen that all cycles having a length of 12 or less among cycles that can be induced by $\left[\begin{matrix}I & I \\ {P}^{1} + {P}^{{b}_{k}} & I\end{matrix}\right]$ as in FIGS. 12B and 12C are eliminated.

Considering the exponent conditions 3 to 6 and the characteristics of the exponent selection example 7, a method of selecting an exponent based on the minimum lifting size of a given lifting size set as follows may also be applied.

### Exponent Selection Example 8 (i_{LS} = k)

- $\left[\begin{matrix}I & I \\ {P}^{1} + {P}^{{b}_{k}} & I\end{matrix}\right]$
- Lifting size set corresponding to *i_{LS} = k* is {*pₖ*2^{*L*1}, *pₖ*2^{*L*2}, ..., *pₖ*2^{*L*max}} where, *L*ₘᵢₙ = *L*₁ < *L*₂ < ... < *L*ₘₐₓ and, *pₖ* is not necessarily an odd number.
- *bₖ* = *pₖ* · *2*^{*L*1}*^{-J}, J* ≥ 2

The exponent selection example 8 refers to a method of selecting an exponent based on the minimum lifting size *Z*ₘᵢₙ included in each lifting size set when lifting size sets are given. According to the exponent selection example 8, *bₖ* may also be expressed as ${b}_{k} = \frac{{Z}_{min}}{{2}^{J}} \left(={p}_{k}⋅{2}^{{L}_{min} - J}\right)$. As a specific example, when J=2 is configured in a system applying the lifting size sets excluding the values in parentheses in Table 9, the values of *bₖ* are, in order, 4, 6, 5, 7, 9, 11, 13, and 15 according to the respective set indexes. When J=3 is configured and the minimum lifting sizes of the respective lifting size sets are 32, 48, 40, 56, 72, 88, 104, and 120, respectively, the values of *bₖ* are, in order, 4, 6, 5, 7, 9, 11, 13, and 15 according to the respective set indexes.

As an embodiment of the disclosure, the value of *bₖ* may be determined based on lifting sizes greater than a specific reference value. Specifically, it is assumed that J=2 and the reference value is configured as 64. When the exponent selection example 8 is applied only when the value of *bₖ* is greater than or equal to the reference value, the values of *bₖ* are, in order, 16, 24, 20, 28, 36, 44, 52, and 60 according to the respective set indexes. As another embodiment, it is assumed that J=3 and the reference value is configured as 64. When the exponent selection example 8 is applied only when the value of *bₖ* is greater than or equal to the reference value, the values of *bₖ* are, in order, 8, 12, 10, 14, 18, 22, 26, and 30 according to the respective set indexes.

As an embodiment of the disclosure, an exponent selection method for improving the decoding efficiency of an LDPC code is proposed. In the disclosure, an LDPC encoding and decoding system using a parity-check matrix having the form of Equation 21 is assumed. [Equation 21] $\begin{matrix}H = \left[\left({\sum }_{j = 1}^{{w}_{1}} {P}^{{e}_{1 j}}\right) ⋯ \left({\sum }_{j = 1}^{{w}_{k}} {P}^{{e}_{kj}}\right) \left({\sum }_{j = 1}^{{w}_{k + 1}} {P}^{{e}_{\left(k+1\right) j}}\right)\right] , \\ M \left(H\right) = \left[1 ⋯ 1 1\right] , \\ W \left(H\right) = \left[{w}_{1} ⋯ {w}_{k} {w}_{k + 1}\right] , {w}_{i} \geq 3 , \left(i=1,2,…,k\right) , {w}_{k + 1} \geq 2 \\ V \left(H\right) = \left[\left({e}_{11},{e}_{12},…,{e}_{1 {w}_{1}}\right) ⋯ \left({e}_{k 1},{e}_{k 2},…,{e}_{{kw}_{k}}\right) \left({e}_{\left(k+1\right) 1},…,{e}_{\left(k+1\right) {w}_{1}}\right)\right]\end{matrix}$

The parity-check matrix of Equation 21 has a size of *Z* × (*k* + 1)*Z,* and the base matrix or weight matrix has a size of 1 × (*k* + 1). The parity-check matrix of Equation 21 may correspond to a core matrix in which submatrix A 1010 in FIG. 10 has a size of *Z* × *kZ* and submatrix B 1020 has a size of *Z* × *Z.* (When M2=0 in FIG. 10, Equation 21 corresponds to the entire parity-check matrix.)

In addition, each *i*-th column block is composed of a *Z* × *Z* circulant matrix in which *wᵢ Z* × *Z* circulant permutation matrices are superimposed. In the disclosure, for convenience, the case in which one of the circulant permutation matrices constituting each column block is configured by an identity matrix (*e*₁₁ = *e*₂₁ = ··· = *e*_{(*k*+1)1} = 0) is described as an example, but the disclosure is not necessarily limited thereto. In addition, matrices that can be transformed into a parity-check matrix having the above form through an appropriate invertible transform process, such as cyclic shifting and permutation, may be regarded as algebraically identical matrices.

In the parity-check matrix of Equation 21, the first *k Z* × *Z* circulant matrices corresponding to information words may be composed of three or more circulant permutation matrices, and may typically be composed of four or more circulant permutation matrices in order to improve the minimum distance characteristics of the code. The last (*k* + 1)-th circulant matrix corresponding to parity bits is composed of two or more circulant permutation matrices. Since a circulant matrix composed of two or four circulant permutation matrices cannot have full rank, at least one of the columns of the (*k* + 1)-th circulant matrix corresponds to information word bits. Accordingly, in general, the (k+1)-th circulant matrix is composed of an odd number of three or more circulant permutation matrices in order to improve the minimum distance characteristics and to apply conventionally known efficient encoding methods. In addition, in general, in order to eliminate cycles having a length of 4, the differences between the respective exponents (or cyclic shift values) corresponding to the circulant permutation matrices constituting a single circulant matrix having a size of *Z*×*Z* are all different regard to modulo-Z.

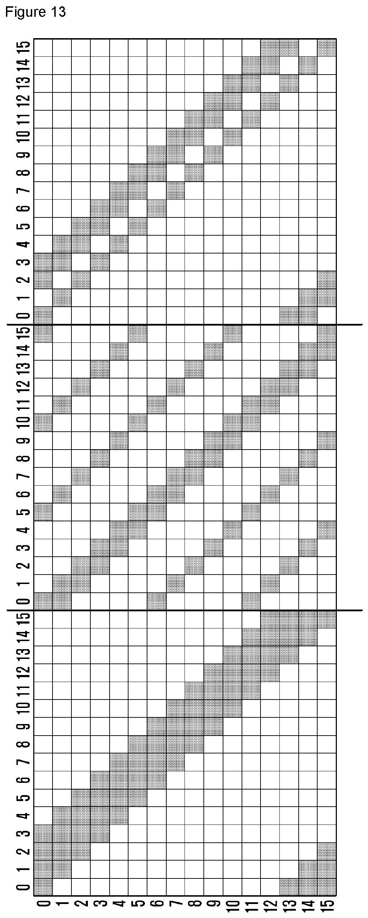

An example of the parity-check matrix of Equation 21 is shown in FIG. 13. The parity-check matrix of FIG. 13 has a size of *Z* × 3*Z* for *Z* = 16, and the circulant permutation matrices constituting the three column blocks are as shown in Equation 22 below. [Equation 22] $H = \left[\left({P}^{0}+{P}^{1}+{P}^{2}+{P}^{3}\right) \left({P}^{0}+{P}^{5}+{P}^{10}+{P}^{15}\right) \left({P}^{0}+{P}^{2}+{P}^{3}\right)\right]$

In general, when three or more circulant permutation matrices are superimposed in one Z × *Z* circulant matrix, as in the parity-check matrix of Equation 21 and FIG. 13, a cycle having a length of 6 may always be generated. In other words, when there is at least one case where *wᵢ* ≥ 3 in the parity-check matrix of Equation 21, the girth (which refers to the minimum cycle length on the Tanner graph corresponding to the code) on the Tanner graph is 6. Accordingly, since the parity-check matrix of Equation 21 cannot improve the cycle characteristics, it is desirable to use the parity-check matrix in an environment that is not significantly affected by the cycle characteristics. Communication systems that are not sensitive to the cycle characteristics typically include systems supporting a short code length, and/or a high code rate, and/or a high target BLER.

According to the parity-check matrix of Equation 21, when *w*₁ + *w*₂ + ··· + *w*_{(*k*+1)} exponents are identified, the parity-check matrix may be generated regardless of the size of Z, and thus has the advantage of high storage efficiency. For example, with respect to the parity-check matrix of FIG. 13, if a UE or a base station is able to identify the value of Z and the information [(0, 1, 2, 3), (0, 5, 10, 15), (0, 2, 3)], the parity-check matrix may be generated or determined.

In general, a QC-LDPC code has a structure suitable for performing parallel processing in units of one row block through a layered decoding scheme. However, in the parity-check matrix of Equation 21 or FIG. 13, since all rows constitute one row block, performing decoding through a Z-unit parallel processing processor means processing all rows simultaneously. Such a decoder structure does not cause a problem when the value of *Z* is small. However, as the code length increases, the row length, that is, the value of Z, also increases. Accordingly, when a large code length is supported, implementation of the decoder may become burdensome.

In the disclosure, an appropriate exponent selection method for the parity-check matrix having the structure of Equation 21 is proposed, and it is described that, when the proposed exponent selection method is applied, parallel processing with a processing size smaller than Z is possible.

First, rules for applying the following column permutation and row permutation to a *Z* × *Z* circulant matrix are defined.

### [Permutation Rule]

- $Z = d \times {Z}_{d}$ (where *d* is a divisor of *Z* greater than 1)
- The following permutation rule is applied to each *Z* × *Z* circulant matrix.
- For 0 ≤ *i* < *Z_{d}* and 0 ≤ $0 \leq j < \frac{{Z}_{d}}{d}$,

(a) Column permutation rule: Move the (*i* × *d + j*) -th column to the (*j* × *Z_{d}* + *i*)-th column.
(b) Row permutation rule: Move the (*i* × *d* + *j*)-th row to the (*j* × *Z_{d} + i*)-th row.

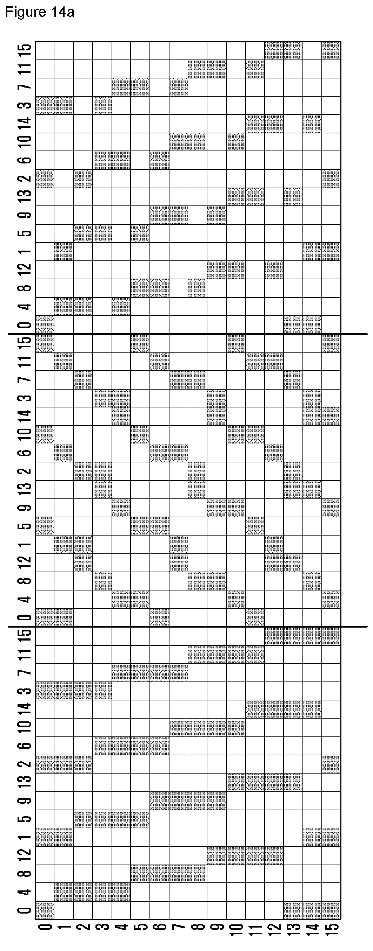

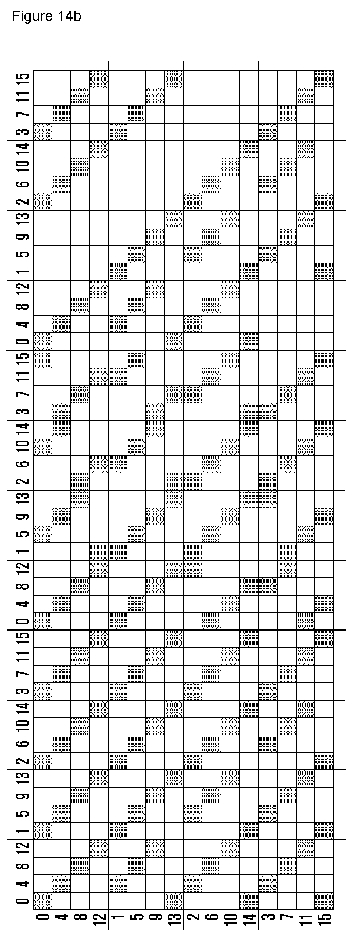

A specific example in which the above Permutation Rule is applied to the parity-check matrix of FIG. 13 is shown in FIGS. 14A and 14B. In FIGS. 14A and 14B, the permutation rule is applied based on *Z = d* × *Z_{d}* = 16, *d* = 4, and *Z_{d}* = 4.

FIGS. 14A and 14B are exemplary diagrams illustrating application of a permutation rule to a parity-check matrix according to an embodiment of the disclosure.

FIG. 14A is an exemplary diagram illustrating application of a column permutation to the parity-check matrix of FIG. 13, and FIG. 14B is an exemplary diagram illustrating further application of a row permutation to the parity-check matrix of FIG. 14A. Referring to FIG. 14B, when the rows and columns of the parity-check matrix of Equation 22, which is composed of circulant matrices having a size of *Z* × *Z,* are rearranged by applying the permutation rule, the parity-check matrix may be represented as a parity-check matrix composed of circulant permutation matrices having a size of *Z_{d}* × *Z_{d},* as shown in Equation 23 below. [Equation 23] ${H}_{perm} = \left[\begin{matrix}I & I & I & I & I & P & {P}^{2} & {P}^{3} & I & O & I & I \\ P & I & I & I & I & I & P & {P}^{2} & P & I & O & I \\ P & P & I & I & {P}^{3} & I & I & P & P & P & I & O \\ P & P & P & I & {P}^{2} & {P}^{3} & I & I & O & P & P & I\end{matrix}\right] .$

In general, a simple permutation of rows and columns does not affect the characteristics or performance of a code. In particular, row permutation does not affect the characteristics of the code at all, and column permutation affects only the order of bits and does not affect the characteristics or performance of the code. Accordingly, merely by rearranging the parity-check matrix in this manner, the parity-check matrix may be transformed into a structure suitable for applying a *Z_{d}*-unit layered decoding scheme.

When the permutation rule is applied to a circulant matrix having a size of *Z* × *Z*, the circulant matrix may be partitioned into *d*² circulant permutation matrices having a size of *Z_{d}* × *Z_{d}* with respect to a divisor *d* of *Z,* as shown in Equation 24 below. [Equation 24] $\begin{matrix}0 \leq {e}_{i} < {Z}_{d} , \\ {\left[{P}^{2 {e}_{1}}+{P}^{2 {e}_{2} + 1}\right]}_{Z \times Z} \to {\left[\begin{matrix}{P}^{{e}_{1}} & {P}^{{e}_{2}} \\ {P}^{{e}_{2} + 1} & {P}^{{e}_{1}}\end{matrix}\right]}_{2 {Z}_{d} \times 2 {Z}_{d}} \\ {\left[{P}^{3 {e}_{1}}+{P}^{3 {e}_{2} + 1}+{P}^{3 {e}_{3} + 2}\right]}_{Z \times Z} \to {\left[\begin{matrix}{P}^{{e}_{1}} & {P}^{{e}_{2}} & {P}^{{e}_{3}} \\ {P}^{{e}_{3} + 1} & {P}^{{e}_{1}} & {P}^{{e}_{2}} \\ {P}^{{e}_{2} + 1} & {P}^{{e}_{3} + 1} & {P}^{{e}_{1}}\end{matrix}\right]}_{3 {Z}_{d} \times 3 {Z}_{d}} \\ {\left[{P}^{4 {e}_{1}}+{P}^{4 {e}_{2} + 1}+{P}^{4 {e}_{3} + 2}+{P}^{4 {e}_{4} + 3}\right]}_{Z \times Z} \to {\left[\begin{matrix}{P}^{{e}_{1}} & {P}^{{e}_{2}} & {P}^{{e}_{3}} & {P}^{{e}_{4}} \\ {P}^{{e}_{4} + 1} & {P}^{{e}_{1}} & {P}^{{e}_{2}} & {P}^{{e}_{3}} \\ {P}^{{e}_{3} + 1} & {P}^{{e}_{4} + 1} & {P}^{{e}_{1}} & {P}^{{e}_{2}} \\ {P}^{{e}_{2} + 1} & {P}^{{e}_{3} + 1} & {P}^{{e}_{4} + 1} & {P}^{{e}_{1}}\end{matrix}\right]}_{4 {Z}_{d} \times 4 {Z}_{d}}\end{matrix}$

Equation 24 illustrates a case in which, when a circulant matrix having a size of *Z* × *Z* is partitioned, no circulant matrix in which circulant permutation matrices are superimposed exists. However, in general, a circulant matrix may exist even after rearrangement, as shown in Equation 25 below. [Equation 25] $\begin{matrix}0 \leq {e}_{i} < {Z}_{d} . \\ {\left[{P}^{3 {e}_{1}}+{P}^{3 {e}_{2} + 1}+{P}^{3 {e}_{3} + 1}\right]}_{Z \times Z} \to {\left[\begin{matrix}{P}^{{e}_{1}} & {P}^{{e}_{2}} + {P}^{{e}_{3}} & O \\ O & {P}^{{e}_{1}} & {P}^{{e}_{2}} + {P}^{{e}_{3}} \\ {P}^{{e}_{2} + 1} + {P}^{{e}_{3 + 1}} & O & {P}^{{e}_{1}}\end{matrix}\right]}_{3 {Z}_{d} \times 3 {Z}_{d}} \\ {\left[{P}^{4 {e}_{1}}+{P}^{4 {e}_{2} + 1}+{P}^{4 {e}_{3} + 2}+{P}^{4 {e}_{4} + 3}\right]}_{Z \times Z} \\ \to {\left[\begin{matrix}{P}^{2 {e}_{1}} + {P}^{2 {e}_{3} + 1} & {P}^{2 {e}_{2}} + {P}^{2 {e}_{4} + 1} \\ {P}^{2 {e}_{2} + 1} + {P}^{2 {e}_{4} + 2} & {P}^{2 {e}_{1}} + {P}^{2 {e}_{3} + 1}\end{matrix}\right]}_{2 {Z}_{d} \times 2 {Z}_{d}}\end{matrix}$

As described above, various forms of rearrangement are possible according to the exponents of the circulant permutation matrices constituting the parity-check matrix of Equation 21. However, since a circulant matrix in which three or more circulant permutation matrices are superimposed generally significantly increases decoder implementation complexity, it is advantageous, in terms of decoder implementation, that no circulant permutation matrices be superimposed or that at most two circulant permutation matrices be superimposed.

According to Equations 24 and 26, the remainders obtained by dividing the column indexes and the row indexes of the respective circulant permutation matrices by a divisor *d* of the size (*Z*) of the circulant permutation matrices may affect the positions after rearrangement. That is, entries corresponding to columns and rows having the same remainder with respect to the divisor *d* are included in the same circulant matrix having a size of *Z_{d}* × *Z_{d}* after rearrangement $\left({Z}_{d}=\frac{Z}{d}\right)$. As a specific example, the ${Z}_{d}^{2}$ entries corresponding to the rows having a remainder i and the columns having a remainder j with respect to the divisor *d* are included in the circulant matrix having a size of *Z_{d}* × *Z_{d}* corresponding to the j-th column block of the i-th row block (0 ≤ *i, j* < *d*). Therefore, in order that no circulant matrix having a size of *Z_{d}* × *Z_{d}* correspond to two or more circulant permutation matrices after the parity-check matrix is rearranged by applying the permutation rule proposed in the disclosure, the exponents (or cyclic shift values) corresponding to the circulant permutation matrices constituting one circulant matrix having a size of *Z*×*Z* in the originally given parity-check matrix may be configured such that the remainders with respect to the divisor *d* of Z are all different, or such that at most one instance in which the remainders are the same. In other words, there should exist a divisor *d* such that the exponents (or cyclic shift values) corresponding to the circulant permutation matrices have different values with regard to modulo*-d* or have at most one identical value (that is, there is at most one instance in which the values are the same), so that no circulant matrix having a size of *Z_{d}* × *Z_{d}* corresponds to two or more circulant permutation matrices after rearrangement. When the largest weight among the respective column blocks is denoted by *w*ₘₐₓ, if 2*d* < *w*ₘₐₓ is satisfied, this means that three circulant permutation matrices are superimposed in at least one circulant matrix having a size of *Z_{d}* × *Z_{d}.* Therefore, when 2*d* ≥ *w*ₘₐₓ is satisfied, rearrangement as described above is possible.

In order that a circulant matrix having a size of *Z_{d}* × *Z_{d}* correspond to at most one circulant permutation matrix after rearrangement of the parity-check matrix, the remainders of the respective exponents (or cyclic shift values) with respect to the divisor *d* of *Z* should all be different. Further, if *d* < *w*ₘₐₓ is satisfied, this means that two circulant permutation matrices are superimposed in at least one circulant matrix having a size of *Z_{d}* × *Z_{d}.* Therefore, rearrangement as described above is possible when *d* ≥ *w*ₘₐₓ is satisfied.

In order to determine the exponents of the circulant permutation matrices constituting the circulant matrix corresponding to the last column block, not only the remainders with respect to *d* but also efficient encoding should be taken into consideration. Since the submatrix corresponding to parity in the parity-check matrix often has lower encoding complexity as it becomes closer to a lower triangular matrix, it is preferable to select, from among the exponents satisfying the above condition, exponents corresponding to a matrix closer to a lower triangular matrix. In the disclosure, considering the case where *w*ₘₐₓ has a value of 4 or greater, the circulant matrix of the last column block may be *I* + *P*¹ *+ P*³ or *I* + *P*² + *P*³*.* Assuming that *d* is 4 or greater in consideration of the condition *d* ≥ *w*ₘₐₓ, the exponent pair (0, 1, 3) or (0, 2, 3) always has different remainders with respect to *d.* Of course, this is merely an example, and the exponent values of the circulant permutation matrices may be appropriately selected based on at least one of the lifting size Z, the size Z × (*k* + 1)*Z* of the parity-check matrix, the divisor value *d* used to rearrange the parity-check matrix into a form partitioned into matrices each having a size of *Z_{d}* × *Z_{d},* and/or the weight distribution of the circulant matrices constituting the respective column blocks. Meanwhile, since the exponent selection method described throughout the disclosure refers to a method of selecting exponents of circulant permutation matrices included in a submatrix of a parity-check matrix, the exponent selection method of the disclosure may also be described as a method of determining the parity-check matrix or a method of determining a submatrix included in the parity-check matrix.

As an embodiment of the disclosure, a rate-matching method is proposed for a case in which a parity-check matrix includes at least one *Z* × *Z* circulant matrix in which two circulant permutation matrices are superimposed, as in Equation 20 or Equation 21.

In general, when the weight of a parity-check matrix is high, additional parity bits may be generated through a row splitting-extending (RSE) method in which rows of the parity-check matrix are split and extended. The RSE method will now be briefly described using an encoding scheme based on the parity-check matrix of Equation 26. [Equation 26] $\left[\begin{matrix}1 & 1 & 1 & 0 & 1 & 0 & 0 \\ 1 & 1 & 0 & 1 & 0 & 1 & 0 \\ 1 & 0 & 1 & 1 & 0 & 0 & 1\end{matrix}\right] \times \left[\begin{matrix}{s}_{1} \\ {s}_{2} \\ {s}_{3} \\ {s}_{4} \\ {p}_{1} \\ {p}_{2} \\ {p}_{3}\end{matrix}\right] = \left[\begin{matrix}0 \\ 0 \\ 0\end{matrix}\right]$

First, Equation 26 may be expressed as three equations, as shown in Equation 27 below. [Equation 27] $\begin{matrix}{p}_{1} = {s}_{1} + {s}_{2} + {s}_{3} , \\ {p}_{2} = {s}_{1} + {s}_{2} + {s}_{4} , \\ {p}_{3} = {s}_{1} + {s}_{3} + {s}_{4} .\end{matrix}$

In Equation 27, there are values *x*₁ and *x*₂ serving as intermediate variables, and the equations may be separated and rearranged using the values *x*₁ and *x*₂, as shown in Equation 28 below. [Equation 28] $\begin{matrix}{p}_{1} = {s}_{1} + {x}_{1} , \\ {x}_{1} = {s}_{2} + {s}_{3} , \\ {p}_{2} = {s}_{2} + {x}_{2} , \\ {x}_{2} = {s}_{1} + {s}_{4} , \\ {p}_{3} = {s}_{1} + {s}_{3} + {s}_{4} .\end{matrix}$

Equation 28 may be represented as a relational expression based on an extended parity-check matrix, as shown in Equation 29. [Equation 28] $\left[\begin{matrix}1 & 0 & 0 & 0 & 1 & 0 & 0 & 1 & 0 \\ 0 & 1 & 1 & 0 & 0 & 0 & 0 & 1 & 0 \\ 0 & 1 & 0 & 0 & 0 & 1 & 0 & 0 & 1 \\ 1 & 0 & 0 & 1 & 0 & 0 & 0 & 0 & 1 \\ 1 & 0 & 1 & 1 & 0 & 0 & 1 & 0 & 0\end{matrix}\right] \times \left[\begin{matrix}{s}_{1} \\ {s}_{2} \\ {s}_{3} \\ {s}_{4} \\ {p}_{1} \\ {p}_{2} \\ {p}_{3} \\ {x}_{1} \\ {x}_{2}\end{matrix}\right] = \left[\begin{matrix}0 \\ 0 \\ 0 \\ 0 \\ 0\end{matrix}\right]$

Referring to Equation 28, the values of the original codeword (*s*₁, *s*₂, *s*₃, *s*₄, *p*₁, *p*₂, *p*₃) remain unchanged while intermediate variables *x*₁ and *x*₂ are introduced additionally. Such a process is equivalent to appropriately splitting some of the rows of the 3x7 parity-check matrix of Equation 26 and adding new columns to define a codeword (*s*₁, *s*₂, *s*₃, *s*₄, *p*₁, *p*₂, *p*₃, *x*₁, *x*₂) satisfying an extended parity-check matrix having a size of 5×9, as shown in Equation 28. In addition, since *x*₁ and *x*₂ have the same effect as additionally providing parity bits for the original codeword, this is identical to an incremental redundancy (IR) operation. In the disclosure, such an IR process is referred to, for convenience, as an RSE method.

In order to improve the performance of the IR method through the RSE method, it is important to determine the rows of the parity-check matrix to which the RSE method is to be applied. As a simple example, in the parity-check matrix H of Equation 29, an RSE method (RSE Method 1 or RSE Method 2) may be applied to obtain a matrix such as *H*_{*RSE*1} or *H*_{*RSE*2} . Meanwhile, hereinafter, a matrix obtained (or defined) by applying the RSE method is denoted by *H_{RSE}*, and other expressions having the same meaning (for example, a modified parity-check matrix, an extended parity-check matrix, or a split parity-check matrix) may be used. Accordingly, *H*_{*RSE*1} and *H*_{*RSE*2} may be referred to as a first modified parity-check matrix and a second modified parity-check matrix, respectively. [Equation 29] $\begin{matrix}H = \left[\left(I+{P}^{{e}_{11}}+{P}^{{e}_{12}}+{P}^{{e}_{13}}\right) \left(I+{P}^{{e}_{21}}+{P}^{{e}_{22}}+{P}^{{e}_{23}}\right) \left(I+{P}^{{e}_{31}}+{P}^{{e}_{32}}\right)\right] \\ {H}_{RSE 1} = \left[\begin{matrix}I + {P}^{{e}_{11}} & {P}^{{e}_{21}} + {P}^{{e}_{22}} & I & I \\ {P}^{{e}_{12}} + {P}^{{e}_{13}} & I + {P}^{{e}_{23}} & {P}^{{e}_{31}} + {P}^{{e}_{32}} & I\end{matrix}\right] \\ {H}_{RSE 2} = \left[\begin{matrix}I + {P}^{{e}_{11}} + {P}^{{e}_{13}} & {P}^{{e}_{21}} & I & I \\ {P}^{{e}_{12}} & I + {P}^{{e}_{22}} + {P}^{{e}_{23}} & {P}^{{e}_{31}} + {P}^{{e}_{32}} & I\end{matrix}\right]\end{matrix}$

The *H, H*_{*RSE*1}, and *H*_{*RSE*2} of Equation 29 are each composed of circulant permutation matrices or permutation matrices having a size of *Z* × *Z,* and their respective sizes are *Z* × 3*Z,* 2*Z* × 4*Z,* and 2*Z* × 4*Z.* The last column block $\left[\begin{matrix}I \\ I\end{matrix}\right]$ of *H*_{*RSE*1} and *H*_{*RSE*2} is a column block corresponding to the additionally introduced intermediate variables and corresponds to newly generated parity bits. The RSE method may be performed in units of rows, as in Equations 26 to 28, or may be performed in units of row blocks, as shown in Equation 29.

The *H*_{*RSE*1} and *H*_{*RSE*2} of Equation 29 have the same row weights and column weights. However, *H*_{*RSE*1} includes a circulant matrix in which at most two circulant permutation matrices are superimposed, whereas *H*_{*RSE*2} includes a circulant matrix in which at most three circulant permutation matrices are superimposed. As the number of superimposed circulant permutation matrices constituting a circulant matrix increases, the parity-check matrix has the advantage of having a simpler structure. However, as the number of superimposed circulant permutation matrices constituting a circulant matrix increases, the parity-check matrix has more limited cycle characteristics, such that the error-correction performance may be degraded when belief-propagation (BP) decoding, which is generally used for decoding an LDPC code, is performed. In particular, when the number of superimposed circulant permutation matrices constituting one circulant matrix is three or more, the maximum cycle length cannot exceed six. Therefore, except for a case in which the parity-check matrix is composed of one row block, as in Equation 21 or Equation 29, it is preferable that a parity-check matrix composed of two or more row blocks, such as *H*_{*RSE*1} and *H*_{*RSE*2}, include no circulant matrix in which three or more circulant permutation matrices are superimposed, if possible.

General rules of the RSE method considering the cycle characteristics and degree distribution of the parity-check matrix may be summarized as follows.

### [RSE Rules]

(1) A row block including a circulant matrix in which three or more circulant permutation matrices are superimposed is first split and extended. In order that the parity-check matrix after the splitting and extending include no circulant matrix in which three or more circulant permutation matrices are superimposed, one row block may be split into two or three or more row blocks and extended into two or three or more column blocks.
(2) If there is no circulant matrix in which three or more circulant permutation matrices are superimposed, a row block including a circulant matrix in which two or more circulant permutation matrices are superimposed is first split and extended. In order that the parity-check matrix after the splitting and extending include no circulant matrix in which two or more circulant permutation matrices are superimposed, one row block may be split into two or three or more row blocks and extended into two or three or more column blocks.
(3) If there is no circulant matrix in which two or more circulant permutation matrices are superimposed, a row block having the highest row degree in the parity-check matrix is first split and extended. In order to efficiently reduce the row degree in the parity-check matrix after the splitting and extending, one row block may be split into two or three or more row blocks and extended into two or three or more column blocks.

All of the above rules (1) to (3) for the RSE method may be used, or at least one thereof may be used, to obtain a parity-check matrix that has been split and extended.

When the originally given parity-check matrix is denoted by *H* and the parity-check matrix split and extended according to the RSE rules is denoted by *Hₑₓₜ*, bits corresponding to new columns or column blocks generated in *Hₑₓₜ* relative to *H* may be regarded as additional parity bits. The additional parity bits may also be used for a service in which parity bits are additionally transmitted to improve reliability, such as a retransmission scheme including HARQ. Further, when specific receivers perform decoding using the parity-check matrix *H* and other receivers are capable of performing decoding using the parity-check matrix *Hₑₓₜ,* the additional parity bits may be separately transmitted so that decoding suitable for the respective receiver characteristics is performed. Meanwhile, in the disclosure, the parity-check matrix *H* may be referred to as a first parity-check matrix, the parity-check matrix *Hₑₓₜ* may be referred to as a second parity-check matrix, or the parity-check matrix *H* may be referred to simply as a parity-check matrix and the parity-check matrix *Hₑₓₜ* may be referred to as an extended parity-check matrix or a modified parity-check matrix.

As described above, the receiver may determine the parity-check matrix *Hₑₓₜ* by physically splitting and extending the parity-check matrix *H*, and may perform LDPC decoding using *Hₑₓₜ.* In another method, the receiver may already store *Hₑₓₜ,* and, if no additional parity portion is transmitted, parity bits corresponding to all or at least some of the columns or column blocks of *Hₑₓₜ* extended relative to *H* may be regarded as punctured, and decoding may be performed. If all or at least some of the additional parity is transmitted, decoding may be performed using all or at least some of the columns or column blocks of *Hₑₓₜ* extended relative to *H.*

The disclosure relates to a method for transmitting additional parity or a method and an apparatus for performing decoding based on signals corresponding to transmitted additional parity bits. The disclosure may include a process and an apparatus in which a transmitter or a receiver physically generates a parity-check matrix *Hₑₓₜ* obtained by splitting and extending the parity-check matrix *H.* The disclosure also includes a method and an apparatus in which the transmitter or the receiver, while storing only *Hₑₓₜ* , performs encoding and decoding through appropriate rate matching with respect to parity bits corresponding to all or at least some of the columns or column blocks of *Hₑₓₜ* extended relative to *H.*

As described above, the splitting and extending of the parity-check matrix may not actually be performed in a transmitter or a receiver depending on the implementation scheme. However, the parity-check matrix *H* and the split and extended parity-check matrix *Hₑₓₜ* satisfy the respective relations *H* · *c^{T} =* 0*^{T}* and ${H}_{ext} ⋅ {{c}_{¯}}_{ext}^{T} = {{0}_{¯}}^{T}$, and the codewords *c^{T}* and ${{c}_{¯}}_{ext}^{T}$, generated for the same input bits or information word bits, have a relationship in which ${{c}_{¯}}_{ext}^{T}$ always includes *c^{T}.* In other words, ${{c}_{¯}}_{ext}^{T}$ may be determined by appending additional parity bits to *c^{T}* for the same input bits or information word bits. Further, from the generation method of *Hₑₓₜ, H* may be obtained by appropriately combining some of the rows or row blocks of *Hₑₓₜ* and removing some of the columns or column blocks. One characteristic of *Hₑₓₜ* in the disclosure is that, even if both *H and Hₑₓₜ* are not actually implemented in the UE or the base station, *Hₑₓₜ* may be determined from *H*, or *H* may be determined from *Hₑₓₜ.* In other words, even if information on only one of *H and Hₑₓₜ* parity-check matrices is stored in the transmitting device or the receiving device, the same effect as storing both *H and Hₑₓₜ* may be achieved. Furthermore, assuming that there is a first communication system based on *Hₑₓₜ,* there may also exist another second communication system based on the parity-check matrix *H* or another version of the first communication system.

Further, when a particular UE or base station stores the split and extended parity-check matrix *Hₑₓₜ* and communicates with a UE or base station storing the parity-check matrix *Hₑₓₜ,* a conventional rate-matching process may be performed. However, when the UE or base station storing the parity-check matrix *Hₑₓₜ* communicates with a UE or base station storing only the parity-check matrix *H*, LDPC encoding may be performed based on *Hₑₓₜ,* and, in the rate-matching process, puncturing may always be applied to parity bits corresponding to all or at least some of the columns or column blocks of *Hₑₓₜ* extended relative to *H.* When puncturing is always applied, in the rate-matching process, to parity bits corresponding to all or at least some of the columns or column blocks of *Hₑₓₜ* extended relative to *H,* the UE or the base station may perform decoding based on *H* by combining the rows or row blocks of *Hₑₓₜ* when performing LDPC decoding. Whether the UE or the base station stores *H* or *Hₑₓₜ* may generally be determined by distinguishing a system version according to a preamble, or may be determined through higher-layer signaling.

As one embodiment of the disclosure, when a sub-matrix corresponding to parity bits in a parity-check matrix has the form of Equation 20, the structure of a sub-matrix corresponding to parity bits in a split and extended parity-check matrix is proposed as shown in Equation 30. [Equation 30] $\begin{matrix}{H}_{P} = \left[\begin{matrix}I & I \\ {P}^{a} + {P}^{b} & I\end{matrix}\right] , \\ {H}_{P , RSE 1} = \left[\begin{matrix}I & I & O \\ {P}^{a} & I & I \\ {P}^{b} & O & I\end{matrix}\right] , {H}_{P , RSE 2} = \left[\begin{matrix}I & I & O & O \\ O & I & I & O \\ {P}^{a} & O & I & I \\ {P}^{b} & O & O & I\end{matrix}\right]\end{matrix}$

Referring to Equation 30, when splitting and extending are applied only to one row block in the parity-check matrix including *H_{P},* a row including a circulant matrix composed of two circulant permutation matrices is split according to the [RSE rules] such that the sub-matrix *H*_{*P,RSE*1} corresponding to the parity bits is composed only of circulant permutation matrices or zero matrices. When splitting and extending are applied to two row blocks in the parity-check matrix including *H_{P},* splitting and extending are applied to the first row block and the second row block, respectively, such that a sub-matrix corresponding to parity bits, such as *H*_{*P,RSE*2}, may be obtained.

As described above, the UE or the base station may physically split and extend the parity-check matrix. However, depending on the implementation, rather than actually splitting and extending the parity-check matrix, the UE or the base station may store a parity-check matrix including the extended parity structure shown in Equation 30 and perform LDPC encoding and decoding. As a specific example, when parity bits corresponding to all of the extended columns or column blocks in *H*_{*P,RSE*2} are received after being punctured, the receiver may perform decoding based on a parity-check matrix in which rows are appropriately combined, such as *H_{P}* or *H*_{*P,RSE*1}*.* Likewise, when parity bits corresponding to all of the extended columns or column blocks in *H*_{*P,RSE*1} are received after being punctured, the receiver may perform decoding based on a parity-check matrix in which rows are appropriately combined, such as *H_{P}.*

As one embodiment of the disclosure, an example of a process of applying LDPC encoding and rate matching based on a split and extended parity-check matrix will be described.

Assume that a parity-check matrix or a first part of a parity-check matrix, used for performing LDPC encoding and decoding in a transmitting device and a receiving device is *H =* [*H_{I} H*_{*P*1}]. Here, *H_{I}* is a sub-matrix corresponding to information word bits, and *H*_{*P*1} a sub-matrix corresponding to parity bits and may correspond to at least one of the matrices disclosed in Equation 31. [Equation 31] $\begin{matrix}{H}_{P 1} = \left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right] , \\ {H}_{P 2 , 1} = \left[\begin{matrix}{P}^{a} & I & O & O \\ O & I & I & O \\ {P}^{b} & O & I & I \\ {P}^{c} & O & O & I\end{matrix}\right] , {H}_{P 2 , 2} = \left[\begin{matrix}{P}^{a} & I & O & O \\ {P}^{b} & I & I & O \\ O & O & I & I \\ {P}^{c} & O & O & I\end{matrix}\right] , {H}_{P 3} = \left[\begin{matrix}{P}^{a} & I & O \\ {P}^{b} & I & I \\ {P}^{c} & O & I\end{matrix}\right] , \\ {H}_{P 4} = \left[\begin{matrix}{P}^{a} & I \\ {P}^{b} + {P}^{c} & I\end{matrix}\right] ,\end{matrix}$

The sub-matrices corresponding to the parity bits of Equation 31 may be determined in the order of *H*_{*P*1} → *H*_{*P*2,1} → *H*_{*P*3} → *H*_{*P*4} or *H*_{*P*1} → *H*_{*P*2,2} → *H*_{*P*3} → *H*_{*P*4} through a reverse process of the RSE process, that is, through appropriate combining of row blocks and deletion of column blocks. However, in order to sequentially represent a process of determining *H*_{*P*4} from *H*_{*P*1}, the sub-matrices have been described as being determined in the order of *H*_{*P*1} → (*H*_{*P*2,1} or *H*_{*P*2,2}) → *H*_{*P*3} → *H*_{*P*4}, but the determination process according to the above order is not necessarily required to be performed. That is, based on *H*_{*P*1}, at least one of *H*_{*P*2,1}, *H*_{*P*2,2}, *H*_{*P*3}, and *H*_{*P*4} may be determined, based on *H*_{*P*2,1} or *H*_{*P*2,2}, at least one of *H*_{*P*3} and *H*_{*P*4} may be determined, and *H*_{*P*4} may be determined based on *H*_{*P*3}. Further, the above determination process is not necessarily required to be performed, and at least one of *H*_{*P*1} to *H*_{*P*4} may be stored in the transmitting device and the receiving device, and the transmitting device and the receiving device may perform encoding or decoding using the sub-matrix. Further, just as the IR technique may be applied through the RSE process, puncturing may be applied, through the reverse process of the RSE process, to additionally generated parity bits used for IR. In other words, contrary to the IR process, a method of adjusting a code rate by generating a sufficient number of parity bits and then applying puncturing is proposed. Although this method has a disadvantage in that parity bits that may not be transmitted are generated, this method not only facilitates adjustment of the code rate through a rate-matching scheme in which some of the parity bits are punctured, but also has an advantage in that the IR technique may be efficiently supported by additionally transmitting at least some of the punctured parity bits during retransmission.

A conventional rate-matching scheme proceeds by first puncturing parity bits starting from the last parity bit according to a code rate. However, considering the reverse process of the RSE process, better coding performance may be provided by puncturing intermediate parity bits rather than applying puncturing starting from the last parity bit.

Considering a process of obtaining *H*₂ *=* [*H*_{*I*2} *H*_{*P*2,1}] from *H*₁ = [*H*_{*I*1} *H*_{*P*1}] through the reverse process of the RSE process, instead of puncturing the parity bits ${{w}_{¯}}^{\left(1\right)} = \left({w}_{0}^{\left(1\right)},{w}_{1}^{\left(1\right)},{w}_{2}^{\left(1\right)},…,{w}_{5 Z - 1}^{\left(1\right)}\right)$ for *H*₁ starting from the last bit, parity bits corresponding to the third column block of *H*_{*P*1} may be punctured as shown in Equation 32 (assuming that the first column block is the 0th column block). Meanwhile, the superscript (1) in *w*⁽¹⁾ is included to indicate that *w*⁽¹⁾ corresponds to *H*₁, but the superscript (1) may be omitted. Accordingly, the parity bits ${{w}_{¯}}^{\left(1\right)} = \left({w}_{0}^{\left(1\right)},{w}_{1}^{\left(1\right)},{w}_{2}^{\left(1\right)},…,{w}_{5 Z - 1}^{\left(1\right)}\right)$ may be denoted by *w* = (*w*₀, *w*₁, *w*₂, ..., *w*_{5*Z*-1}). Further, w = (*w*₀, *w*₁, *w*₂, ..., *w*_{5*Z*-1}) may denote parity bits for the 0th to the 4th column blocks, where *w*₀, *w*₁, ..., *w*_{*Z*-1} may denote parity bits for the 0th column block, *w_{Z}, w*_{*Z*+1}, ..., *w*_{2*Z*-1} may denote parity bits for the first column block, *w*_{2*Z*}, *w*_{2*Z*+1}, ... , *w*_{3*Z*-1} may denote parity bits for the second column block, *w*_{3*Z*}, *w*_{3*Z*+1}, ..., *w*_{4*Z*-1} may denote parity bits for the third column block, and *w*_{4*Z*}, *w*_{4*Z*+1}, ..., *w*_{5*Z*-1} may denote parity bits for the fourth column block. [Equation 32] ${{w}_{¯}}^{\left(2\right)} = \left({w}_{0}^{\left(1\right)},{w}_{1}^{\left(1\right)},…,{w}_{3 Z - 1}^{\left(1\right)},{w}_{4 Z}^{\left(1\right)}…,{w}_{5 Z - 1}^{\left(1\right)}\right)$
*w*⁽²⁾ of Equation 32 are parity bits for *H*₂. That is, *w*⁽²⁾ may indicate that the parity bits *w*₃*_{Z}, w*_{3*Z*+1}, ..., w_{4*Z*-1} corresponding to the third column block have been punctured.

Likewise, considering a process of obtaining *H*₃ *=* [*H*_{*I*3} *H*_{*P*3}] from *H*₂ = [*H*_{*I*2} *H*_{*P*2,1}] through the reverse process of the RSE process, when additional parity bits are punctured, instead of puncturing the parity bits *w*⁽²⁾ for *H*₂ starting from the last bit, parity bits corresponding to the first column block of *H*_{*P*2,1}, that is, the parity bits corresponding to the first column block of *H*_{*P*1}, may be punctured as shown in Equation 33. [Equation 33] ${{w}_{¯}}^{\left(3\right)} = \left({w}_{0}^{\left(1\right)},{w}_{1}^{\left(1\right)},…,{w}_{Z - 1}^{\left(1\right)},{w}_{2 Z}^{\left(1\right)}…,{w}_{3 Z - 1}^{\left(1\right)},{w}_{4 Z}^{\left(1\right)}…,{w}_{5 Z - 1}^{\left(1\right)}\right)$

The parity bits *w*⁽³⁾ of Equation 33 are parity bits for *H*₃.

Likewise, considering a process of obtaining *H*₄ = [*H*_{*I*4} *H*_{*P*4}] from *H*₃ *=* [*H_{I3} H*_{*P*3}] through the reverse process of the RSE process, when additional parity bits are punctured, parity bits corresponding to the second column block of *H*_{*P*3}, that is, the parity bits corresponding to the fourth column block of *H*_{*P*1}, may be punctured from the parity bits *w*⁽³⁾ for *H*₃, as shown in Equation 34. [Equation 34] ${{w}_{¯}}^{\left(4\right)} = \left({w}_{0}^{\left(1\right)},{w}_{1}^{\left(1\right)},…,{w}_{Z - 1}^{\left(1\right)},{w}_{2 Z}^{\left(1\right)}…,{w}_{3 Z - 1}^{\left(1\right)}\right)$
*w*⁽⁴⁾ of Equation 34 are parity bits for *H*₄.

As a result, in a conventional rate-matching scheme, parity puncturing is applied in the order of parity bits corresponding to the (4th, 3rd, 2nd, 1st, and 0th) column blocks in a sub-matrix corresponding to parity bits. However, as in this embodiment, better coding performance may be provided by applying parity puncturing in the order of parity bits corresponding to the (3rd, 1st, 4th, 2nd, and 0th) column blocks in consideration of the RSE process or the reverse process of the RSE process.

The same result may also be obtained when parity bits corresponding to the second column block of *H*_{*P*2,1}, that is, the parity bits corresponding to the second column block of *H*_{*P*1}, are punctured in a process of obtaining *H*₃ *=* [*H*_{*I*3} *H*_{*P*3}] from *H*₂ *=* [*H*_{*I*2} *H*_{*P*2,1}] through the reverse process of the RSE process. In this case, *w*⁽³⁾ and *w*⁽⁴⁾ expressed in Equations 33 and 34 may be represented as shown in Equation 35, which indicates that parity puncturing is applied in the order of parity bits corresponding to the (3rd, 2nd, 4th, 1st, and 0th) column blocks. [Equation 35] $\begin{matrix}{{w}_{¯}}^{\left(3\right)} = \left({w}_{0}^{\left(1\right)},{w}_{1}^{\left(1\right)},…,{w}_{2 Z - 1}^{\left(1\right)},{w}_{4 Z}^{\left(1\right)}…,{w}_{5 Z - 1}^{\left(1\right)}\right) \\ {{w}_{¯}}^{\left(4\right)} = \left({w}_{0}^{\left(1\right)},{w}_{1}^{\left(1\right)},…,{w}_{2 Z - 1}^{\left(1\right)}\right)\end{matrix}$

Considering another process of obtaining *H*₂ *=* [*H*_{*I*2} *H*_{*P*2,1}] from *H*₁ *=* [*H*_{*I*1} *H*_{*P*1}] through the reverse process of the RSE process, it is also possible to puncture the parity bits for *H*₁ starting from the last bit, as shown in Equation 36. [Equation 36] ${{w}_{¯}}^{\left(2\right)} = \left({w}_{0}^{\left(1\right)},{w}_{1}^{\left(1\right)},…,{w}_{3 Z - 1}^{\left(1\right)},{w}_{3 Z}^{\left(1\right)}…,{w}_{4 Z - 1}^{\left(1\right)}\right)$
*w*⁽²⁾ of Equation 36 are parity bits for *H*₂.

Likewise, considering a process of obtaining *H*₃ = [*H*_{*I*3} *H*_{*P*3}] from *H*₂ *=* [*H*_{*I*2} *H*_{*P*2,1}] through the reverse process of the RSE process, when parity bits are punctured, instead of puncturing the parity bits *w*⁽²⁾ for *H*₂ starting from the last bit, parity bits corresponding to the first column block or the second column block of *H*_{*P*2,1}, that is, parity bits corresponding to the first column block or the third column block of *H*_{*P*1}, may be punctured as shown in Equation 37. [Equation 37] $\begin{matrix}{{w}_{¯}}^{\left(3\right)} = \left({w}_{0}^{\left(1\right)},{w}_{1}^{\left(1\right)},…,{w}_{Z - 1}^{\left(1\right)},{w}_{2 Z}^{\left(1\right)}…,{w}_{3 Z - 1}^{\left(1\right)},{w}_{3 Z}^{\left(1\right)}…,{w}_{4 Z - 1}^{\left(1\right)}\right) \\ or \\ {{w}_{¯}}^{\left(3\right)} = \left({w}_{0}^{\left(1\right)},{w}_{1}^{\left(1\right)},…,{w}_{2 Z - 1}^{\left(1\right)},{w}_{3 Z}^{\left(1\right)}…,{w}_{3 Z - 1}^{\left(1\right)},{w}_{3 Z}^{\left(1\right)}…,{w}_{4 Z - 1}^{\left(1\right)}\right)\end{matrix}$

The parity bits *w*⁽³⁾ of Equation 33 are parity bits for *H*₃.

Likewise, considering a process of obtaining *H*₄ *=* [*H*_{*I*4} *H*_{*P*4}] from *H*₃ *=* [*H_{I3} H*_{*P*3}] through the reverse process of the RSE process, when parity bits are punctured, parity bits corresponding to the second column block of *H*_{*P*3}, that is, parity bits corresponding to the third column block of *H*_{*P*1}, may be punctured from the parity bits *w*⁽³⁾ for *H*₃, as shown in Equation 38. [Equation 38] ${{w}_{¯}}^{\left(4\right)} = \left({w}_{0}^{\left(1\right)},{w}_{1}^{\left(1\right)},…,{w}_{2 Z - 1}^{\left(1\right)}\right)$

The parity bits *w*⁽⁴⁾ of Equation 38 are parity bits for *H*₄.

As a result, in consideration of the RSE process or the reverse process of the RSE process, better coding performance may be provided by applying parity puncturing in the order of parity bits corresponding to the (4th, 1st, 3rd, 2nd, and 0th) column blocks or (4th, 2nd, 3rd, 1st, and 0th) column blocks.

According to the above results, when parity bits corresponding to two or more column blocks are punctured in a rate-matching process, better coding performance may be obtained by puncturing the parity bits according to an appropriate order of column blocks, such as the (3rd, 1st, 4th, 2nd, and 0th) column blocks, the (3rd, 2nd, 4th, 1st, and 0th) column blocks, the (4th, 1st, 3rd, 2nd, and 0th) column blocks, or the (4th, 2nd, 3rd, 1st, and 0th) column blocks, rather than sequentially puncturing the parity bits starting with the last parity bits corresponding to the fourth column block and then those corresponding to the third column block. In particular, among the five column blocks, when the parity bits punctured first correspond to one of the first, second, and third column blocks, or when the parity bits punctured first correspond to the fourth column block, superior performance is provided when the next corresponding column block is the first or second column block.

The RSE process or the reverse process of the RSE process may be applied not only to a sub-matrix corresponding to parity bits but also to combining or splitting of a sub-matrix corresponding to information word bits. Accordingly, even when the sub-matrices corresponding to parity bits determined through the RSE process or the reverse process of the RSE process have the same form, the sub-matrices corresponding to information word bits may be different from each other, and thus the rate-matched parity bits may be different from each other. As described above, when the RSE process or the reverse process of the RSE process is applied in consideration of combining of the sub-matrices corresponding to information word bits, a rate-matching order supporting better coding performance may be determined.

In the above examples, a case in which the parity-check matrix, or the first part of the parity-check matrix, used for performing LDPC encoding and decoding in the transmitting device and the receiving device is *H =* [*H*_{*I*1} *H*_{*P*1}] has been described. However, when the parity-check matrix, or the first part of the parity-check matrix, is *H =* [*H*_{*I*2} *H*_{*P*2,1}], the puncturing order of the parity bits may be determined in consideration of the reverse process of the RSE process in the order of *H*_{*P*2,1} → *H*_{*P*3} → *H*_{*P*4}. For example, based on *H*_{*P*2,1}, the puncturing order of the parity bits may be represented by the (1st, 3rd, 2nd, and 0th) column-block order or the (2nd, 3rd, 1st, and 0th) column-block order.

Meanwhile, when *H*₂ *=* [*H*_{*I*2} *H*_{*P*2,2}] or *H =* [*H*_{*I*2} *H*_{*P*2,2}] is defined in the above examples, the puncturing order of the parity bits for rate matching may be such that, in the sub-matrix corresponding to parity bits, puncturing is performed according to the (1st, 3rd, 4th, 2nd, and 0th) column-block order, the (1st, 4th, 3rd, 2nd, and 0th) column-block order, the (2nd, 3rd, 4th, 1st, and 0th) column-block order, or the (2nd, 4th, 3rd, 1st, and 0th) column-block order, or according to the (2nd, 3rd, 1st, and 0th) column-block order or the (3rd, 2nd, 1st, and 0th) column-block order. In particular, in this case, puncturing may be applied according to the (3rd, 2nd, 1st, and 0th) column-block order, as in the conventional rate-matching process.

Meanwhile, as described above, the determination process according to the above order is not necessarily required to be performed. That is, *H*_{*P*4} may be determined based on *H*_{*P*2,1} or *H*_{*P*2,2}*,* and *H*_{*P*4} may be determined based on *H*_{*P*3}*.* Furthermore, in the rate-matching process, when parity bits are punctured in consideration of only *H*_{*P*1} and *H*_{*P*2,1}, or only *H*_{*P*1} and *H*_{*P*2,2}*,* or in consideration of only *H*_{*P*1}, *H*_{*P*2,1}, and *H*_{*P*3}, or only *H*_{*P*1}, *H*_{*P*2,2}*,* and *H*_{*P*3}, the puncturing order of the parity bits may be differently configured.

For example, when puncturing is limited to no more than Z bits corresponding to one column block among the parity bits corresponding to *H*_{*P*1} during the rate-matching process, puncturing may be applied to parity bits corresponding to one of the first, second, third, and fourth column blocks, excluding the parity bits corresponding to the 0th column block. Here, puncturing the parity bits corresponding to the first or second column block of *H*_{*P*1} is the same as generating the parity bits corresponding to *H*_{*P*2,2} , and puncturing the parity bits corresponding to the third or fourth column block of *H*_{*P*1} is the same as generating the parity bits corresponding to *H*_{*P*2,1}*.* If puncturing parity bits corresponding to any column block does not significantly affect coding performance, puncturing may be applied starting from the parity bits corresponding to the last column block, as in a conventional rate-matching operation.

Further, when puncturing is applied, during the rate-matching process, to no more than 2Z bits corresponding to two column blocks among the parity bits corresponding to *H*_{*P*1}, parity bits corresponding to three column blocks need not be punctured. Accordingly, the puncturing order may be represented only in terms of the (3rd, 1st, *, *, *), (3rd, 2nd, *, *, *), (4th, 1st, *, *, *), (4th, 2nd, *, *, *), (1st, 3rd, *, *, *), (1st, 4th, *, *, *), (2nd, 3rd, *, *, *), or (2nd, 4th, *, *, *) column blocks corresponding to puncturing. (* indicates that no number is indicated, or, even if a number is indicated, it is irrelevant to puncturing.) Likewise, when puncturing is applied, during the rate-matching process, to no more than 3Z bits corresponding to two column blocks among the parity bits corresponding to *H*_{*P*1}, the parity bits corresponding to three column blocks need not be punctured. Accordingly, the puncturing order may be represented only in terms of the (3rd, 1st, 4th, *, *), (3rd, 2nd, 4th, *, *), (4th, 1st, 3rd, *, *), (4th, 2nd, 3rd, *, *), (1st, 3rd, 4th, *, *), (1st, 4th, 3rd, *, *), (2nd, 3rd, 4th, *, *), or (2nd, 4th, 3rd, *, *) column blocks corresponding to puncturing. A method of differently configuring the order of puncturing parity bits in the rate-matching process may be implemented in various ways. As in the above embodiment, when the transmitting device or the receiving device stores a pattern indicating the order of bits to be punctured, LDPC encoding and decoding may be performed because the positions of the parity bits punctured through rate matching can be identified.

In another method, the generated parity bits may be appropriately interleaved, and then a conventional rate-matching scheme may be applied. For example, the parity bits generated according to the (0th, 1st, 2nd, 3rd, and 4th) column-block order may be interleaved in units of Z-bit column blocks so that the parity bits correspond to the (0th, 2nd, 4th, 1st, and 3rd), (0th, 1st, 4th, 2nd, and 3rd), (0th, 2nd, 3rd, 1st, and 4th), (0th, 1st, 3rd, 2nd, and 4th), (0th, 2nd, 4th, 3rd, and 1st), (0th, 2nd, 3rd, 4th, and 1st), (0th, 1st, 4th, 3rd, and 2nd), or (0th, 1st, 3rd, 4th, and 2nd) column blocks. Thereafter, when puncturing is sequentially applied starting from the last interleaved parity bits, as in the conventional rate-matching scheme, the puncturing method of the above embodiment may be supported. When the maximum number of parity bits to be punctured is set to *kZ,* the order of the first (5-*k*) column blocks in the above interleaving pattern may be changed.

For example, when parity bits corresponding to the column blocks of a sub-matrix are denoted by *w* = (*w*₀, *w*₁, *w*₂, ..., *w*_{5*Z*-1}), and interleaving is performed according to the (0th, 2nd, 3rd, 1st, and 4th) column-block order, the interleaved parity bits may be *w*ᵢₙₜₗ = (*w*₀, *w*₁, ... , *w*_{*Z*-1}, *w*_{2*Z*}, *w*_{2*Z*+1}, ... , *w*_{3*Z-*1}*, w*_{3*Z*}, *w*_{3*Z*+1}, ... , *w*_{4*Z*-1}, *w*_{Z}, *w*_{*Z*+1}, ..., *w*_{2*Z*-1}, *w*_{4*Z*}, *w*_{4*Z*+1} ... , *w*_{5*Z*-1}).

Alternatively, when parity bits corresponding to the column blocks of a sub-matrix are denoted by *w* = (*w*₀, *w*₁, *w*₂, ..., *w*_{5*Z*-1}), and interleaving is performed according to the (0th, 1st, 3rd, 2nd, and 4th) column-block order, the interleaved parity bits may be *w*ᵢₙₜₗ = (*w*₀, *w*₁, ..., *w*_{*Z-*1}, *w*_{Z}, *w*_{*Z*+1}, ... , *w*_{2*Z*-1}, *w*₃*_{Z}, w*_{3*Z*+1}, ..., *w*_{4*Z*-1}, *w*_{2*Z*}, *w*_{2*Z*+1}, ..., *w*_{3*Z*-1}, *w*_{4*Z*}, *w*_{4*Z*+1} ..., *w*_{5*Z*-1}).

Likewise, parity bits generated according to the (0th, 1st, 2nd, and 3rd) column-block order may be interleaved in units of column blocks so that the parity bits correspond to the (0th, 2nd, 3rd, and 1st), (0th, 1st, 3rd, and 2nd), or (0th, 1st, 3rd, and 2nd) column blocks. Thereafter, when puncturing is sequentially applied starting from the last interleaved parity bits, as in the conventional rate-matching scheme, the puncturing method of the above embodiment may be supported. However, when the sub-matrix corresponding to parity bits is *H*_{*P*2,2}*,* interleaving may not be applied.

As described above, when a parity-check matrix of a quasi-cyclic LDPC code has a dual-diagonal structure of a sub-matrix corresponding to parity bits, as in Equation 15 or Equation 31, an effect similar to combining row blocks of the parity-check matrix may be obtained through appropriate parity puncturing.

The electronic device according to various embodiments set forth herein may be one of various types of electronic devices. The electronic device may include, for example, at least one of a portable communication device (e.g., a smart phone), a computer device, a portable multimedia device, a portable medical device, a camera, a wearable device, or a home appliance. The electronic device according to the embodiments set forth herein is not limited to the above-described devices. In addition, an operation of transmitting a frame not only means that a frame is transmitted through a radio channel, but also means that an interface which outputs a frame is included in order to transmit the frame to various electronic devices. For example, some processors may output a frame to an RF front end in order to transmit the frame via a bus interface. Likewise, an operation of receiving a frame from any other device may also mean that there is an interface for obtaining, by various devices, a frame received from any other device. For example, it means that some processors may receive or obtain a frame from an RF front end via a bus interface.

It should be appreciated that various embodiments of the disclosure and the terms used therein are not intended to limit the technological features set forth herein to particular embodiments and the disclosure includes various changes, equivalents, and/or alternatives for a corresponding embodiment.

With regard to the description of the drawings, the same or like reference signs may be used to designate the same or like elements. Expressions in the singular may include expressions in the plural unless the context clearly indicates otherwise. As used herein, each of such phrases as "A or B," "at least one of A and B," "at least one of A or B," "A, B, or C,""at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). When an element (e.g., a first element) is referred to as being (operatively or communicatively) "connected" or "coupled" to/with another element (e.g., a second element), the element may be connected or coupled to/with the other element directly or via another element (e.g., a third element).

Also, the term "determining" may imply various meanings, for example, may mean, according to situations, various operations such as "identifying", "calculating or computing", "processing", "deriving", "investigating", "estimating", "looking up" (e.g., from a database or other data structures), or "ascertaining".

In the drawings in which methods of the disclosure are described, the order of the description does not always correspond to the order in which steps are performed, and the order relationship between the steps may be changed or the steps may be performed in parallel.

Alternatively, the drawings describing the methods of the disclosure may omit some components and include only some components, without departing from the essential spirit and scope of the disclosure.

In addition, in methods of the disclosure, some or all of the contents of each embodiment may be implemented in combination without departing from the essential spirit and scope of the disclosure.

Although exemplary embodiments of the disclosure have been described, various changes and modifications may be presented to those skilled in the art. These changes and modifications are intended to fall within the appended claims. In addition, operations that are represented by different blocks for the convenience of description in the operation flowcharts of the disclosure may be implemented by a plurality of separate processors in an actual system, but it will be obvious that they may also be implemented by a single integrated processor.

## Claims

1. A method performed by a transmitting apparatus in a communication system, the method comprising:
determining a number of input bits;
determining a base matrix based on the number of the input bits;
determining a lifting size (Z) based on at least one of the number of the input bits or the base matrix;
determining a parity-check matrix based on at least one of the base matrix or the lifting size (Z);
performing encoding based on the parity-check matrix and the input bits; and
performing rate matching based on the encoded bits,
wherein the parity-check matrix comprises $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits,
wherein puncturing starts from parity bits corresponding to a 4th column block among 0th, 1st, 2nd, 3rd, and 4th column blocks of the sub-matrix, and
wherein, in the parity-check matrix, I is an identity matrix having a size of Z × Z, O is a zero matrix having a size of Z × Z, and P^{a}, P^{b}, and P^{c} are each an identity matrix or a circulant permutation matrix having a size of Z × Z.

2. The method of claim 1, further comprising performing interleaving on the parity bits corresponding to the submatrix among the encoded bits in units of Z bits.

3. The method of claim 2,
wherein, based on the interleaving, parity bits w = (w₀,w₁,w₂,...,w_{5Z - 1}) corresponding to column blocks of the sub-matrix are determined based on $\begin{matrix}{{w}_{¯}}_{intl} \\ = \left(\begin{matrix}{w}_{0} , {w}_{1} , … , {w}_{Z - 1} , {w}_{2 Z} , {w}_{2 Z + 1} , … , {w}_{3 Z - 1} , {w}_{3 Z} , {w}_{3 Z + 1} , … , {w}_{4 Z - 1} , {w}_{Z} , {w}_{Z + 1} , … , \\ {w}_{2 Z - 1} , {w}_{4 Z} , {w}_{4 Z + 1} … , {w}_{5 Z - 1}\end{matrix}\right)\end{matrix}$ or $\begin{matrix}{{w}_{¯}}_{intl} \\ = \left(\begin{matrix}{w}_{0} , {w}_{1} , … , {w}_{Z - 1} , {w}_{Z} , {w}_{Z + 1} , … , {w}_{2 Z - 1} , {w}_{3 Z} , {w}_{3 Z + 1} , … , {w}_{4 Z - 1} , {w}_{2 Z} , {w}_{2 Z + 1} , … , \\ {w}_{3 Z - 1} , {w}_{4 Z} , {w}_{4 Z + 1} … , {w}_{5 Z - 1}\end{matrix}\right) ,\end{matrix}$ and
wherein, based on the rate matching, the interleaved parity bits wᵢₙₜₗ are punctured in reverse order starting from the last bit of the interleaved parity bits.

4. The method of claim 1, wherein determining the parity-check matrix further comprises determining a modified parity-check matrix based on the parity-check matrix, and
wherein the modified parity-check matrix is defined by combining two or more rows while excluding two or more columns in the parity-check matrix.

5. A method performed by a receiving apparatus in a communication system, the method comprising:
receiving a signal corresponding to input bits;
demodulating the signal to determine values for decoding;
identifying a number of the input bits based on the signal;
determining a base matrix based on the number of the input bits;
determining a lifting size (Z) based on at least one of the number of the input bits or the base matrix;
determining a parity-check matrix based on at least one of the base matrix or the lifting size (Z); and
performing decoding based on the parity-check matrix and the values,
wherein the parity-check matrix comprises $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits,
wherein the signal comprises parity bits punctured starting from parity bits corresponding to a 4th column block among 0th, 1st, 2nd, 3rd, and 4th column blocks of the sub-matrix, and
wherein, in the parity-check matrix, I is an identity matrix having a size of Z × Z, O is a zero matrix having a size of Z × Z, and P^{a}, P^{b}, and P^{c} are each an identity matrix or a circulant permutation matrix having a size of Z × Z.

6. The method of claim 5, wherein the signal comprises parity bits corresponding to the submatrix, the parity bits being interleaved in units of Z bits.

7. The method of claim 6, wherein the interleaved parity bits are determined, based on parity bits w = (w₀,w₁,w₂,...,w_{5Z - 1}) corresponding to column blocks of the sub-matrix, as $\begin{matrix}{{w}_{¯}}_{intl} \\ = \left(\begin{matrix}{w}_{0} , {w}_{1} , … , {w}_{Z - 1} , {w}_{2 Z} , {w}_{2 Z + 1} , … , {w}_{3 Z - 1} , {w}_{3 Z} , {w}_{3 Z + 1} , … , {w}_{4 Z - 1} , {w}_{Z} , {w}_{Z + 1} , … , \\ {w}_{2 Z - 1} , {w}_{4 Z} , {w}_{4 Z + 1} … , {w}_{5 Z - 1}\end{matrix}\right)\end{matrix}$ or $\begin{matrix}{{w}_{¯}}_{intl} \\ = \left(\begin{matrix}{w}_{0} , {w}_{1} , … , {w}_{Z - 1} , {w}_{Z} , {w}_{Z + 1} , … , {w}_{2 Z - 1} , {w}_{3 Z} , {w}_{3 Z + 1} , … , {w}_{4 Z - 1} , {w}_{2 Z} , {w}_{2 Z + 1} , … , \\ {w}_{3 Z - 1} , {w}_{4 Z} , {w}_{4 Z + 1} … , {w}_{5 Z - 1}\end{matrix}\right)\end{matrix}$ and
wherein the interleaved parity bits wᵢₙₜₗ are punctured in reverse order starting from the last bit of the interleaved parity bits.

8. The method of claim 5, wherein determining the parity-check matrix further comprises determining a modified parity-check matrix, based on the parity-check matrix, and
wherein the modified parity-check matrix is defined by combining two or more rows while excluding two or more columns in the parity-check matrix.

9. A transmitting apparatus in a communication system, comprising:
a transceiver; and
a controller coupled with the transceiver and configured to:
determine a number of input bits;
determine a base matrix, based on the number of the input bits;
determine a lifting size (Z), based on at least one of the number of the input bits or the base matrix;
determine a parity-check matrix, based on at least one of the base matrix or the lifting size (Z);
perform encoding based on the parity-check matrix and the input bits; and
perform rate matching based on the encoded bits,
wherein the parity-check matrix comprises $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits,
wherein puncturing starts from parity bits corresponding to a 4th column block among 0th, 1st, 2nd, 3rd, and 4th column blocks of the sub-matrix, and
wherein, in the parity-check matrix, I is an identity matrix having a size of Z × Z, O is a zero matrix having a size of Z × Z, and P^{a}, P^{b}, and P^{c} are each an identity matrix or a circulant permutation matrix having a size of Z × Z.

10. The transmitter of claim 9, wherein the controller is configured to perform interleaving on the parity bits corresponding to the submatrix among the encoded bits in units of Z bits.

11. The transmitter of claim 10, wherein, based on the interleaving, parity bits w = (w₀,w₁,w₂,...,w_{5Z - 1}) corresponding to column blocks of the sub-matrix are determined as $\begin{matrix}{{w}_{¯}}_{intl} \\ = \left(\begin{matrix}{w}_{0} , {w}_{1} , … , {w}_{Z - 1} , {w}_{2 Z} , {w}_{2 Z + 1} , … , {w}_{3 Z - 1} , {w}_{3 Z} , {w}_{3 Z + 1} , … , {w}_{4 Z - 1} , {w}_{Z} , {w}_{Z + 1} , … , \\ {w}_{2 Z - 1} , {w}_{4 Z} , {w}_{4 Z + 1} … , {w}_{5 Z - 1}\end{matrix}\right)\end{matrix}$ or $\begin{matrix}{{w}_{¯}}_{intl} \\ = \left(\begin{matrix}{w}_{0} , {w}_{1} , … , {w}_{Z - 1} , {w}_{Z} , {w}_{Z + 1} , … , {w}_{2 Z - 1} , {w}_{3 Z} , {w}_{3 Z + 1} , … , {w}_{4 Z - 1} , {w}_{2 Z} , {w}_{2 Z + 1} , … , \\ {w}_{3 Z - 1} , {w}_{4 Z} , {w}_{4 Z + 1} … , {w}_{5 Z - 1}\end{matrix}\right) ,\end{matrix}$ and
wherein, based on the rate matching, the interleaved parity bits wᵢₙₜₗ are punctured in reverse order starting from the last bit of the interleaved parity bits.

12. The transmitter of claim 9, wherein the controller is configured to:
determine a modified parity-check matrix, based on the parity-check matrix, and
wherein the modified parity-check matrix is defined by combining two or more rows while excluding two or more columns in the parity-check matrix.

13. A receiving apparatus in a communication system, comprising:
a transceiver; and
a controller coupled with the transceiver and configured to:
receive a signal corresponding to input bits;
demodulate the signal to determine values for decoding;
identify a number of the input bits, based on the signal;
determine a base matrix based on the number of the input bits;
determine a lifting size (Z) based on at least one of the number of the input bits or the base matrix;
determine a parity-check matrix based on at least one of the base matrix or the lifting size (Z); and
perform decoding, based on the parity-check matrix and the values,
wherein the parity-check matrix comprises $\left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right]$ which is a sub-matrix corresponding to parity bits,
wherein the signal comprises parity bits punctured starting from parity bits corresponding to a 4th column block among 0th, 1st, 2nd, 3rd, and 4th column blocks of the sub-matrix, and
wherein, in the parity-check matrix, I is an identity matrix having a size of Z × Z, O is a zero matrix having a size of Z × Z, and P^{a}, P^{b}, and P^{c} are each an identity matrix or a circulant permutation matrix having a size of Z × Z.

14. The receiver of claim 13, wherein the interleaved parity bits are determined, based on parity bits w = (w₀,w₁,w₂,...,w_{5Z - 1}) corresponding to column blocks of the sub-matrix, as $\begin{matrix}{{w}_{¯}}_{intl} \\ = \left(\begin{matrix}{w}_{0} , {w}_{1} , … , {w}_{Z - 1} , {w}_{2 Z} , {w}_{2 Z + 1} , … , {w}_{3 Z - 1} , {w}_{3 Z} , {w}_{3 Z + 1} , … , {w}_{4 Z - 1} , {w}_{Z} , {w}_{Z + 1} , … , \\ {w}_{2 Z - 1} , {w}_{4 Z} , {w}_{4 Z + 1} … , {w}_{5 Z - 1}\end{matrix}\right)\end{matrix}$ or $\begin{matrix}{{w}_{¯}}_{intl} \\ = \left(\begin{matrix}{w}_{0} , {w}_{1} , … , {w}_{Z - 1} , {w}_{Z} , {w}_{Z + 1} , … , {w}_{2 Z - 1} , {w}_{3 Z} , {w}_{3 Z + 1} , … , {w}_{4 Z - 1} , {w}_{2 Z} , {w}_{2 Z + 1} , … , \\ {w}_{3 Z - 1} , {w}_{4 Z} , {w}_{4 Z + 1} … , {w}_{5 Z - 1}\end{matrix}\right) ,\end{matrix}$ and
wherein the interleaved parity bits wᵢₙₜₗ are punctured in reverse order starting from the last bit of the interleaved parity bits.

15. The receiver of claim 13, wherein the controller is configured to determine a modified parity-check matrix based on the parity-check matrix,
wherein the modified parity-check matrix is defined by combining two or more rows while excluding two or more columns in the parity-check matrix, and
wherein the signal comprises parity bits corresponding to the sub-matrix, the parity bits being interleaved in units of Z bits.
